(19)

**Europäisches Patentamt**
**European Patent Office**
**Office européen des brevets**

(11) **EP 4 576 585 A1**

(12) **EUROPEAN PATENT APPLICATION**
published in accordance with Art. 153(4) EPC

(43) Date of publication:
**25.06.2025 Bulletin 2025/26**

(21) Application number: **23864666.5**

(22) Date of filing: **11.09.2023**

(51) International Patent Classification (IPC):
**H03M 13/11** (2006.01)    **H04L 1/00** (2006.01)

(52) Cooperative Patent Classification (CPC):
**H03M 13/11; H04L 1/00**

(86) International application number:
**PCT/CN2023/118033**

(87) International publication number:
**WO 2024/055934 (21.03.2024 Gazette 2024/12)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **13.09.2022 CN 202211110834**

(71) Applicant: **Huawei Technologies Co., Ltd.**
**Shenzhen, Guangdong 518129 (CN)**

(72) Inventors:
• **LIN, Wei**
**Shenzhen, Guangdong 518129 (CN)**

• **MONTORSI, Guido**
**10131 Torino (IT)**
• **BENEDETTO, Sergio**
**10122 Torino (IT)**
• **QIAN, Bin**
**Shenzhen, Guangdong 518129 (CN)**
• **LIU, Chenchen**
**Shenzhen, Guangdong 518129 (CN)**
• **YANG, Xun**
**Shenzhen, Guangdong 518129 (CN)**
• **XIN, Yan**
**Shenzhen, Guangdong 518129 (CN)**

(74) Representative: **Pfenning, Meinig & Partner mbB**
**Patent- und Rechtsanwälte**
**Theresienhöhe 11a**
**80339 München (DE)**

(54) **ENCODING METHOD, DECODING METHOD, COMMUNICATION DEVICE, AND COMPUTER-READABLE STORAGE MEDIUM**

(57)    Embodiments of this application disclose an encoding method, a decoding method, a communication apparatus, and a computer-readable storage medium. This application is applied to a wireless local area network system that supports the IEEE 802.11be Wi-Fi protocol, Wi-Fi 8, and other 802.11 family protocols, and may also be applied to a UWB-based wireless personal local area network system. The method includes: performing LDPC encoding on a bit sequence based on a check matrix set, to obtain an encoded sequence, where the check matrix set includes a first check matrix and a second check matrix, the first check matrix is a check matrix obtained by expanding a base matrix using a first set of circular shift values, the second check matrix is a check matrix obtained by expanding the base matrix using a second set of circular shift values, and the second set of circular shift values are circular shift values obtained by using the first set of circular shift values; and transmitting a data packet obtained based on the encoded sequence. This can reduce circular shift values stored by a transmit end.

FIG. 9

EP 4 576 585 A1

**Description**

This application claims priority to Chinese Patent Application No. 202211110834.9, filed with the China National Intellectual Property Administration on September 13, 2022 and entitled "ENCODING METHOD, DECODING METHOD, COMMUNICATION APPARATUS, AND COMPUTER-READABLE STORAGE MEDIUM", which is incorporated herein by reference in its entirety.

**TECHNICAL FIELD**

This application relates to the field of communications technologies, and in particular, to an encoding method, a decoding method, a communication apparatus, and a computer-readable storage medium.

**BACKGROUND**

A wireless local area network (wireless local area network, WLAN) transmission standard like IEEE 802.11n/ac/ax/be mainly studies to improve user experience in a high-bandwidth scenario, including improving an average user throughput and energy usage efficiency of a battery-type power supply device. In a 60 GHz high-bandwidth scenario, high-speed and reliable transmission of services such as data and video on limited frequency and power resources needs to be supported. Therefore, a highly reliable and efficient channel encoding/decoding scheme is required. In the field of channel encoding, a Turbo code and a low-density parity-check (low-density parity-check, LDPC) code are currently two maturest and most widely used channel encoding methods, and both the two codes have performance close to the Shannon (Shannon) limit. Compared with the Turbo code, the LDPC code has the following advantages: good bit error performance achieved without a depth interleaver, better frame error rate performance, a greatly reduced error floor, supported parallel decoding, a short decoding latency, and the like.

To improve transmission reliability of a wireless transmission system, LDPC codes have been widely used in WLAN standards. Compared with the IEEE 802.15.4z standard, a new IEEE 802.15ab standard may introduce a new LDPC encoding technology, to greatly improve data transmission reliability of the wireless transmission system. Based on this, it may be considered that a new LDPC code encoding method and decoding method are designed for a next-generation WLAN standard or ultra-wideband (ultra wide band, UWB), to further improve system performance of a next-generation WLAN system or UWB system.

**SUMMARY**

Embodiments of this application disclose an encoding method, a decoding method, a communication apparatus, and a computer-readable storage medium, to improve system performance of a next-generation WLAN system or UWB system.

According to a first aspect, an embodiment of this application provides an encoding method. The method includes: performing low-density parity-check LDPC encoding on a bit sequence based on a check matrix set, to obtain an encoded sequence, where the check matrix set includes a first check matrix and a second check matrix, a first expansion factor corresponding to the first check matrix is different from a second expansion factor corresponding to the second check matrix, the first check matrix is a check matrix obtained by expanding a base matrix using a first set of circular shift values, the second check matrix is a check matrix obtained by expanding the base matrix using a second set of circular shift values, and the second set of circular shift values are circular shift values obtained by using the first set of circular shift values; and transmitting a data packet obtained based on the encoded sequence.

In this embodiment of this application, the first check matrix is a check matrix obtained by expanding the base matrix using the first set of circular shift values, and the second check matrix is a check matrix obtained by expanding the base matrix using the second set of circular shift values. Because the second set of circular shift values may be obtained by using the first set of circular shift values, a transmit end needs to store only the first set of circular shift values, with no need to store the second set of circular shift values. In this way, circular shift values stored by the transmit end can be reduced.

According to a second aspect, an embodiment of this application provides a decoding method. The method includes: obtaining an LDPC encoded sequence; and decoding the encoded sequence based on a check matrix set, where the check matrix set includes a first check matrix and a second check matrix, a first expansion factor corresponding to the first check matrix is different from a second expansion factor corresponding to the second check matrix, the first check matrix is a check matrix obtained by expanding a base matrix using a first set of circular shift values, the second check matrix is a check matrix obtained by expanding the base matrix using a second set of circular shift values, and the second set of circular shift values are circular shift values obtained by using the first set of circular shift values.

In this embodiment of this application, the first check matrix is a check matrix obtained by expanding the base matrix using the first set of circular shift values, and the second check matrix is a check matrix obtained by expanding the base matrix using the second set of circular shift values. Because the second set of circular shift values may be obtained by using the first set of circular shift values, a receive end needs to store only the first set of circular shift values, with no need to store the second set of circular shift values. In this way, circular shift values stored by the receive end can be reduced.

In a possible implementation of the first aspect or the second aspect, respective circular shift values of the first set of circular shift values and the second set of circular shift values meet a same modulo operation relationship.

In this implementation, the respective circular shift values of both the first set of circular shift values and the second set of circular shift values meet the same modulo operation relationship, and the second set of circular shift values can be quickly and accurately obtained by using the operation relationship and the first set of circular shift values.

In a possible implementation of the first aspect or the second aspect, the second set of circular shift values are circular shift values obtained by performing modulo processing on the first set of circular shift values and the second expansion factor.

In this implementation, the second set of circular shift values used for expanding the base matrix can be quickly obtained.

In a possible implementation of the first aspect or the second aspect, the check matrix set further includes a third check matrix, the first expansion factor is K times a third expansion factor corresponding to the third check matrix, K is an odd number greater than 1, the third check matrix is a check matrix obtained by expanding the base matrix using a third set of circular shift values, the third set of circular shift values are circular shift values obtained by using the first set of circular shift values, and the third set of circular shift values are different from the second set of circular shift values.

The expansion factor corresponding to the first check matrix is K times the expansion factor corresponding to the third check matrix, indicating that a code length of a code word obtained by encoding using the first check matrix is K times a code length of a code word obtained by encoding using the third check matrix. If the expansion factors corresponding to the two check matrices are both in an even multiple relationship, there may be a problem that a code word of an appropriate code length cannot be obtained by encoding using the check matrices, thereby causing a waste of resources. In this implementation, the transmit end may select a check matrix as required to perform LDPC encoding, so as to obtain code words of different code lengths through encoding, thereby reducing resource overheads.

In a possible implementation of the first aspect or the second aspect, the second expansion factor is F times the third expansion factor, and F is an even number greater than 1.

In this implementation, the transmit end may select a check matrix as required to perform LDPC encoding, so as to obtain code words of different code lengths through encoding, thereby reducing resource overheads.

In a possible implementation of the first aspect or the second aspect, the first expansion factor is 102, the second expansion factor is 68, and the third expansion factor is 34.

In this implementation, the first expansion factor is 102, and a long code can be obtained by performing LDPC encoding based on the first check matrix; the second expansion factor is 68, and a medium code can be obtained by performing LDPC encoding based on the second check matrix; and the third expansion factor is 34, and a short code can be obtained by performing LDPC encoding based on the third check matrix. Therefore, the short code, the medium code, and the long code can be correspondingly generated as required.

In a possible implementation of the first aspect or the second aspect, an encoded sequence corresponding to the first check matrix includes a code word with a code length of 2040 bits, an encoded sequence corresponding to the second check matrix includes a code word with a code length of 1360 bits, and an encoded sequence corresponding to the third check matrix includes a code word with a code length of 680 bits.

In this implementation, the transmit end can generate a code word with a code length of 2040 bits, 1360 bits, or 680 bits by using different check matrices as required.

In a possible implementation of the first aspect or the second aspect, the method is applied to a wireless local area network system and/or a UWB-based wireless personal local area network system.

In this implementation, the method provided in this embodiment of this application is applied to a wireless local area network system and/or a UWB-based wireless personal local area network system, to improve encoding/decoding performance of these systems.

In a possible implementation of the first aspect or the second aspect, the base matrix includes H rows or M columns of the following (12×22) matrix:

```
1 1 0 1 0 0 1 0 0 0 1 1 0 0 0 0 0 0 0
0 0 0
1 0 0 1 1 1 0 1 1 0 0 1 1 0 0 0 0 0 0
0 0 0
1 1 1 0 0 0 1 0 1 1 0 0 1 1 0 0 0 0 0
0 0 0
0 1 1 1 1 1 1 0 0 1 1 0 0 1 1 0 0 0 0
0 0 0
1 1 1 0 1 1 0 1 1 1 0 0 0 0 1 1 0 0 0
0 0 0
```

```
1 0 0 1 0 0 0 1 0 0 1 0 0 0 0 1 0 0 0
0 0 0
1 1 0 0 0 0 0 0 0 0 0 0 0 0 0 0 1 0 0
0 0 0
0 1 0 1 0 0 0 0 0 1 0 1 1 0 0 0 0 1 0
0 0 0
1 1 0 0 0 0 0 1 0 0 0 0 0 0 0 0 0 0 1
0 0 0
1 0 0 0 1 0 0 0 1 0 0 0 0 0 1 0 0 0 0
1 0 0
1 1 0 1 0 0 0 0 0 0 0 0 1 0 0 0 1 0 0 0
0 1 0
0 1 0 1 1 1 0 0 0 0 0 0 0 0 0 0 0 0 0
0 0 1
```

H is an integer from 1 to 12, and M is an integer from 1 to 22.

In this implementation, the design of the base matrix allows a check matrix that conforms to the base matrix to have information quickly transmitted and exchanged, and decoded and updated between code word bits corresponding to columns of the check matrix, thereby accelerating an overall decoding convergence speed of a system.

In a possible implementation of the first aspect or the second aspect, the first check matrix includes H rows or M columns of the following (12×22) matrix:

```
19 64 -1 42 -1 -1 61 -1 -1 -1 1 0 -1 -1 -1 -1 -1 -1 -
1 -1 -1 -1
58 -1 -1 27 37 32 -1 32 49 -1 -1 0 0 -1 -1 -1 -1 -1 -
1 -1 -1 -1
47 0 11 -1 -1 -1 3 -1 8 13 -1 -1 0 0 -1 -1 -1 -1 -
1 -1 -1 -1
-1 55 7 24 4 7 54 -1 -1 28 0 -1 -1 0 0 -1 -1 -1 -
1 -1 -1 -1
29 38 53 -1 40 16 -1 30 15 67 -1 -1 -1 -1 0 0 -1 -1 -
1 -1 -1 -1
7 -1 -1 0 -1 -1 -1 52 -1 -1 1 -1 -1 -1 -1 0 -1 -1 -
1 -1 -1 -1
39 12 -1 -1 -1 -1 -1 -1 -1 -1 -1 -1 -1 -1 -1 -1 0 -1 -
1 -1 -1 -1
-1 61 -1 11 -1 -1 -1 -1 -1 24 -1 51 44 -1 -1 -1 -1 0 -1
-1 -1 -1
0 16 -1 -1 -1 -1 -1 -1 5 -1 -1 -1 -1 -1 -1 -1 -1 -1
0 -1 -1 -1
24 -1 -1 -1 36 -1 -1 -1 61 -1 -1 -1 -1 -1 56 -1 -1 -1 -
1 0 -1 -1
58 24 -1 50 -1 -1 -1 -1 -1 -1 -1 26 -1 -1 -1 10 -1 -1 -
1 -1 0 -1
-1 4 -1 60 61 48 -1 -1 -1 -1 -1 -1 -1 -1 -1 -1 -1 -
1 -1 -1 0
```

- 1 in the first check matrix represents an all-zero matrix of size (K×K), 0 in the first check matrix represents an identity matrix of size (K×K), and an element greater than 0 in the first check matrix represents a CPM of size (K×K), where H is an integer from 1 to 12, and M is an integer from 1 to 22.

In this implementation, a code word obtained by performing LDPC encoding based on the check matrix in the check matrix set has better error control performance and packet error rate performance than a code word of a corresponding code length in WLAN LDPC.

In a possible implementation of the first aspect or the second aspect, the first check matrix includes H rows or M columns of the following (12×22) matrix:

```
53 64 -1 42 -1 -1 61 -1 -1 -1 1 0 -1 -1 -1 -1 -1 -1 -
1 -1 -1 -1
24 -1 -1 61 37 66 -1 32 49 -1 -1 0 0 -1 -1 -1 -1 -1 -
1 -1 -1 -1
47 0 45 -1 -1 -1 37 -1 8 13 -1 -1 0 0 -1 -1 -1 -1 -
1 -1 -1 -1
-1 55 41 24 38 7 54 -1 -1 62 0 -1 -1 0 0 -1 -1 -1 -
1 -1 -1 -1
63 38 19 -1 40 16 -1 64 15 67 -1 -1 -1 -1 0 0 -1 -1 -
1 -1 -1 -1
41 -1 -1 0 -1 -1 -1 52 -1 -1 1 -1 -1 -1 -1 0 -1 -1 -
1 -1 -1 -1
```

```
5 46 -1 -1 -1 -1 -1 -1 -1 -1 -1 -1 -1 -1 -1 -1 0 -1 -1
-1 -1 -1
-1 61 -1 45 -1 -1 -1 -1 -1 58 -1 51 44 -1 -1 -1 -1 0 -
1 -1 -1 -1
0 16 -1 -1 -1 -1 -1 -1 5 -1 -1 -1 -1 -1 -1 -1 -1 0
-1 -1 -1
58 -1 -1 -1 36 -1 -1 -1 27 -1 -1 -1 -1 -1 56 -1 -1 -1 -
1 0 -1 -1
24 58 -1 50 -1 -1 -1 -1 -1 -1 60 -1 -1 -1 10 -1 -1 -
1 -1 0 -1
-1 38 -1 60 61 14 -1 -1 -1 -1 -1 -1 -1 -1 -1 -1 -1 -
1 -1 -1 0
```

- 1 in the first check matrix represents an all-zero matrix of size (K×K), 0 in the first check matrix represents an identity matrix of size (K×K), and an element greater than 0 in the first check matrix represents a CPM of size (K×K), where H is an integer from 1 to 12, and M is an integer from 1 to 22.

In this implementation, a code word obtained by performing LDPC encoding based on the check matrix in the check matrix set has better error control performance and packet error rate performance than a code word of a corresponding code length in WLAN LDPC.

In a possible implementation of the first aspect or the second aspect, the first check matrix includes H rows or M columns of the following (12×22) matrix:

```
19 64 -1 42 -1 -1 27 -1 -1 -1 1 0 -1 -1 -1 -1 -1 -1 -
1 -1 -1 -1
58 -1 -1 27 3 66 -1 66 15 -1 -1 0 0 -1 -1 -1 -1 -1 -
1 -1 -1 -1
13 0 45 -1 -1 -1 37 -1 42 13 -1 -1 0 0 -1 -1 -1 -1 -
1 -1 -1 -1
-1 55 7 24 38 41 20 -1 -1 28 0 -1 -1 0 0 -1 -1 -1 -
1 -1 -1 -1
29 38 53 -1 40 50 -1 64 49 33 -1 -1 -1 0 0 -1 -1 -
1 -1 -1 -1
41 -1 -1 0 -1 -1 -1 52 -1 -1 1 -1 -1 -1 -1 0 -1 -1 -
1 -1 -1 -1
39 46 -1 -1 -1 -1 -1 -1 -1 -1 -1 -1 -1 -1 -1 -1 0 -1 -
1 -1 -1 -1
-1 61 -1 45 -1 -1 -1 -1 -1 24 -1 17 44 -1 -1 -1 -1 0 -
1 -1 -1 -1
0 16 -1 -1 -1 -1 -1 -1 39 -1 -1 -1 -1 -1 -1 -1 -1 0
-1 -1 -1
24 -1 -1 -1 2 -1 -1 -1 27 -1 -1 -1 -1 -1 56 -1 -1 -1 -
1 0 -1 -1
24 58 -1 16 -1 -1 -1 -1 -1 -1 26 -1 -1 -1 44 -1 -1 -
1 -1 0 -1
-1 38 -1 60 61 48 -1 -1 -1 -1 -1 -1 -1 -1 -1 -1 -1 -
1 -1 -1 0
```

- 1 in the first check matrix represents an all-zero matrix of size (K×K), 0 in the first check matrix represents an identity matrix of size (K×K), and an element greater than 0 in the first check matrix represents a CPM of size (K×K), where H is an integer from 1 to 12, and M is an integer from 1 to 22.

In this implementation, a code word obtained by performing LDPC encoding based on the check matrix in the check matrix set has better error control performance and packet error rate performance than a code word of a corresponding code length in WLAN LDPC.

In a possible implementation of the first aspect or the second aspect, the first check matrix includes H rows or M columns of the following (12×22) matrix:

```
53 30 -1 42 -1 -1 27 -1 -1 -1 1 0 -1 -1 -1 -1 -1 -1 -
1 -1 -1 -1
58 -1 -1 27 3 32 -1 66 49 -1 -1 0 0 -1 -1 -1 -1 -1 -
1 -1 -1 -1
47 0 45 -1 -1 -1 3 -1 8 47 -1 -1 0 0 -1 -1 -1 -1 -
1 -1 -1 -1
-1 21 41 24 38 7 54 -1 -1 28 0 -1 -1 0 0 -1 -1 -1 -
1 -1 -1 -1
63 38 19 -1 6 50 -1 64 15 67 -1 -1 -1 0 0 -1 -1 -
1 -1 -1 -1
```

```
7 -1 -1 0 -1 -1 -1 52 -1 -1 1 -1 -1 -1 -1 0 -1 -1 -1
-1 -1 -1
5 12 -1 -1 -1 -1 -1 -1 -1 -1 -1 -1 -1 -1 -1 -1 0 -1 -1
-1 -1 -1
-1 61 -1 45 -1 -1 -1 -1 -1 24 -1 17 44 -1 -1 -1 -1 0 -
1 -1 -1 -1
0 16 -1 -1 -1 -1 -1 -1 5 -1 -1 -1 -1 -1 -1 -1 -1 -1 0
-1 -1 -1
24 -1 -1 -1 2 -1 -1 -1 61 -1 -1 -1 -1 -1 56 -1 -1 -1 -
1 0 -1 -1
24 24 -1 50 -1 -1 -1 -1 -1 -1 -1 60 -1 -1 -1 10 -1 -1 -
1 -1 0 -1
-1 38 -1 60 61 14 -1 -1 -1 -1 -1 -1 -1 -1 -1 -1 -1 -1 -
1 -1 -1 0
```

- 1 in the first check matrix represents an all-zero matrix of size (K×K), 0 in the first check matrix represents an identity matrix of size (K×K), and an element greater than 0 in the first check matrix represents a CPM of size (K×K), where H is an integer from 1 to 12, and M is an integer from 1 to 22.

In this implementation, a code word obtained by performing LDPC encoding based on the check matrix in the check matrix set has better error control performance and packet error rate performance than a code word of a corresponding code length in WLAN LDPC.

In a possible implementation of the first aspect or the second aspect, the first check matrix includes H rows or M columns of the following (12×22) matrix:

```
19 64 -1 8 -1 -1 61 -1 -1 -1 1 0 -1 -1 -1 -1 -1 -1 -
1 -1 -1 -1
58 -1 -1 61 37 32 -1 32 15 -1 -1 0 0 -1 -1 -1 -1 -1 -
1 -1 -1 -1
47 0 45 -1 -1 -1 3 -1 8 47 -1 -1 0 0 -1 -1 -1 -1 -
1 -1 -1 -1
-1 21 7 58 38 7 54 -1 -1 28 0 -1 -1 0 0 -1 -1 -1 -
1 -1 -1 -1
29 4 53 -1 40 50 -1 30 49 33 -1 -1 -1 0 0 -1 -1 -
1 -1 -1 -1
7 -1 -1 0 -1 -1 -1 18 -1 -1 1 -1 -1 -1 -1 0 -1 -1 -1
-1 -1 -1
39 46 -1 -1 -1 -1 -1 -1 -1 -1 -1 -1 -1 -1 -1 0 -1 -
1 -1 -1 -1
-1 27 -1 11 -1 -1 -1 -1 -1 58 -1 51 44 -1 -1 -1 -1 0 -1
-1 -1 -1
0 50 -1 -1 -1 -1 -1 -1 5 -1 -1 -1 -1 -1 -1 -1 -1 0
-1 -1 -1
24 -1 -1 -1 36 -1 -1 -1 61 -1 -1 -1 -1 -1 22 -1 -1 -1 -
1 0 -1 -1
24 24 -1 16 -1 -1 -1 -1 -1 -1 -1 60 -1 -1 -1 44 -1 -1 -
1 -1 0 -1
-1 38 -1 26 27 48 -1 -1 -1 -1 -1 -1 -1 -1 -1 -1 -1 -1 -
1 -1 -1 0
```

- 1 in the first check matrix represents an all-zero matrix of size (K×K), 0 in the first check matrix represents an identity matrix of size (K×K), and an element greater than 0 in the first check matrix represents a CPM of size (K×K), where H is an integer from 1 to 12, and M is an integer from 1 to 22.

In this implementation, a code word obtained by performing LDPC encoding based on the check matrix in the check matrix set has better error control performance and packet error rate performance than a code word of a corresponding code length in WLAN LDPC.

In a possible implementation of the first aspect or the second aspect, the first check matrix includes H rows or M columns of the following (12×22) matrix:

```
87 64 -1 42 -1 -1 61 -1 -1 -1 1 0 -1 -1 -1 -1 -1 -1 -
1 -1 -1 -1
58 -1 -1 27 37 100 -1 32 49 -1 -1 0 0 -1 -1 -1 -1 -1 -1
-1 -1 -1
47 0 11 -1 -1 -1 71 -1 8 13 -1 -1 0 0 -1 -1 -1 -1 -1
-1 -1 -1
-1 55 7 24 4 75 54 -1 -1 28 0 -1 -1 0 0 -1 -1 -1 -
1 -1 -1 -1
```

```
97 38 53 -1 40 84 -1 30 83 67 -1 -1 -1 -1 0 0 -1 -1 -
1 -1 -1 -1
7 -1 -1 0 -1 -1 -1 52 -1 -1 1 -1 -1 -1 -1 0 -1 -1 -1
-1 -1 -1
39 80 -1 -1 -1 -1 -1 -1 -1 -1 -1 -1 -1 -1 -1 -1 0 -1 -
1 -1 -1 -1
-1 61 -1 79 -1 -1 -1 -1 -1 24 -1 51 44 -1 -1 -1 -1 0 -
1 -1 -1 -1
0 16 -1 -1 -1 -1 -1 -1 73 -1 -1 -1 -1 -1 -1 -1 -1 -1 0
-1 -1 -1
92 -1 -1 -1 36 -1 -1 -1 61 -1 -1 -1 -1 56 -1 -1 -1 -
1 0 -1 -1
58 24 -1 50 -1 -1 -1 -1 -1 -1 -1 26 -1 -1 -1 10 -1 -1 -
1 -1 0 -1
-1 4 -1 60 61 48 -1 -1 -1 -1 -1 -1 -1 -1 -1 -1 -1 -
1 -1 -1 0
```

- 1 in the first check matrix represents an all-zero matrix of size (K×K), 0 in the first check matrix represents an identity matrix of size (K×K), and an element greater than 0 in the first check matrix represents a CPM of size (K×K), where H is an integer from 1 to 12, and M is an integer from 1 to 22.

In this implementation, a code word obtained by performing LDPC encoding based on the check matrix in the check matrix set has better error control performance and packet error rate performance than a code word of a corresponding code length in WLAN LDPC.

In a possible implementation of the first aspect or the second aspect, the first check matrix includes H rows or M columns of the following (12×22) matrix:

```
19 64 -1 42 -1 -1 61 -1 -1 -1 1 0 -1 -1 -1 -1 -1 -1 -
1 -1 -1 -1
58 -1 -1 27 37 100 -1 32 49 -1 -1 0 0 -1 -1 -1 -1 -1 -1
-1 -1 -1
47 0 11 -1 -1 -1 71 -1 8 13 -1 -1 0 0 -1 -1 -1 -1 -1
-1 -1 -1
-1 55 7 24 72 75 54 -1 -1 28 0 -1 -1 0 0 -1 -1 -1 -
1 -1 -1 -1
97 38 53 -1 40 84 -1 30 83 67 -1 -1 -1 -1 0 0 -1 -1 -
1 -1 -1 -1
75 -1 -1 0 -1 -1 -1 52 -1 -1 1 -1 -1 -1 -1 0 -1 -1 -
1 -1 -1 -1
39 12 -1 -1 -1 -1 -1 -1 -1 -1 -1 -1 -1 -1 -1 0 -1 -
1 -1 -1 -1
-1 61 -1 79 -1 -1 -1 -1 -1 24 -1 51 44 -1 -1 -1 -1 0 -
1 -1 -1 -1
0 16 -1 -1 -1 -1 -1 -1 73 -1 -1 -1 -1 -1 -1 -1 -1 -1 0
-1 -1 -1
24 -1 -1 -1 36 -1 -1 -1 61 -1 -1 -1 -1 56 -1 -1 -1 -
1 0 -1 -1
58 92 -1 50 -1 -1 -1 -1 -1 -1 -1 26 -1 -1 -1 78 -1 -1 -
1 -1 0 -1
-1 72 -1 60 61 48 -1 -1 -1 -1 -1 -1 -1 -1 -1 -1 -1 -
1 -1 -1 0
```

- 1 in the first check matrix represents an all-zero matrix of size (K×K), 0 in the first check matrix represents an identity matrix of size (K×K), and an element greater than 0 in the first check matrix represents a CPM of size (K×K), where H is an integer from 1 to 12, and M is an integer from 1 to 22.

In this implementation, a code word obtained by performing LDPC encoding based on the check matrix in the check matrix set has better error control performance and packet error rate performance than a code word of a corresponding code length in WLAN LDPC.

In a possible implementation of the first aspect or the second aspect, the first check matrix includes H rows or M columns of the following (12×22) matrix:

```
53 64 -1 42 -1 -1 61 -1 -1 -1 1 0 -1 -1 -1 -1 -1 -1 -
1 -1 -1 -1
92 -1 -1 61 37 66 -1 100 49 -1 -1 0 0 -1 -1 -1 -1 -1 -1
-1 -1 -1
47 0 45 -1 -1 -1 37 -1 76 81 -1 -1 0 0 -1 -1 -1 -1 -
1 -1 -1 -1
```

```
-1 55 41 92 38 75 54 -1 -1 62 0 -1 -1 0 0 -1 -1 -1 -
1 -1 -1 -1
63 38 87 -1 40 16 -1 64 83 67 -1 -1 -1 0 0 -1 -1 -
1 -1 -1 -1
41 -1 -1 0 -1 -1 -1 52 -1 -1 1 -1 -1 -1 -1 0 -1 -1 -
1 -1 -1 -1
73 46 -1 -1 -1 -1 -1 -1 -1 -1 -1 -1 -1 -1 -1 -1 0 -1 -
1 -1 -1 -1
-1 61 -1 45 -1 -1 -1 -1 -1 58 -1 51 44 -1 -1 -1 -1 0 -
1 -1 -1 -1
0 16 -1 -1 -1 -1 -1 -1 73 -1 -1 -1 -1 -1 -1 -1 -1 -1 0
-1 -1 -1
58 -1 -1 -1 36 -1 -1 -1 95 -1 -1 -1 -1 -1 56 -1 -1 -1 -
1 0 -1 -1
24 58 -1 50 -1 -1 -1 -1 -1 -1 -1 60 -1 -1 -1 78 -1 -1 -
1 -1 0 -1
-1 38 -1 60 61 14 -1 -1 -1 -1 -1 -1 -1 -1 -1 -1 -1 -
1 -1 -1 0
```

- 1 in the first check matrix represents an all-zero matrix of size (K×K), 0 in the first check matrix represents an identity matrix of size (K×K), and an element greater than 0 in the first check matrix represents a CPM of size (K×K), where H is an integer from 1 to 12, and M is an integer from 1 to 22.

In this implementation, a code word obtained by performing LDPC encoding based on the check matrix in the check matrix set has better error control performance and packet error rate performance than a code word of a corresponding code length in WLAN LDPC.

In a possible implementation of the first aspect or the second aspect, the first check matrix includes H rows or M columns of the following (12×22) matrix:

```
87 64 -1 42 -1 -1 27 -1 -1 -1 1 0 -1 -1 -1 -1 -1 -1 -
1 -1 -1 -1
58 -1 -1 27 3 66 -1 66 83 -1 -1 0 0 -1 -1 -1 -1 -1 -
1 -1 -1 -1
13 0 45 -1 -1 -1 37 -1 42 81 -1 -1 0 0 -1 -1 -1 -1 -
1 -1 -1 -1
-1 55 75 92 38 41 20 -1 -1 28 0 -1 -1 0 0 -1 -1 -1 -
1 -1 -1 -1
97 38 53 -1 40 50 -1 64 49 33 -1 -1 -1 0 0 -1 -1 -
1 -1 -1 -1
41 -1 -1 0 -1 -1 -1 52 -1 -1 1 -1 -1 -1 -1 0 -1 -1 -
1 -1 -1 -1
39 46 -1 -1 -1 -1 -1 -1 -1 -1 -1 -1 -1 -1 -1 -1 0 -1 -
1 -1 -1 -1
-1 61 -1 45 -1 -1 -1 -1 -1 24 -1 85 44 -1 -1 -1 -1 0 -
1 -1 -1 -1
0 16 -1 -1 -1 -1 -1 -1 39 -1 -1 -1 -1 -1 -1 -1 -1 -1 0
-1 -1 -1
92 -1 -1 -1 70 -1 -1 -1 27 -1 -1 -1 -1 -1 56 -1 -1 -1 -
1 0 -1 -1
92 58 -1 16 -1 -1 -1 -1 -1 -1 26 -1 -1 -1 44 -1 -1 -
1 -1 0 -1
-1 38 -1 60 61 48 -1 -1 -1 -1 -1 -1 -1 -1 -1 -1 -1 -
1 -1 -1 0
```

- 1 in the first check matrix represents an all-zero matrix of size (K×K), 0 in the first check matrix represents an identity matrix of size (K×K), and an element greater than 0 in the first check matrix represents a CPM of size (K×K), where H is an integer from 1 to 12, and M is an integer from 1 to 22.

In this implementation, a code word obtained by performing LDPC encoding based on the check matrix in the check matrix set has better error control performance and packet error rate performance than a code word of a corresponding code length in WLAN LDPC.

In a possible implementation of the first aspect or the second aspect, the first check matrix includes H rows or M columns of the following (12×22) matrix:

```
53 30 -1 42 -1 -1 27 -1 -1 -1 1 0 -1 -1 -1 -1 -1 -1 -
1 -1 -1 -1
58 -1 -1 27 71 100 -1 66 49 -1 -1 0 0 -1 -1 -1 -1 -1
-1 -1 -1
```

```
47 0 45 -1 -1 -1 71 -1 76 47 -1 -1 0 0 -1 -1 -1 -1 -
1 -1 -1 -1
-1 21 41 24 38 75 54 -1 -1 28 0 -1 -1 0 0 -1 -1 -1 -
1 -1 -1 -1
63 38 19 -1 6 50 -1 64 83 67 -1 -1 -1 -1 0 0 -1 -1 -
1 -1 -1 -1
7 -1 -1 0 -1 -1 -1 52 -1 -1 1 -1 -1 -1 -1 0 -1 -1 -1
-1 -1 -1
73 80 -1 -1 -1 -1 -1 -1 -1 -1 -1 -1 -1 -1 -1 -1 0 -1 -
1 -1 -1 -1
-1 61 -1 45 -1 -1 -1 -1 -1 24 -1 17 44 -1 -1 -1 -1 0 -
1 -1 -1 -1
0 16 -1 -1 -1 -1 -1 -1 5 -1 -1 -1 -1 -1 -1 -1 -1 0
-1 -1 -1
24 -1 -1 -1 70 -1 -1 -1 61 -1 -1 -1 -1 -1 56 -1 -1 -1 -
1 0 -1 -1
24 24 -1 50 -1 -1 -1 -1 -1 -1 -1 60 -1 -1 -1 78 -1 -1 -
1 -1 0 -1
-1 38 -1 60 61 82 -1 -1 -1 -1 -1 -1 -1 -1 -1 -1 -1 -
1 -1 -1 0
```

- 1 in the first check matrix represents an all-zero matrix of size (K×K), 0 in the first check matrix represents an identity matrix of size (K×K), and an element greater than 0 in the first check matrix represents a CPM of size (K×K), where H is an integer from 1 to 12, and M is an integer from 1 to 22.

In this implementation, a code word obtained by performing LDPC encoding based on the check matrix in the check matrix set has better error control performance and packet error rate performance than a code word of a corresponding code length in WLAN LDPC.

In a possible implementation of the first aspect or the second aspect, the first check matrix includes H rows or M columns of the following (12×22) matrix:

```
87 64 -1 8 -1 -1 61 -1 -1 -1 1 0 -1 -1 -1 -1 -1 -1 -
1 -1 -1 -1
58 -1 -1 61 37 32 -1 100 83 -1 -1 0 0 -1 -1 -1 -1 -1 -1
-1 -1 -1
47 0 45 -1 -1 -1 71 -1 8 47 -1 -1 0 0 -1 -1 -1 -1 -
1 -1 -1 -1
-1 21 75 58 38 75 54 -1 -1 28 0 -1 -1 0 0 -1 -1 -1 -
1 -1 -1 -1
29 4 53 -1 40 50 -1 30 49 101 -1 -1 -1 -1 0 0 -1 -1 -1
-1 -1 -1
7 -1 -1 0 -1 -1 -1 18 -1 -1 1 -1 -1 -1 -1 0 -1 -1 -1
-1 -1 -1
39 46 -1 -1 -1 -1 -1 -1 -1 -1 -1 -1 -1 -1 -1 -1 0 -1 -
1 -1 -1 -1
-1 27 -1 79 -1 -1 -1 -1 -1 58 -1 51 44 -1 -1 -1 -1 0 -
1 -1 -1 -1
0 50 -1 -1 -1 -1 -1 -1 73 -1 -1 -1 -1 -1 -1 -1 -1 0
-1 -1 -1
92 -1 -1 -1 36 -1 -1 -1 61 -1 -1 -1 -1 -1 22 -1 -1 -1 -
1 0 -1 -1
24 24 -1 16 -1 -1 -1 -1 -1 -1 -1 60 -1 -1 -1 44 -1 -1 -
1 -1 0 -1
-1 38 -1 26 95 48 -1 -1 -1 -1 -1 -1 -1 -1 -1 -1 -1 -
1 -1 -1 0
```

- 1 in the first check matrix represents an all-zero matrix of size (K×K), 0 in the first check matrix represents an identity matrix of size (K×K), and an element greater than 0 in the first check matrix represents a CPM of size (K×K), where H is an integer from 1 to 12, and M is an integer from 1 to 22.

In this implementation, a code word obtained by performing LDPC encoding based on the check matrix in the check matrix set has better error control performance and packet error rate performance than a code word of a corresponding code length in WLAN LDPC.

In a possible implementation of the first aspect or the second aspect, the base matrix includes D rows or E columns of the following (12×24) matrix:

```
1 0 0 0 1 1 0 0 1 0 0 1 1 1 0 0 0 0 0
0 0 0 0 0
```

```
1 1 0 0 1 0 1 1 1 0 0 0 0 1 1 0 0 0 0
0 0 0 0 0
1 0 1 0 1 0 0 0 1 0 1 0 0 0 1 1 0 0 0
0 0 0 0 0
1 0 0 1 1 0 0 0 1 1 0 0 0 0 0 1 1 0 0
0 0 0 0 0
1 0 0 0 1 0 0 0 1 0 1 1 0 0 0 0 1 1 0
0 0 0 0 0
1 0 1 1 1 0 1 0 1 0 0 0 0 0 0 0 0 1 1
0 0 0 0 0
1 0 0 0 1 0 0 0 1 1 0 0 1 0 0 0 0 0 1
1 0 0 0 0
1 1 0 0 1 0 1 0 1 0 0 0 0 0 0 0 0 0 0
1 1 0 0 0
1 1 0 1 1 0 0 1 0 0 0 0 0 0 0 0 0 0 0
0 1 1 0 0
1 0 0 0 1 0 0 0 1 0 1 1 0 0 0 0 0 0 0
0 0 1 1 0
1 0 1 0 1 1 0 1 1 0 0 0 0 0 0 0 0 0 0
0 0 0 1 1
1 0 0 0 1 0 0 1 1 1 0 0 1 0 0 0 0 0 0
0 0 0 0 1
```

D is an integer from 1 to 12, and E is an integer from 1 to 24.

In a possible implementation of the first aspect or the second aspect, the first check matrix includes D rows or E columns of the following (12×24) matrix:

```
0 -1 -1 -1 0 0 -1 -1 0 -1 -1 0 1 0 -1 -1 -1 -1 -1
-1 -1 -1 -1 -1
49 0 -1 -1 44 -1 0 0 39 -1 -1 -1 -1 0 0 -1 -1 -1 -
1 -1 -1 -1 -1 -1
6 -1 0 -1 37 -1 -1 -1 51 -1 0 -1 -1 -1 0 0 -1 -1 -1
-1 -1 -1 -1 -1
2 -1 -1 0 47 -1 -1 -1 52 0 -1 -1 -1 -1 -1 0 0 -1 -1
-1 -1 -1 -1 -1
23 -1 -1 -1 30 -1 -1 -1 0 -1 36 11 -1 -1 -1 -1 0 0 -1
-1 -1 -1 -1 -1
51 -1 23 28 17 -1 30 -1 37 -1 -1 -1 -1 -1 -1 -1 0
0 -1 -1 -1 -1 -1
52 -1 -1 -1 35 -1 -1 -1 7 45 -1 0 -1 -1 -1 -1 -1
0 0 -1 -1 -1 -1
13 51 -1 -1 0 -1 8 -1 33 -1 -1 -1 -1 -1 -1 -1 -1 -
1 0 0 -1 -1 -1
7 20 -1 16 22 37 -1 -1 23 -1 -1 -1 -1 -1 -1 -1 -1 -1
-1 0 0 -1 -1
38 -1 -1 -1 19 -1 -1 -1 13 -1 3 17 -1 -1 -1 -1 -1 -1 -
1 -1 -1 0 0 -1
25 -1 35 -1 23 45 -1 41 9 -1 -1 -1 -1 -1 -1 -1 -1 -
1 -1 -1 -1 0 0
3 -1 -1 -1 16 -1 -1 2 25 32 -1 -1 1 -1 -1 -1 -1 -1 -1
-1 -1 -1 -1 0
```

- 1 in the first check matrix represents an all-zero matrix of size (L×L), 0 in the first check matrix represents an identity matrix of size (L×L), and an element greater than 0 in the first check matrix represents a CPM of size (L×L), where D is an integer from 1 to 12, and E is an integer from 1 to 24.

In this implementation, a code word obtained by performing LDPC encoding based on the check matrix in the check matrix set has better error control performance and packet error rate performance than a code word of a corresponding code length in WLAN LDPC.

In a possible implementation of the first aspect or the second aspect, the first check matrix includes D rows or E columns of the following (12×24) matrix:

```
0 -1 -1 -1 0 0 -1 -1 0 -1 -1 0 1 0 -1 -1 -1 -1 -1
-1 -1 -1 -1 -1
49 0 -1 -1 44 -1 0 0 39 -1 -1 -1 -1 0 0 -1 -1 -1 -
1 -1 -1 -1 -1 -1
60 -1 0 -1 37 -1 -1 -1 51 -1 0 -1 -1 -1 0 0 -1 -1 -
1 -1 -1 -1 -1 -1
56 -1 -1 0 47 -1 -1 -1 52 0 -1 -1 -1 -1 -1 0 0 -1 -
1 -1 -1 -1 -1 -1
```

```
77 -1 -1 -1 30 -1 -1 -1 0 -1 36 11 -1 -1 -1 -1 0 0 -1
-1 -1 -1 -1 -1
51 -1 77 28 17 -1 30 -1 37 -1 -1 -1 -1 -1 -1 -1 -1 0
0 -1 -1 -1 -1 -1
52 -1 -1 -1 35 -1 -1 -1 7 45 -1 -1 0 -1 -1 -1 -1 -1
0 0 -1 -1 -1 -1
67 51 -1 -1 0 -1 8 -1 33 -1 -1 -1 -1 -1 -1 -1 -1 -
1 0 0 -1 -1 -1
61 74 -1 70 22 37 -1 -1 23 -1 -1 -1 -1 -1 -1 -1 -1 -
1 -1 0 0 -1 -1
38 -1 -1 -1 73 -1 -1 -1 67 -1 57 71 -1 -1 -1 -1 -1 -1 -
1 -1 -1 0 0 -1
25 -1 35 -1 77 45 -1 41 9 -1 -1 -1 -1 -1 -1 -1 -1 -
1 -1 -1 -1 0 0
57 -1 -1 -1 16 -1 -1 56 25 32 -1 -1 1 -1 -1 -1 -1 -1 -
1 -1 -1 -1 -1 0
```

-   1 in the first check matrix represents an all-zero matrix of size (L×L), 0 in the first check matrix represents an identity matrix of size (L×L), and an element greater than 0 in the first check matrix represents a CPM of size (L×L), where D is an integer from 1 to 12, and E is an integer from 1 to 24.

In this implementation, a code word obtained by performing LDPC encoding based on the check matrix in the check matrix set has better error control performance and packet error rate performance than a code word of a corresponding code length in WLAN LDPC.

In a possible implementation of the first aspect or the second aspect, the first expansion factor is 81, the second expansion factor is 54, and the third expansion factor is 27.

In a possible implementation of the first aspect or the second aspect, an encoded sequence corresponding to the first check matrix includes a code word with a code length of 1944 bits, an encoded sequence corresponding to the second check matrix includes a code word with a code length of 1296 bits, and an encoded sequence corresponding to the third check matrix includes a code word with a code length of 648 bits.

According to a third aspect, an embodiment of this application provides another encoding method. The method includes: performing LDPC encoding on a bit sequence based on a check matrix, to obtain an encoded sequence; and transmitting a data packet obtained based on the encoded sequence. The check matrix may be the first check matrix, the second check matrix, or the third check matrix in the first aspect or the second aspect. Alternatively, the check matrix is a check matrix obtained by performing modulo processing on the first check matrix in the first aspect or the second aspect. Specifically, the check matrix is any one of the following matrix 1 to matrix 5. Specifically, the check matrix is any one of the following matrix 21 to matrix 26.

In this embodiment of this application, a code word obtained by performing LDPC encoding based on the check matrix has better error control performance and packet error rate performance than a code word of a corresponding code length in WLAN LDPC.

According to a fourth aspect, an embodiment of this application provides another decoding method. The method includes: obtaining an LDPC encoded sequence; and performing decoding on the LDPC encoded sequence based on a check matrix. The check matrix may be the first check matrix, the second check matrix, or the third check matrix in the first aspect or the second aspect. Alternatively, the check matrix is a check matrix obtained by performing modulo processing on the first check matrix in the first aspect or the second aspect. Specifically, the check matrix is any one of the following matrix 1 to matrix 5. Specifically, the check matrix is any one of the following matrix 21 to matrix 26.

In this embodiment of this application, compared with decoding based on an existing WLAN LDPC check matrix, decoding based on the check matrix provided in this embodiment of this application has better error control performance and better packet error rate performance.

According to a fifth aspect, an embodiment of this application provides a communication apparatus. The communication apparatus has a function of implementing behavior in the method embodiment in the first aspect. The communication apparatus may be a communication device, or may be a component (for example, a processor, a chip, or a chip system) of the communication device, or may be a logical module or software that can implement all or some of functions of the communication device. The function of the communication apparatus may be implemented by hardware, or may be implemented by hardware executing corresponding software. The hardware or the software includes one or more modules or units corresponding to the foregoing function. In a possible implementation, the communication apparatus includes an interface module and a processing module. The processing module is configured to perform low-density parity-check LDPC encoding on a bit sequence based on a check matrix set, to obtain an encoded sequence, where the check matrix set includes a first check matrix and a second check matrix, a first expansion factor corresponding to the first check matrix is different from a second expansion factor corresponding to the second check matrix, the first check matrix is a check matrix obtained by expanding a base matrix using a first set of circular shift values, the second check matrix is a check matrix obtained by expanding the base matrix using a second set of circular shift values, and the second set of circular shift values are circular shift values obtained by using the first set of circular shift values. The transceiver module is configured to transmit a data packet obtained based on the encoded sequence.

For possible implementations of the communication apparatus in the fifth aspect, refer to the possible implementations of the first aspect.

For technical effects achieved by the possible implementations of the fifth aspect, refer to the description of the technical effects of the first aspect or the possible implementations of the first aspect.

According to a sixth aspect, an embodiment of this application provides a communication apparatus. The communication apparatus has a function of implementing behavior in the method embodiment in the second aspect. The communication apparatus may be a communication device, or may be a component (for example, a processor, a chip, or a chip system) of the communication device, or may be a logical module or software that can implement all or some of functions of the communication device. The function of the communication apparatus may be implemented by hardware, or may be implemented by hardware executing corresponding software. The hardware or the software includes one or more modules or units corresponding to the foregoing function. In a possible implementation, the communication apparatus includes a transceiver module and a processing module. The transceiver module is configured to receive a signal that carries a data packet obtained based on an LDPC encoded sequence. The processing module is configured to: obtain the LDPC encoded sequence based on the received signal that carries the data packet obtained based on the LDPC encoded sequence; and decode the encoded sequence based on a check matrix set, where the check matrix set includes a first check matrix and a second check matrix, a first expansion factor corresponding to the first check matrix is different from a second expansion factor corresponding to the second check matrix, the first check matrix is a check matrix obtained by expanding a base matrix using a first set of circular shift values, the second check matrix is a check matrix obtained by expanding the base matrix using a second set of circular shift values, and the second set of circular shift values are circular shift values obtained by using the first set of circular shift values.

For possible implementations of the communication apparatus in the sixth aspect, refer to the possible implementations of the second aspect.

For technical effects achieved by the possible implementations of the sixth aspect, refer to the description of the technical effects of the second aspect or the possible implementations of the second aspect.

According to a seventh aspect, an embodiment of this application provides a communication apparatus. The communication apparatus has a function of implementing behavior in the method embodiment in the third aspect. The communication apparatus may be a communication device, or may be a component (for example, a processor, a chip, or a chip system) of the communication device, or may be a logical module or software that can implement all or some of functions of the communication device. The function of the communication apparatus may be implemented by hardware, or may be implemented by hardware executing corresponding software. The hardware or the software includes one or more modules or units corresponding to the foregoing function. In a possible implementation, the communication apparatus includes a transceiver module and a processing module. The processing module is configured to perform LDPC encoding on a bit sequence based on a check matrix, to obtain an encoded sequence. The transceiver module is configured to transmit a data packet obtained based on the encoded sequence. The check matrix may be the first check matrix, the second check matrix, or the third check matrix in the first aspect or the second aspect. Alternatively, the check matrix is a check matrix obtained by performing modulo processing on the first check matrix in the first aspect or the second aspect. Specifically, the check matrix is any one of the following matrix 1 to matrix 5. Specifically, the check matrix is any one of the following matrix 21 to matrix 26.

For technical effects achieved by the possible implementations of the seventh aspect, refer to the description of the technical effects of the third aspect or the possible implementations of the third aspect.

According to an eighth aspect, an embodiment of this application provides a communication apparatus. The communication apparatus has a function of implementing behavior in the method embodiment in the fourth aspect. The communication apparatus may be a communication device, or may be a component (for example, a processor, a chip, or a chip system) of the communication device, or may be a logical module or software that can implement all or some of functions of the communication device. The function of the communication apparatus may be implemented by hardware, or may be implemented by hardware executing corresponding software. The hardware or the software includes one or more modules or units corresponding to the foregoing function. In a possible implementation, the communication apparatus includes a transceiver module and a processing module. The transceiver module is configured to receive a signal that carries a data packet obtained based on an LDPC encoded sequence. The processing module is configured to: obtain the LDPC encoded sequence based on the received signal that carries the data packet obtained based on the LDPC encoded sequence; and perform decoding on the LDPC encoded sequence based on a check matrix. The check matrix may be the first check matrix, the second check matrix, or the third check matrix in the first aspect or the second aspect. Alternatively, the check matrix is a check matrix obtained by performing modulo processing on the first check matrix in the first aspect or the second aspect. Specifically, the check matrix is any one of the following matrix 1 to matrix 5. Specifically, the check matrix is any one of the following matrix 21 to matrix 26.

For technical effects achieved by the possible implementations of the eighth aspect, refer to the description of the technical effects of the fourth aspect or the possible implementations of the fourth aspect.

According to a ninth aspect, an embodiment of this application provides another communication apparatus. The communication apparatus includes a processor. The processor is coupled to a memory. The memory is configured to store a program or instructions. When the program or instructions are executed by the processor, the communication apparatus is enabled to perform the method according to any one of the first aspect to the fourth aspect.

In this embodiment of this application, a to-be-encoded bit sequence may be a first bit sequence, a second bit sequence, or a third bit sequence. A base matrix may be a first base matrix or a second base matrix.

In this embodiment of this application, in a process of performing the method, a process of sending information (or a signal) in the method may be understood as a process of outputting information according to instructions of the processor. When the information is output, the processor outputs the information to a transceiver, so that the transceiver transmits the information. After the information is output by the processor, the information may further require other processing, and then reaches the transceiver. Similarly, when the processor receives input information, the transceiver receives the information, and inputs the information into the processor. Further, after the transceiver receives the information, other processing may need to be performed on the information before the information is input into the processor.

An operation such as sending and/or receiving involved in the processor may be generally understood as an instruction output based on the processor, unless otherwise noted, or if the operation does not conflict with an actual function or internal logic of the operation in a related description.

In an implementation process, the processor may be a processor specially configured to perform these methods, or may be a processor, for example, a general-purpose processor that executes computer instructions in a memory to perform these methods. For example, the processor may be further configured to execute a program stored in the memory. When the program is executed, the communication apparatus is enabled to perform the method according to any one of the first aspect or the possible implementations of the first aspect.

In a possible implementation, the memory is located outside the communication apparatus. In a possible implementation, the memory is located in the communication apparatus.

In a possible implementation, the processor and the memory may alternatively be integrated into one device, that is, the processor and the memory may alternatively be integrated together.

In a possible implementation, the communication apparatus further includes the transceiver. The transceiver is configured to receive a signal, send a signal, or the like.

According to a tenth aspect, this application provides another communication apparatus. The communication apparatus includes a processing circuit and an interface circuit. The interface circuit is configured to obtain data or output data. The processing circuit is configured to perform the method shown in any one of the first aspect to the fourth aspect.

According to an eleventh aspect, this application provides a computer-readable storage medium. The computer-readable storage medium stores a computer program, and the computer program includes program instructions. When the program instructions are executed, a computer is enabled to perform the method shown in any one of the first aspect to the fourth aspect.

According to a twelfth aspect, this application provides a computer program product. The computer program product includes a computer program, and the computer program includes program instructions. When the program instructions are executed, a computer is enabled to perform the method shown in any one of the first aspect to the fourth aspect.

According to a thirteenth aspect, this application provides a communication system, including the communication apparatus according to any one of the fifth aspect or the possible implementations of the fifth aspect and the communication apparatus according to any one of the sixth aspect or the possible implementations of the sixth aspect.

According to a fourteenth aspect, this application provides a communication system, including the communication apparatus according to the seventh aspect and the communication apparatus according to the eighth aspect.

According to a fifteenth aspect, this application provides a chip, including a processor and a communication interface. The processor reads, through the communication interface, instructions stored on a memory, to perform the method according to any one of the first aspect to the fourth aspect.

**BRIEF DESCRIPTION OF DRAWINGS**

To describe the technical solutions in embodiments of this application or in the background more clearly, the following briefly describes the accompanying drawings for describing embodiments of this application or the background.

FIG. 1 shows an example of a check matrix H of an LDPC code;
FIG. 2 shows a Tanner graph of a check matrix H of an LDPC code;
FIG. 3 shows an example of an LDPC code encoding process;
FIG. 4 is a diagram of a shortening operation part in an LDPC encoding process;

FIG. 5 shows an example of a mother matrix obtained by expanding $H_{MC}$;

FIG. 6 shows an example of four (4×4) CPMs according to this application;

FIG. 7 shows an example of a check matrix obtained by expanding a base matrix 1 of size (12×22) according to an embodiment of this application;

FIG. 8 shows an example of a wireless communication system to which a technical solution according to this application is applicable;

FIG. 9 is an interaction flowchart of an LDPC code encoding and decoding method according to an embodiment of this application;

FIG. 10A and FIG. 10B are an interaction flowchart of another LDPC code encoding and decoding method according to an embodiment of this application;

FIG. 11 shows an example of a base matrix according to this application;

FIG. 12 shows an example of a check matrix;

FIG. 13 is a diagram of tree expansion according to an embodiment of this application;

FIG. 14A is a diagram of a PER simulation performance comparison for LDPC codes according to an embodiment of this application;

FIG. 14B is a diagram of a PER simulation performance comparison for LDPC codes according to an embodiment of this application;

FIG. 15 is a diagram of a structure of a communication apparatus 1500 according to an embodiment of this application;

FIG. 16 is a diagram of a structure of another communication apparatus 160 according to an embodiment of this application; and

FIG. 17 is a diagram of a structure of another communication apparatus 170 according to an embodiment of this application.

## DESCRIPTION OF EMBODIMENTS

Terms "first", "second", and the like in the specification, claims, and accompanying drawings of this application are merely used to distinguish between different objects, and are not used to describe a specific order. In addition, terms such as "include" and "have" and any other variants thereof are intended to cover a non-exclusive inclusion. For example, processes, methods, systems, products, or devices that include a series of steps or units are not limited to listed steps or units, but instead, optionally further include steps or units that are not listed, or optionally further include other steps or units inherent to these processes, methods, products, or devices.

In this application, the term "example", "for example", or the like is used to represent giving an example, an illustration, or a description. Any embodiment or design scheme described with "example", "in an example", or "for example" in this application should not be explained as being more preferred or having more advantages than another embodiment or design scheme. Exactly, use of the term "example", "in an example", "for example", or the like is intended to present a related concept in a specific manner.

"Embodiments" mentioned herein mean that specific features, structures, or characteristics described in combination with the embodiments may be included in at least one embodiment of this application. The phrase shown in various locations in the specification may not necessarily refer to a same embodiment, and is not an independent or optional embodiment exclusive from another embodiment. It may be understood explicitly and implicitly by a person skilled in the art that the embodiments described herein may be combined with other embodiments.

Terms used in the following embodiments of this application are merely intended to describe specific embodiments, but are not intended to limit this application. The terms "one", "a", "an", "the", and "this" of singular forms used in this specification and the appended claims of this application are also intended to include plural forms, unless otherwise specified in the context clearly. It should also be understood that the term "and/or" used in this application means and includes any or all possible combinations of one or more listed items. For example, "A and/or B" may represent three cases: Only A exists, only B exists, and both A and B exist, where A and B may be singular or plural. The term "a plurality of" used in this application means two or more.

It may be understood that in embodiments of this application, "B corresponding to A" indicates that there is a correspondence between A and B, and B may be determined based on A. However, it should also be understood that determining (or generating) B based on (or based on) A does not mean that B is determined (or generated) based on (or based on) A only, and B may alternatively be determined (or generated) based on (or based on) A and/or other information.

To facilitate understanding of the solutions in this application, related concepts of LDPC code in this application are first described.

LDPC code is short for low-density parity-check code. Literally, an LDPC code is a parity-check code with a low-density nature. The low density herein means that a check matrix of the LDPC code has a low density. Therefore, to understand what the LDPC code is, it is necessary to first understand the three concepts: parity-check code, check matrix, and low density.

1. Parity-check code

Parity-check code is an encoding method that makes the number of 1s in a code word always odd or even by adding a redundant bit. A parity-check code is an error-detecting code. Parity-check code is usually used for digital encoding in a binary field of 0 and 1. One or more bits (check bits) are added to the end of a code word. Whether an error occurs in the code word before and after transmission is determined by determining whether the number of 1s in the code word is odd or even. For example, if a code word 100 uses parity check, a check bit may be 1. In this case, a value s of the (exclusive OR) sum of the entire code word is 0, that is, 1001. If the code word changes to 1101 after transmission, one information bit (which may be referred to as a bit) is incorrect. Then, s is 1, and it can be determined that a transmission error occurs. It should be understood that if an even number of information bits are incorrect, the algorithm fails. Therefore, further, a plurality of check bits may be set. For example, a four-bit code word 1101 may be grouped, and a first bit of check bits is used to check a first bit and a second bit of information bits (that is, the first two bits 11 of the information bits). For example, if the sum of the first two bits of the information bits is 0, the first bit of the check bits should be set to 0. Similarly, a second bit of the check bits may be used to check the last two information bits of the code word 1101, and then the second bit of the check bits is set to 1. Therefore, an encoded code word is 110101. This is actually the check idea of LDPC code, that is, the meaning of "PC". It can be learned that the LDPC code is a block code and actually uses parity check. If a low density feature is added, the LDPC code can be obtained.

2. Low-density nature of the LDPC code

The low-density nature of the LDPC code means that the number of 1s in a check matrix of the LDPC code is very small. The LDPC code is a linear block code, and the check matrix of the LDPC code is a sparse matrix. The number of zero elements in the check matrix of the LDPC code is far greater than the number of non-zero elements. In other words, a row weight (that is, the number of 1s in each row) and a column weight (that is, the number of 1s in each column) of the check matrix are far less than a code length of the LDPC code.

3. Check matrix and generator matrix of the LDPC code

The code word 1101 is used as an example. A check relationship between information bits and check bits of the code word may be expressed in the form of a matrix. The information bits are denoted as c1, c2, c3, and c4, and the check bits are denoted as p1 and p2. c = [c1, c2, c3, c4], x = [c1, c2, c3, c4, p1, p2]. c and x are code words before and after encoding respectively. In the example of the code word 1101, the check relationship between the information bits and the check bits of the code word 1101 may be represented as the following linear relationships: c1 + c2 + p1 = 0, and c3 + c4 + p2 = 0. The linear relationships may be expressed as the following formula:

$$x \cdot H^T = s = 0 \quad (1);$$

where H is $\begin{bmatrix} 1 & 1 & 0 & 0 & 1 & 0 \\ 0 & 0 & 1 & 1 & 0 & 1 \end{bmatrix}$, and s = (0,0). H is a check matrix, s is a syndrome, and $H^T$ represents a transpose of H. The idea of the formula (1) is that after an original code word (an unencoded code word) c is encoded by using a generator matrix G (G is determined by H), an obtained transmit code word x needs to satisfy $x \cdot H^T = 0$. To easily determine whether the result is 0, the concept of the syndrome s is introduced. As long as s is all 0s, there is no problem with transmission. In this application, "·" represents a matrix multiplication operation, and "A·B" represents a product of matrix multiplication of matrix A and matrix B.

The transmit code word x obtained by encoding c using the generator matrix G may satisfy the following formula:

$$x = c \cdot G \quad (2).$$

c represents the unencoded code word (or the bit sequence), and G represents the generator matrix. G and $H^T$ are orthogonal to each other, that is, $G \cdot H^T = 0$. The generator matrix may be obtained by transforming the check matrix. That is, when the check matrix is known, the generator matrix corresponding to the check matrix may be obtained. c may be referred to as an information code word, and x may be referred to as a transmit code word. The formula (2) indicates that the transmit code word is obtained by multiplying the information code word by the generator matrix.

4. Tanner graph

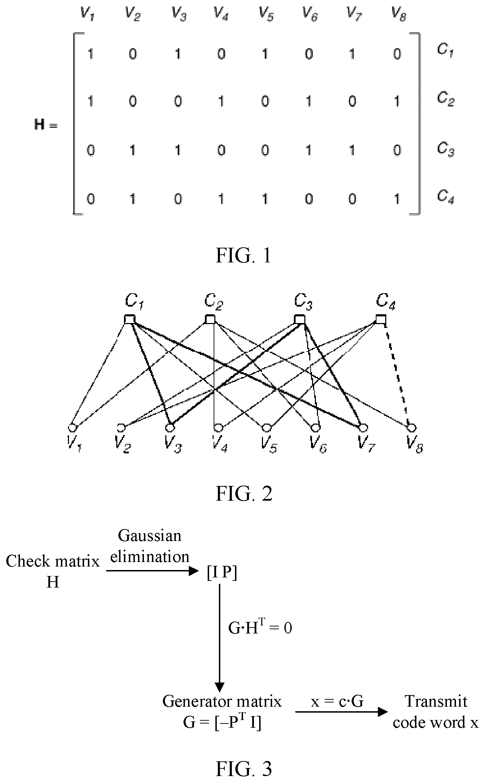

In 1981, Tanner represented a code word of an LDPC code in the form of a graph. Currently, such a graph is referred to as a Tanner graph, which is in a one-to-one correspondence with a check matrix. A Tanner graph includes two types of vertices. One type of vertex is a variable node, representing a code word bit. The other type of vertex is a check node, representing a check constraint relationship. Each check node represents a check constraint relationship, which is described below with reference to FIG. 1 and FIG. 2.

Refer to FIG. 1. FIG. 1 shows an example of a check matrix H of an LDPC code according to this application. In FIG. 1, {Vi} indicates a variable node set, and {Ci} indicates a check node set. Each row of the check matrix H corresponds to one check equation, and each column of the check matrix H corresponds to one code word bit. In FIG. 1, there are eight variable nodes and four check nodes. If a code word bit is included in a corresponding check equation, a connection line is used to connect an involved variable node and an involved check node, to obtain a Tanner graph.

Refer to FIG. 2. FIG. 2 is a Tanner graph of a check matrix H of an LDPC code according to an embodiment of this application. As shown in FIG. 2, the Tanner graph represents the check matrix of the LDPC code. For example, for the check matrix H with a size of m rows and n columns, the Tanner graph includes two types of nodes: n variable nodes (which may also be referred to as information nodes or bit nodes) and m check nodes, where both m and n are integers greater than 0. The n variable nodes correspond to the n columns of the check matrix H, and the m check nodes correspond to the m rows of the check matrix H. A cycle in the Tanner graph consists of connected vertices. The cycle uses one of the vertices as both a start point and an end point, and passes through each node only once. A length of the cycle is defined as the number of connection lines included in the cycle. A girth of a graph may also be referred to as a size of the graph, and is defined as the shortest cycle length in the graph. In FIG. 2, a girth is 6, as shown by the bold connection lines in FIG. 2.

5. LDPC code encoding

It can be learned from the foregoing description that the transmit code word is obtained by multiplying the information code word by the generator matrix, and the generator matrix may be obtained by transforming the check matrix. Therefore, the entire LDPC code encoding process is actually a process of constructing the check matrix. Refer to FIG. 3. FIG. 3 shows an example of an LDPC code encoding process according to this application. As shown in FIG. 3, a check matrix H can be changed to H = [I P] only through Gaussian elimination; a generator matrix $G = [-P^T I]$ is obtained based on $G \cdot H^T = 0$; and an information code word c is encoded by using the generator matrix G to obtain a transmit code word x, that is, $x = c \cdot G$. I represents an information bit part, P represents a check bit part, and x is the transmit code word.

6. LDPC code decoding

In an LDPC code decoding process, message iterations are continuously performed between variable nodes and check nodes according to the check rule between check bits (or referred to as parity elements) and information bits (or referred to as information elements) until a code word satisfying $x \cdot H^T = $ is found, and an output x is a decoded code word. LDPC code decoding algorithms include the following three categories: hard-decision decoding, soft-decision decoding, and hybrid decoding.

7. LDPC encoding in a WLAN scenario

Some WLAN standards (for example, IEEE 802.11n/ac) use an orthogonal frequency division multiplexing (orthogonal frequency division multiplexing, OFDM) technology. An LDPC encoding module needs to encode data bits (which may be referred to as information bits) and place the encoded data bits into an integer number of OFDM symbols, and these encoded bits also need to be exactly capable of being placed into an integer number of LDPC code words. To perform the foregoing steps, a transmit end first calculates the minimum number $N_{SYM}$ of OFDM symbols required for the current transmission, and then calculates, according to $N_{SYM}$ and the current modulation and coding scheme, the total number $N_{TCB}$ of encoded bits that can be placed into all the OFDM symbols, that is, $N_{TCB} = N_{CBPS} * N_{SYM}$, where $N_{CBPS}$ is the number of bits that can be stored in each OFDM symbol. Subsequently, the transmit end calculates, based on the obtained result, a code length of an LDPC code used in the current transmission and a quantity of required code words. For most combinations of bit lengths and modulation and coding schemes of to-be-encoded data, because data bits for filling a data bit part in an LDPC code word are insufficient, a shortening operation needs to be performed before a check bit is generated. The data bit part in the LDPC code word includes only an information bit (or a data bit), and does not include a check bit (or a check bit).

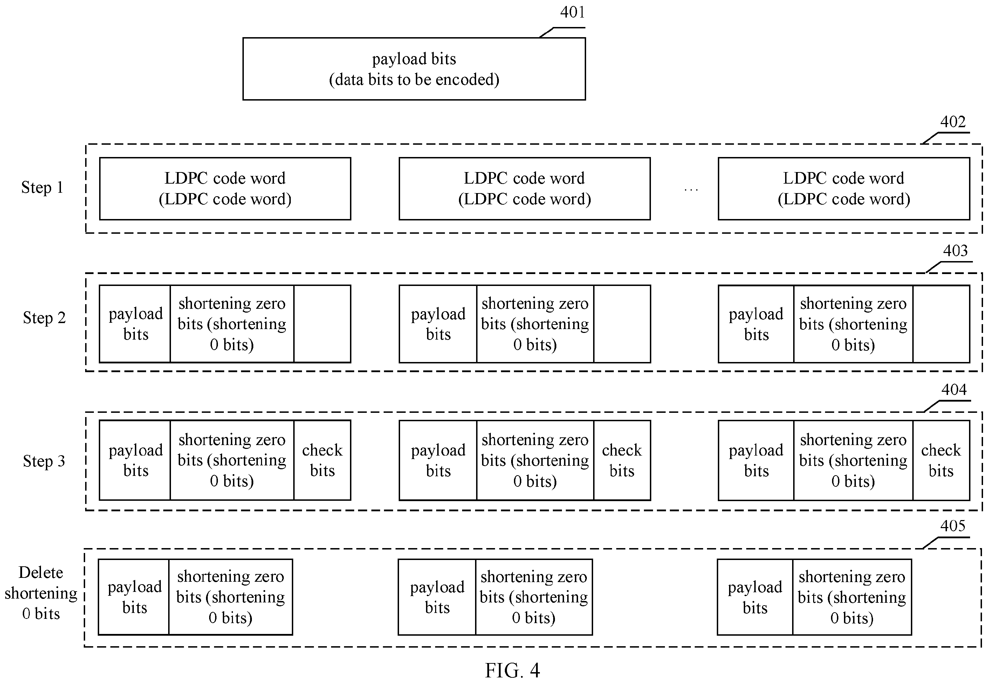

In this application, the shortening operation means that before the check bit is generated through LDPC encoding, a specific quantity of 0s are filled in a data bit part of code word information, and these 0s are deleted after the check bit is generated through encoding. FIG. 4 is a diagram of a shortening operation part in an LDPC encoding process according to an embodiment of this application. As shown in FIG. 4, 401 represents to-be-encoded data bits (payload bits); step (step) 1 is to calculate a length of an LDPC code word and a quantity of code words required for sending the to-be-encoded data bits, and 402 shows the length of the LDPC code word and the quantity of code words; step 2 is to perform a shortening operation on the to-be-encoded data bits, and 403 shows code words including the data bits and shortening zero bits (shortening zero bits); step 3 is to generate check bits (parity bits) by using the data bits and the shortening zero bits, and 404 shows code words including the data bits, the shortening zero bits, and the check bits; and these shortening zero bits are then deleted (discard shortening bits), and 405 shows code words including only the data bits and the check bits.

8. Obtaining a mother matrix by expanding a check matrix

A mother matrix is a larger matrix, and check matrices of different sizes may be read from the mother matrix. The check matrices of different sizes that are read from the mother matrix correspond to different code rates. The mother matrix may be obtained by expanding a check matrix (which may be referred to as a base matrix). For example, when the base matrix is read from the mother matrix, the base matrix is the check matrix. In this case, a code rate corresponding to the check matrix is the largest. When the entire mother matrix is read, the mother matrix is the check matrix. In this case, a code rate corresponding to the check matrix is the smallest. The following describes, with reference to an example, how to obtain the mother matrix by expanding the check matrix.

If $H_{MC}$ represents a base matrix of size $(4 \times 24)$ (for example, a WLAN LDPC check matrix of code length 1944 and code rate 5/6), $0_{4 \times 100}$ represents an all-zero matrix of size $(4 \times 100)$, and $I_{100 \times 100}$ represents an identity matrix of size $(100 \times 100)$, a matrix $H_{IR}$ of size $(100 \times 24)$ is defined to form an expanded mother matrix $H$ with $H_{MC}$, $0_{4 \times 100}$, and $I_{100 \times 100}$, that is:

$$H = \begin{bmatrix} H_{MC} & 0_{4 \times 100} \\ H_{IR} & I_{100 \times 100} \end{bmatrix} \quad (1).$$

It can be learned from the formula that, because both $0_{4 \times 100}$ and $I_{100 \times 100}$ are fixed matrices, a key of rate compatibility for the mother matrix (that is, check matrices with different code rates may be read from the mother matrix) lies in design and optimization of $H_{MC}$ and $H_{IR}$. If an incremental redundancy bit corresponding to a lower code rate is expected through expanding $H_{MC}$, $H_{MC}$ needs to be expanded by a required quantity of columns based on the required code rate. For example, if the code rate needs to be reduced from 5/6 corresponding to $H_{MC}$ to 4/7, or 324 new incremental redundancy bits corresponding to four columns need to be added to $H_{MC}$, $H_{MC}$ needs to be expanded to the lower left based on $H$, that is, expanded four rows downwards and four rows rightwards.

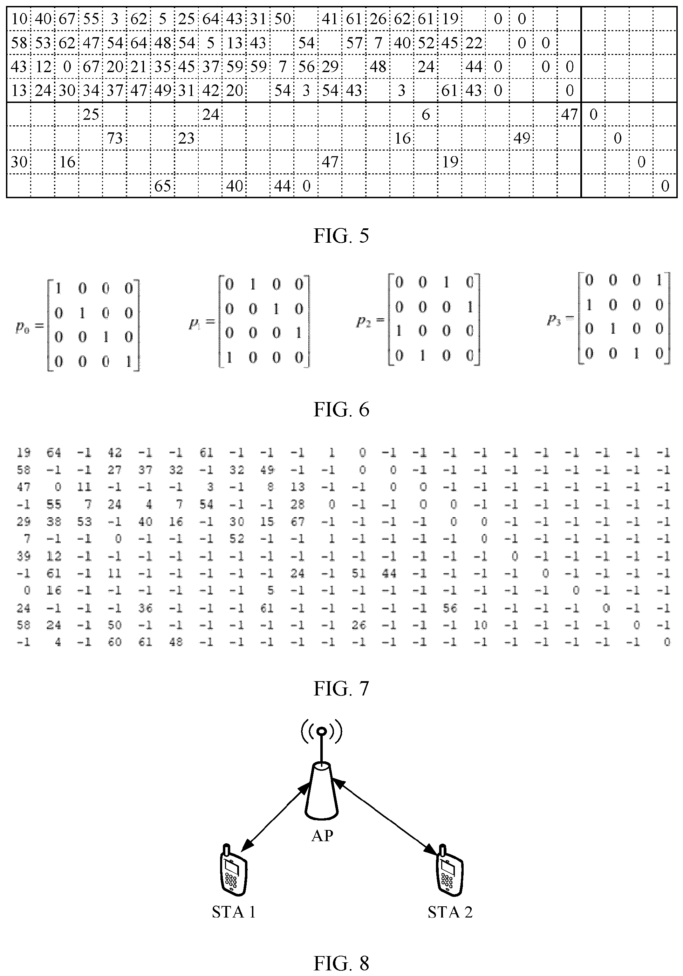

Refer to FIG. 5. FIG. 5 shows an example of a mother matrix obtained by expanding $H_{MC}$. As shown in FIG. 5, a rectangular box at the upper left corner of the mother matrix is a matrix $H_{MC}$, $H_{MC}$ is expanded four columns rightwards, and $H_{MC}$ is expanded four rows downwards, to obtain the mother matrix shown in FIG. 5. Each blank cell in FIG. 5 represents an all-zero matrix of size $(81 \times 81)$, the upper left corner of the mother matrix is a matrix $H_{MC}$ of size $(4 \times 24)$, the upper right corner of the mother matrix is a first fixed matrix, and the first fixed matrix is $0_{4 \times 100}$. The lower left corner of the mother matrix is a matrix $H_{IR}$, the lower right corner of the mother matrix is a second fixed matrix, and the fixed matrix is large $I_{100 \times 100}$.

A size of a matrix obtained by expanding $H_{MC}$ is $(8 \times 28)$, as shown by the entire matrix in FIG. 5. Each element (except the blank cells) in the mother matrix is a circulant permutation matrix of size $(81 \times 81)$. It should be understood that a size of the entire mother matrix is $(8 \times 28)$, and a final size of the mother matrix obtained by expanding each entry is $(648 \times 2268)$. If the remaining code rate or the remaining quantity of incremental redundancy bits needs to be obtained, a required part may be selected from the upper left part of $H$ as a check matrix according to the foregoing method. If $(81 \cdot j)$ incremental redundancy check bits need to be generated in addition to a code word bit corresponding to an original $H_{MC}$, the selected check matrix is a part of size $(4 + j) \times (24 + j)$ in the upper left part of $H$, and $j$ is a positive integer.

The foregoing uses the check matrix $H_{MC}$ as an example to describe a process of expanding the base matrix into the mother matrix. Obtaining a mother matrix by expanding another check matrix is also based on the same design idea.

9. Obtaining a check matrix by expanding a base matrix

A base matrix of an LDPC code may be expanded into check matrices of LDPC codes with various code lengths as required. A base matrix of an LDPC code includes only two types of elements: 0 and 1. In this application, 0 in the base matrix may be replaced by a blank, "-", "-1", or another number or symbol. This is not limited in this application. In this application, when the check matrix is obtained by expanding the base matrix, 1 in the base matrix may be expanded into a non-all-zero square matrix (which may also be referred to as a non-all-0 square matrix), and a 0 element in the base matrix may be expanded into an all-zero square matrix (which may also be referred to as an all-0 square matrix). In this application, the all-zero square matrix is a square matrix in which all elements included are 0, for example, a square matrix of size ($27 \times 27$). In this application, the non-all-zero square matrix is a square matrix including at least one non-0 element, for example, a circulant permutation matrix (circulant permutation matrix, CPM). A CPM is a circular shift of an identity matrix. In other words, a circular shift of an identity matrix is referred to as a CPM. Meanings of all subsequent CPMs are the same, and are not described again subsequently. In this application, any CPM may be represented by one value and one expansion factor together. In other words, any CPM corresponds to one value and one expansion factor. That sizes of two CPMs are different means that the two CPMs correspond to different expansion factors. In this application, a value corresponding to the CPM may be referred to as a specific expansion factor value, an expansion factor value, a specific expansion factor, a circular shift coefficient, a circular shift factor, or the like. An expansion factor corresponding to the CPM represents a size of the CPM; that is, CPMs of different sizes have different expansion factors. For example, an expansion factor of a CPM of size ($27 \times 27$) is 27. In other words, if an expansion factor of a CPM is 27, it indicates that a size of the CPM is ($27 \times 27$). For another example, an expansion factor of a CPM of size ($54 \times 54$) is 54. Meanings of expansion factors of all subsequent CPMs are the same, and are not described again subsequently. It should be noted that expansion factors of CPMs in the check matrix are the same. An expansion factor of each CPM in the check matrix may be considered as an expansion factor corresponding to the check matrix. For example, a size of a base matrix is ($12 \times 22$), and the base matrix is expanded by using an expansion factor Z = 27, to obtain a check matrix. An expansion factor of each CPM in the check matrix is Z, and an expansion factor corresponding to the check matrix is Z.

In this application, a value (integer) corresponding to the CPM represents the number of bits that are circularly shifted to the right in the identity matrix. FIG. 6 shows an example of four ($4 \times 4$) CPMs according to this application. As shown in FIG. 6, $P_0$ represents a ($4 \times 4$) identity matrix, $P_0$ may be considered as a CPM with an expansion factor of 4 and a corresponding value of 0, $P_1$ is a CPM with an expansion factor of 4 and a corresponding value of 1, $P_2$ is a CPM with an expansion factor of 4 and a corresponding value of 2, and $P_3$ is a CPM with an expansion factor of 4 and a corresponding value of 3. FIG. 6 shows an example of four CPMs according to an embodiment of this application. It should be understood that any CPM may be obtained by circularly shifting a corresponding identity matrix to the right. Details are not described herein again. It may be understood that 1 in the base matrix may be expanded into a CPM of any size, and 0 in the base matrix may be expanded into an all-zero square matrix of any size. The meaning or function of 1 or 0 in a subsequent base matrix is consistent with that in the foregoing description, and is not described again.

A method of obtaining the check matrix by expanding the base matrix may be as follows: 1 in the base matrix is replaced by a CPM, and 0 in the base matrix is replaced by an all-0 square matrix of a corresponding size. For example, each element in the base matrix is 0 or 1. To obtain a check matrix by expanding the base matrix, each 0 in the base matrix is expanded into a ($Z \times Z$) all-zero matrix, and each 1 in the base matrix is expanded into a ($Z \times Z$) CPM, where Z is an expansion factor corresponding to the CPM, and values corresponding to different CPMs are the same or different. Therefore, a series of check matrices of LDPC codes may be obtained based on the base matrix. Sizes of these check matrices and expansion factors of the CPMs may be different, but the check matrices and the CPMs correspond or conform to the same base matrix.

The following is an example of a check matrix obtained by expanding a base matrix. An example of a base matrix of size ($12 \times 22$) is as follows:

```
1 1 0 1 0 0 1 0 0 0 1 1 0 0 0 0 0 0 0
0 0 0
1 0 0 1 1 1 0 1 1 0 0 1 1 0 0 0 0 0 0
0 0 0
1 1 1 0 0 0 1 0 1 1 0 0 1 1 0 0 0 0 0
0 0 0
0 1 1 1 1 1 1 0 0 1 1 0 0 1 1 0 0 0 0
0 0 0
1 1 1 0 1 1 0 1 1 1 0 0 0 0 1 1 0 0 0
0 0 0
1 0 0 1 0 0 0 1 0 0 1 0 0 0 0 1 0 0 0
0 0 0
1 1 0 0 0 0 0 0 0 0 0 0 0 0 0 1 0 0
0 0 0
0 1 0 1 0 0 0 0 0 1 0 1 1 0 0 0 0 1 0
0 0 0
1 1 0 0 0 0 0 0 1 0 0 0 0 0 0 0 0 0 1
0 0 0
1 0 0 0 1 0 0 0 1 0 0 0 0 1 0 0 0 0
1 0 0
1 1 0 1 0 0 0 0 0 0 0 1 0 0 0 1 0 0 0
0 1 0
0 1 0 1 1 1 0 0 0 0 0 0 0 0 0 0 0 0 0
0 0 1
```

Refer to FIG. 7. FIG. 7 shows an example of a check matrix (a check matrix 1 below) obtained by expanding a base matrix 1 of size (12×22) according to an embodiment of this application. As shown in FIG. 7, "-1" in the check matrix represents an all-zero matrix of size (K×K), 0 in the check matrix represents an identity matrix (or referred to as a unit matrix) of size (K×K), and an element greater than 0 in the check matrix represents a CPM of size (K×K) and a corresponding value being the element, where K represents an expansion factor corresponding to the check matrix. In this application, -1 (representing an all-zero matrix) in the check matrix may be replaced by a blank, "-", or another number or symbol. This is not limited in this application. The meaning or function of "-" or 0 in a subsequent check matrix is the same as that in the foregoing description, and is not described again. Obtaining a check matrix by expanding a base matrix may be: expanding the base matrix by using a set of expansion factors, to obtain the check matrix. For example, the check matrix 1 is obtained by expanding the base matrix 1 using a set of expansion factors, where the set of expansion factors may be a (12×22) two-dimensional matrix shown in FIG. 7. That is, the check matrix 1 is obtained by expanding the base matrix 1 using the (12×22) two-dimensional matrix shown in FIG. 7. When the matrix shown in FIG. 7 represents the check matrix 1, "-1" in the matrix shown in FIG. 7 represents an all-zero matrix of size (K×K), 0 in the matrix shown in FIG. 7 represents an identity matrix (or referred to as a unit matrix) of size (K×K), and an element greater than 0 in the matrix shown in FIG. 7 represents a CPM of size (K×K) and a corresponding value being the element, where K represents an expansion factor corresponding to the check matrix 1. The check matrix 1 is actually a (12×K)×(22×K) two-dimensional matrix expanded from the matrix shown in FIG. 7, instead of the (12×22) two-dimensional matrix shown in FIG. 7. When the matrix shown in FIG. 7 represents a set of expansion factors, each element in the matrix shown in FIG. 7 is a specific value of an expansion factor in the set of expansion factors. In this example, the set of expansion factors may be a matrix of the same size as the base matrix 1, that is, the (12×22) two-dimensional matrix shown in FIG. 7. Specific values of expansion factors in the set of expansion factors are in a one-to-one correspondence with elements in the base matrix 1. It should be understood that when a set of expansion factors used for expanding any base matrix is a two-dimensional matrix, elements in the two-dimensional matrix are in a one-to-one correspondence with those at the same positions in the base matrix 1. A possible implementation of expanding a base matrix by using a set of expansion factors, to obtain a check matrix is: using a two-dimensional matrix (of the same size as the base matrix) corresponding to the set of expansion factors as the check matrix, where "-1" in the check matrix represents an all-zero matrix of size (K×K), 0 in the check matrix represents an identity matrix of size (K×K), and an element greater than 0 in the check matrix represents a CPM of size (K×K) and a corresponding value being the element. It should be noted that a set of expansion factors used to obtain the check matrix by expanding the base matrix is not limited to a form of a matrix, and may alternatively be in another form, for example, an array.

A process of expanding the base matrix into the check matrix is described above by using an example. It should be understood that any base matrix may be expanded in the same manner to obtain a check matrix of a required code length. In this application, if a check matrix is expanded from a base matrix, it may be understood that the check matrix conforms to (or satisfies) the base matrix, or that the check matrix corresponds to the base matrix.

To improve transmission reliability of a wireless transmission system, LDPC codes have been widely used in WLAN standards. Compared with the IEEE 802.15.4z standard, a new IEEE 802.15ab standard may introduce a new LDPC encoding technology, to greatly improve data transmission reliability of the system. Therefore, it may be considered that a new LDPC code is designed for a next-generation WLAN standard or UWB standard, to further improve reliability and system performance of a next-generation WLAN system or UWB system.

To improve reliability and system performance of a next-generation WLAN system or UWB system, this application proposes a design of obtaining check matrices of different code lengths through expansion using a single base matrix and a set (or a collection) of expansion factors for the next-generation WLAN system or UWB system. The solution provided in this application to obtain check matrices of different code lengths through expansion using a single base matrix and a set of expansion factors is applicable to a transmission scenario in which both a medium packet and a long packet exist, providing relatively good error control performance. In other words, compared with encoding and decoding using an existing check matrix of a corresponding code length, encoding and decoding using a check matrix obtained through expansion with the solution provided in this application provide better error control performance.

The technical solutions of this application are mainly applicable to a wireless communication system. The wireless communication system may comply with a wireless communication standard of the Third Generation Partnership Project (Third Generation Partnership Project, 3GPP), or may comply with another wireless communication standard, for example, a wireless communication standard in the 802 family (for example, 802.11, 802.15, or 802.20) of the Institute of Electrical and Electronics Engineers (Institute of Electrical and Electronics Engineers, IEEE). The technical solutions of this application are further applicable to a wireless local area network system, for example, an Internet of Things (Internet of Things, IoT) network, a UWB system, or a vehicle-to-everything (Vehicle to X, V2X) network. Certainly, embodiments of this application are further applicable to other possible communication systems, for example, a long term evolution (long term evolution, LTE) system, an LTE frequency division duplex (frequency division duplex, FDD) system, an LTE time division duplex (time division duplex, TDD) system, a universal mobile telecommunication system (universal mobile telecommunication system, UMTS), a worldwide interoperability for microwave access (worldwide interoperability for microwave access, WiMAX) communication system, a 5th generation (5th generation, 5G) communication system, and a future 6th generation (6th generation, 6G) communication system.

Embodiments of this application are mainly described by using a network in which a WLAN system or a UWB system is deployed, and in particular, a network to which the IEEE 802.11 standard is applied, as an example. A person skilled in the art easily understands that aspects of this application may be extended to other networks using various standards or protocols, for example, Bluetooth (Bluetooth), high-performance radio LAN (high performance radio LAN, HIPERLAN) (a wireless standard similar to the IEEE 802.11 standard, mainly used in Europe), and a wide area network (WAN), a personal area network (personal area network, PAN), or another network that is known currently or developed in the future. Therefore, regardless of a used coverage area and wireless access protocol, various aspects provided in this application are applicable to any suitable wireless network.

The foregoing communication system applicable to this application is only an example for description, and the communication system applicable to this application is not limited thereto. This is uniformly described herein, and details are not described below again.

Refer to FIG. 8. FIG. 8 shows an example of a wireless communication system to which a technical solution according to this application is applicable. The communication system includes an access point (access point, AP) and one or more STAs (only a STA 1 and a STA 2 are shown). Both the access point and the STAs support a WLAN protocol. The WLAN protocol may include IEEE 802.11be (or referred to as Wi-Fi 7, the EHT protocol), and may further include protocols such as IEEE 802.15ab, IEEE 802.11ax, and IEEE 802.11ac. Certainly, with continuous evolution and development of communication technologies, the WLAN protocol may further include a next-generation protocol of IEEE 802.11be, or the like. A WLAN is used as an example. An apparatus for implementing a method in this application may be an access point or a STA in the WLAN, or a chip or a processing system installed in the access point or the STAs.

The access point is an apparatus having a wireless communication function, supports communication according to the WLAN protocol, and has a function of communicating with another device (for example, a station or another access point) in the WLAN network. Certainly, the access point may further have a function of communicating with another device. The WLAN system includes one or more access point (access point, AP) stations and one or more non access point stations (none access point station, non-AP STA). For ease of description, in this specification, an access point station is referred to as an access point (AP), and a non-access point station is referred to as a station (STA).

The access point may be a standalone device, or may be a chip, a processing system, or the like installed in the standalone device. The device in which the chip or the processing system is installed may implement a method and a function in embodiments of this application under the control of the chip or the processing system (that is, the AP). The AP in the embodiments of this application is an apparatus that provides a service for a station (Station, STA), and may support 802.11 family protocols, for example, 802.15ab, 802.11ac, 802.11n, 802.11g, 802.11b, 802.11a, 802.11be, Wi-Fi 8, or a next generation thereof. For example, the AP may be a communication entity such as a communication server, a router, a switch, or a bridge. The AP may include a macro base station, a micro base station (also referred to as a small cell), a pico base station, a femto base station, a relay station, an access point, a gNB, a transmission and reception point (transmission reception point, TRP), an evolved NodeB (evolved NodeB, eNB), a radio network controller (radio network controller, RNC), a home base station (for example, a home evolved NodeB or a home NodeB, HNB), a baseband unit (baseband unit, BBU), a Wi-Fi access point (access point, AP), integrated access and backhaul (integrated access and backhaul, IAB), or the like. Certainly, the AP may alternatively be a chip and a processing system in devices in various forms, to implement the method and the function in embodiments of this application.

The station is an apparatus having a wireless communication function, supports communication according to the WLAN protocol, and has a capability of communicating with another station or access point in the WLAN network. For example, the STA is any communication apparatus that allows a user to communicate with the AP and further communicate with the WLAN. The communication apparatus may be a standalone device, or may be a chip, a processing system, or the like installed in the standalone device. The device in which the chip or the processing system is installed may implement a method and a function in embodiments of this application under the control of the chip or the processing system (that is, the station). The STA may include a mobile phone (mobile phone), a mobile station (mobile station, MS), a tablet computer (pad), a computer with a wireless transceiver function (for example, a notebook computer), a virtual reality (virtual reality, VR) device, an augmented reality (augmented reality, AR) device, a wireless terminal in industrial control (industrial control), a wireless terminal in self driving (self driving), a wireless terminal in telemedicine (remote medical), a wireless terminal in a smart grid (smart grid), a wireless terminal in transportation safety (transportation safety), a wireless terminal in a smart city (smart city), a wireless terminal in a smart home (smart home), a subscriber unit (subscriber unit), a cellular phone (cellular phone), a wireless data card, a personal digital assistant (personal digital assistant, PDA) computer, a tablet computer, a laptop computer (laptop computer), a machine type communication (machine type communication, MTC) terminal, or the like. The station may include various handheld devices, vehicle-mounted devices, wearable devices, or computing devices that have a wireless communication function, or other processing devices connected to a wireless modem. Optionally, the station may be a handheld device (handset), a vehicle-mounted device, a wearable device, a terminal in the internet of things or a vehicle-to-everything network, a terminal in any form in 5G and a communication system evolved after 5G, or the like that has a wireless communication function. This is not limited in this application. The station may support 802.11 family protocols, for example, a plurality of WLAN standards such as 802.15ab, 802.11ac, 802.11n, 802.11g, 802.11b, 802.11a, 802.11be, Wi-Fi 8, or a next generation thereof.

The following describes an LDPC code encoding method according to this application with reference to the accompanying drawings.

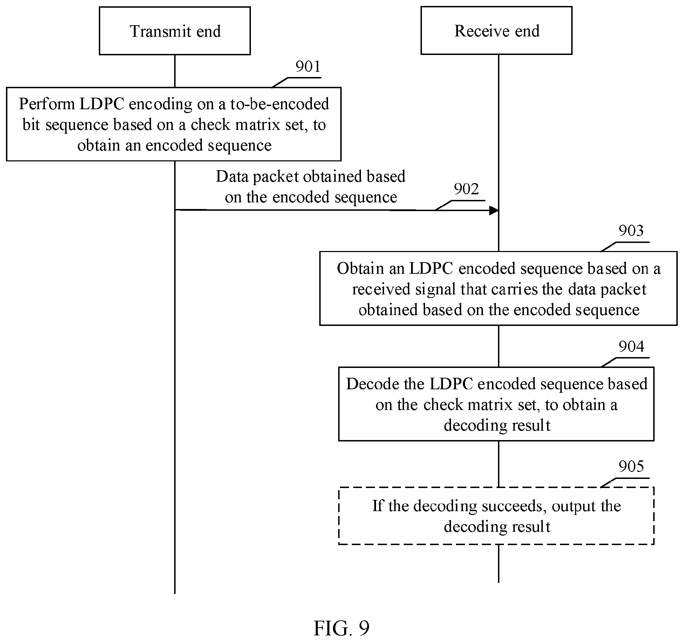

FIG. 9 is an interaction flowchart of an LDPC code encoding and decoding method according to an embodiment of this application. The method process shown in FIG. 9 may be applied to a wireless local area network system and/or an ultra-wideband UWB-based wireless personal local area network system. As shown in FIG. 9, the method includes the following steps.

901: A transmit end performs LDPC encoding on a to-be-encoded bit sequence based on a check matrix set, to obtain an encoded sequence.

In embodiments of this application, the transmit end may be a station, or may be an access point. The transmit end in embodiments of this application is an encoding device.

In a possible implementation, a check matrix of an LDPC code may be shortened or punctured to obtain another code rate. For a shortening operation, refer to FIG. 4.

In embodiments of this application, the check matrix set includes a first check matrix and a second check matrix. A first expansion factor corresponding to the first check matrix is different from a second expansion factor corresponding to the second check matrix. For example, the first expansion factor may be 1.5, 2, or the like times the second expansion factor. For example, the first expansion factor is 102, and the second expansion factor is 68. For another example, the first expansion factor is 68, and the second expansion factor is 34. For another example, the first expansion factor is 81, and the second expansion factor is 54. For another example, the first expansion factor is 54, and the second expansion factor is 27. The first check matrix is a check matrix obtained by expanding a base matrix using a first set of circular shift values, and the second check matrix is a check matrix obtained by expanding the base matrix using a second set of circular shift values. The base matrix is described below, and is not described here now. The second set of circular shift values are a set of circular shift values obtained by using the first set of circular shift values. Both the first check matrix and the second check matrix are obtained by expanding the base matrix. In other words, both the first check matrix and the second check matrix conform to the base matrix. The check matrix set may further include a third check matrix that conforms to the base matrix. That is, the check matrix set includes two or more check matrices that conform to the base matrix. In other words, the check matrix set includes two or more check matrices that are obtained by expanding the base matrix. Any two check matrices in the check matrix set correspond to different expansion factors. In the following description, the check matrix set includes the first check matrix and the second check matrix, for example.

That the transmit end performs LDPC encoding on the to-be-encoded bit sequence based on the check matrix set, to obtain an encoded sequence may be understood as that the transmit end performs LDPC encoding on the to-be-encoded bit sequence based on any check matrix in the check matrix set, to obtain an encoded sequence. A possible implementation of step 901 is as follows: The transmit end performs LDPC encoding on the to-be-encoded bit sequence based on the first check matrix in the check matrix set, to obtain an encoded sequence. For example, the transmit end performs LDPC encoding on the to-be-encoded bit sequence by using a generator matrix corresponding to the first check matrix, to obtain the encoded sequence. Another possible implementation of step 901 is as follows: The transmit end performs LDPC encoding on the to-be-encoded bit sequence based on the second check matrix in the check matrix set, to obtain an encoded sequence. For example, the transmit end performs LDPC encoding on the to-be-encoded bit sequence by using a generator matrix corresponding to the second check matrix, to obtain the encoded sequence. In a possible implementation, the transmit end determines, based on a code rate of a code word that needs to be generated, to perform LDPC encoding on the to-be-encoded bit sequence by using a submatrix of a check matrix. That is, the transmit end may perform, based on the code rate of the code word that needs to be generated, LDPC encoding on the to-be-encoded bit sequence based on a submatrix formed by some rows or columns of the check matrix. For example, the transmit end performs LDPC encoding on the to-be-encoded bit sequence based on a submatrix of the first check matrix or the second check matrix, to obtain an encoded sequence. It may be understood that the transmit end may perform, according to a requirement or a preset rule, LDPC encoding on the to-be-encoded bit sequence by using any one of the two or more check matrices included in the check matrix set. For a specific process, refer to LDPC code encoding and LDPC encoding in a WLAN described above. A specific method of performing LDPC encoding on the to-be-encoded bit sequence based on the check matrix set is not limited in this application.

It should be noted that the transmit end performs LDPC encoding on the to-be-encoded bit sequence at a same moment by using one check matrix, and the transmit end may perform LDPC encoding on the to-be-encoded bit sequence at different moments by using different check matrices. Herein, that the transmit end performs LDPC encoding on the to-be-encoded bit sequence based on the check matrix set, to obtain the encoded sequence is intended to indicate that the transmit end may select different check matrices according to actual requirements to perform LDPC encoding on the to-be-encoded bit sequence. For example, the transmit end selects a corresponding check matrix from the check matrix set based on a code rate and/or a code length for transmitting data.

In a possible implementation, because the second set of circular shift values are obtained by using the first set of circular shift values, the transmit end may store only the first set of circular shift values, with no need to store the second set of circular shift values. The transmit end may directly obtain the first check matrix through expansion using the stored first set of circular shift values. When there is a need to use the second check matrix, the transmit end first obtains the second set of circular shift values through processing using the stored first set of circular shift values, and then obtains the second check matrix through expansion using the second set of circular shift values. In this implementation, the stored circular shift values can be reduced.

In a possible implementation, respective circular shift values of both the first set of circular shift values and the second set of circular shift values meet a same modulo operation relationship. For example, the circular shift values in the first set of circular shift values are in a one-to-one correspondence with the circular shift values in the second set of circular shift values. The transmit end may perform a same modulo operation on the circular shift values in the first set of circular shift values, to obtain the second set of circular shift values. For example, the second set of circular shift values are obtained by performing modulo processing on the first set of circular shift values and the second expansion factor corresponding to the second check matrix. For example, the first set of circular shift values and the second set of circular shift values are different two-dimensional matrices, and elements in the first set of circular shift values are in a one-to-one correspondence with those at the same positions in the second set of circular shift values. An element in an $i^{th}$ row and a $j^{th}$ column in the first set of circular shift values is $Z1(i,j)$, an element in an $i^{th}$ row and a $j^{th}$ column in the second set of circular shift values is $Z2(i,j)$, and $Z2(i,j) = Z1(i,j) \% Z2$, where Z2 is the expansion factor corresponding to the second check matrix, and both i and j are integers greater than 0. $Z2(i,j)$ may be an element at any position in the second set of circular shift values. % represents a modulo operation or a remainder operation. Modulo operation a % p (or a mod p) represents the remainder of a divided by p. For example, 58 % 34 = 24. It should be noted that, if $Z1(i,j) = -1$, $Z2(i,j) = -1$; or if $Z1(i,j) = 0$, $Z2(i,j) = 0$. In this implementation, the respective circular shift values of both the first set of circular shift values and the second set of circular shift values meet the same modulo operation relationship, and the second set of circular shift values can be quickly and accurately obtained by using the operation relationship and the first set of circular shift values.

In a possible implementation, the check matrix further includes a third check matrix, and the first expansion factor corresponding to the first check matrix is K times a third expansion factor corresponding to the third check matrix, where K is an odd number greater than 1, for example, K is 3. The third check matrix is a check matrix obtained by expanding the base matrix using a third set of circular shift values. The third set of circular shift values are a set of circular shift values obtained by using the first set of circular shift values. The third set of circular shift values are different from the second set of circular shift values. In a possible implementation, the second expansion factor is F times the third expansion factor, where F is an even number greater than 1, for example, F is 2. For example, the first expansion factor is 102, the second expansion factor is 68, and the third expansion factor is 34. For another example, the first expansion factor is 81, the second expansion factor is 54, and the third expansion factor is 27. In this implementation, the expansion factor corresponding to the first check matrix is K times the expansion factor corresponding to the third check matrix, that is, a code length of a code word obtained by encoding using the first check matrix is K times a code length obtained by encoding using the third check matrix. The transmit end may select a check matrix according to requirements to perform LDPC encoding, thereby obtaining code words of different code lengths and reducing resource overheads.

In a possible implementation, an encoded sequence corresponding to the first check matrix includes a code word with a code length of 2040 bits, an encoded sequence corresponding to the second check matrix includes a code word with a code length of 1360 bits, and an encoded sequence corresponding to the third check matrix includes a code word with a code length of 680 bits. An encoded sequence corresponding to any check matrix in the check matrix set includes one or more code words obtained by encoding based on the check matrix. That the encoded sequence corresponding to the first check matrix includes a code word with a code length of 2040 bits may be understood as that the first check matrix is used for encoding to obtain a code word with a code length of 2040 bits. That the encoded sequence corresponding to the second check matrix includes a code word with a code length of 1360 bits may be understood as that the second check matrix is used for encoding to obtain a code word with a code length of 1360 bits. That the encoded sequence corresponding to the third check matrix includes a code word with a code length of 680 bits may be understood as that the third check matrix is used for encoding to obtain a code word with a code length of 680 bits. The transmit end selects a corresponding check matrix from the check matrix set based on a code length for transmitting data, so that code words of different code lengths can be sent.

In a possible implementation, an encoded sequence corresponding to the first check matrix includes a code word with a code length of 1944 bits, an encoded sequence corresponding to the second check matrix includes a code word with a code length of 1296 bits, and an encoded sequence corresponding to the third check matrix includes a code word with a code length of 648 bits. An encoded sequence corresponding to any check matrix in the check matrix set includes one or more code words obtained by encoding based on the check matrix. That the encoded sequence corresponding to the first check matrix includes a code word with a code length of 1944 bits may be understood as that the first check matrix is used for encoding to obtain a code word with a code length of 1944 bits. That the encoded sequence corresponding to the second check matrix includes a code word with a code length of 1296 bits may be understood as that the second check matrix is used for encoding to obtain a code word with a code length of 1296 bits. That the encoded sequence corresponding to the third check matrix includes a code word with a code length of 648 bits may be understood as that the third check matrix is used for encoding to obtain a code word with a code length of 648 bits. The transmit end selects a corresponding check matrix from the check matrix set based on a code length for transmitting data, so that code words of different code lengths can be sent.

902: The transmit end transmits a data packet obtained based on the encoded sequence.

Correspondingly, a receive end receives a signal from the transmit end that carries the data packet obtained based on the encoded sequence.

In a possible implementation, the transmit end is a station, and the receive end is an access point. In another possible implementation, the transmit end is an access point, and the receive end is a station.

Specifically, the transmitting step may include but is not limited to: performing, by the transmit end based on LDPC-encoded bits (that is, the first data packet), processing such as stream parsing (stream parser), constellation mapping (constellation mapper), LDPC carrier mapping, or possibly including inverse Fourier transform (inverse discrete Fourier transform, IDFT), for transmitting on a channel. Because it is a conventional technical means in the art to obtain a corresponding data packet based on encoded information such as the encoded sequence, details are not described herein.

A possible implementation of step 902 is as follows: The transmit end broadcasts a data packet (referred to as a first data packet below) obtained based on the encoded sequence.

A possible implementation of step 902 is as follows: The transmit end sends a first data packet to the receive end (corresponding to a unicast mode).

903: The receive end obtains an LDPC encoded sequence based on the received signal that carries the data packet obtained based on the encoded sequence.

The LDPC encoded sequence is the encoded sequence obtained by the transmit end through LDPC encoding. A possible implementation of step 903 is as follows: The receive end uses a first log-likelihood ratio (log likelihood rate, LLR) sequence corresponding to a received first channel receiving sequence as the encoded sequence. The first channel receiving sequence corresponds to the signal that is received by the receive end and that carries the data packet obtained based on the encoded sequence. It should be understood that the receive end may also obtain the encoded sequence by using another received signal that carries the data packet obtained based on the encoded sequence. This is not limited in this application.

904: The receive end performs decoding on the LDPC encoded sequence based on the check matrix set, to obtain a decoding result.

The check matrix set includes the first check matrix and the second check matrix.

That the receive end decodes the encoded sequence based on the check matrix set, to obtain a decoding result may be understood as that the receive end decodes the encoded sequence based on any check matrix in the check matrix set, to obtain a decoding result. A possible implementation of step 904 is as follows: The receive end decodes the encoded sequence based on the first check matrix in the check matrix set, to obtain a decoding result. Another possible implementation of step 901 is as follows: The receive end decodes the encoded sequence based on the second check matrix in the check matrix set, to obtain a decoding result.

It should be understood that if the transmit end performs LDPC encoding on the to-be-encoded bit sequence based on the first check matrix, the receive end decodes the encoded sequence based on the first check matrix. If the transmit end performs LDPC encoding on the to-be-encoded bit sequence based on the second check matrix, the receive end decodes the encoded sequence based on the second check matrix. The receive end may learn, based on control information from the transmit end, the check matrix used for decoding the encoded sequence. The receive end may also learn, in another manner, the check matrix used for decoding the encoded sequence. This is not limited in this application.

It should be noted that the receive end decodes the encoded sequence at a same moment by using one check matrix, and the receive end may decode the to-be-decoded encoded sequence at different moments by using different check matrices. Herein, that the receive end decodes the encoded sequence based on the check matrix set is intended to indicate that the receive end may select different check matrices according to actual requirements to decode the to-be-decoded encoded sequence.

The receive end may decode the encoded sequence based on any check matrix in the check matrix set by using any one of hard-decision decoding, soft-decision decoding, or hybrid decoding. This is not limited herein.

905: If the decoding succeeds, the receive end outputs the decoding result.

Step 905 is optional rather than mandatory. The decoding result may be output by the receive end via an output device such as a display, a display screen, or an audio device. Optionally, if the receive end decoding is incorrect (or decoding fails), the receive end sends retransmission indication information to the transmit end, to request the transmit end to perform retransmission. In addition, if the decoding fails, the receive end may store the first LLR sequence, to combine the first LLR sequence with a subsequently received retransmitted LLR sequence for decoding.

In this embodiment of this application, the first check matrix is a check matrix obtained by expanding the base matrix using the first set of circular shift values, and the second check matrix is a check matrix obtained by expanding the base matrix using the second set of circular shift values. Because the second set of circular shift values may be obtained by using the first set of circular shift values, the transmit end needs to store only the first set of circular shift values, with no need to store the second set of circular shift values. In this way, circular shift values stored by the transmit end can be reduced. Similarly, the receive end also needs to store only the first set of circular shift values, with no need to store the second set of circular shift values. In this way, circular shift values stored by the receive end can be reduced.

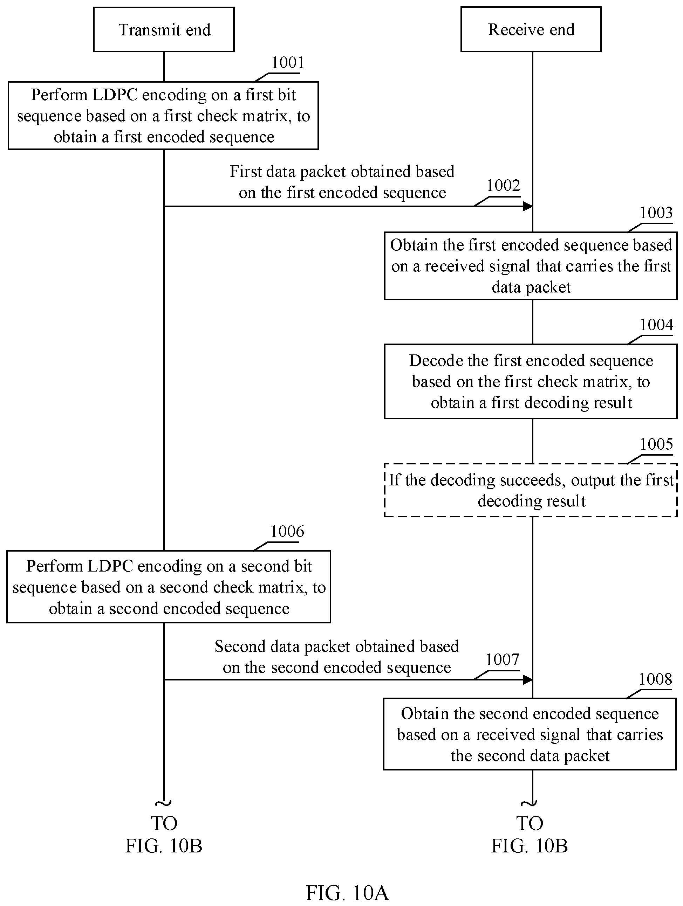

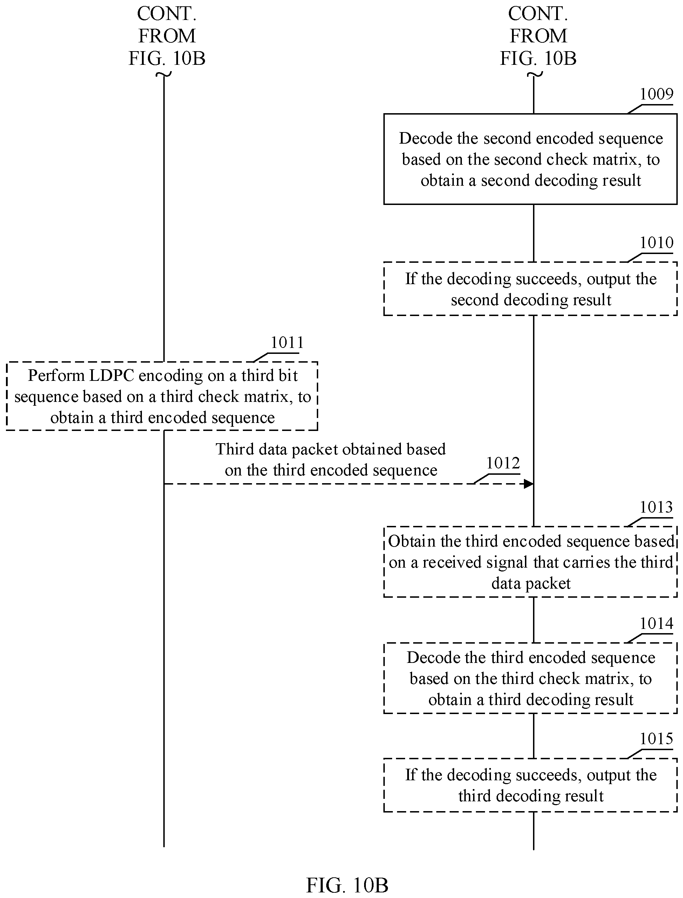

FIG. 10A and FIG. 10B are an interaction flowchart of another LDPC code encoding and decoding method according to an embodiment of this application. An interaction process of the method in FIG. 10A and FIG. 10B is a possible implementation of the method described in FIG. 9. In this implementation, a transmit end performs LDPC encoding on bit sequences of different lengths by using different check matrices, so that code words of different code lengths can be obtained through encoding. As shown in FIG. 10A and FIG. 10B, the method includes the following steps.

1001: The transmit end performs LDPC encoding on a first bit sequence based on a first check matrix, to obtain a first encoded sequence.

The transmit end stores a first set of circular shift values. Before performing step 1001, the transmit end may perform the following operation: expanding a base matrix by using the stored first set of circular shift values, to obtain the first check matrix. The foregoing describes, with reference to the example of obtaining the check matrix 1 by expanding the base matrix 1, a method of expanding the base matrix by using a set of circular shift values to obtain a check matrix. It should be understood that the transmit end may employ a similar method to expand the base matrix by using a set of circular shift values, to obtain a corresponding check matrix. A method of expanding the base matrix by using the first set of circular shift values or another set of circular shift values is not described herein again.

Before performing step 1001, the transmit end may perform the following operation: when LDPC encoding is to be performed on the first bit sequence by using the first check matrix, expanding the base matrix by using the first set of circular shift values, to obtain the first check matrix. The first bit sequence is a bit sequence currently to be sent by the transmit end. A case in which LDPC encoding is to be performed on the first bit sequence by using the first check matrix may be that a length of the first bit sequence is within a first interval. The first interval may be an interval configured as required. This is not limited in this application. For example, the first interval may be greater than or equal to P bits (bits), where P is 680, 1020, 648, 1296, or the like. When a length of a to-be-encoded bit sequence (for example, the first bit sequence) is within the first interval, the transmit end performs LDPC encoding on the bit sequence based on the first check matrix, where the first check matrix is used for encoding to obtain a code word of a first code length. The first code length may be 1360 bits, 2040 bits, 1296 bits, 1944 bits, or the like. That the length of the to-be-encoded first bit sequence is within the first interval may be understood as a condition that needs to be satisfied for obtaining the first check matrix by expanding based on the base matrix. In other words, that the length of the to-be-encoded first bit sequence is within the first interval is a condition for triggering the transmit end to obtain the first check matrix by expanding based on the base matrix. It should be understood that the transmit end may also obtain the first check matrix by expanding based on the base matrix when another condition is satisfied. For example, when it is determined that the to-be-encoded bit sequence needs to be encoded as the code word of the first code length, the transmit end obtains the first check matrix by expanding based on the base matrix.

The first check matrix is used for encoding to obtain a code word whose code length is the first code length. The first encoded sequence (that is, an encoded sequence corresponding to the first check matrix) includes one or more code words of the first code length. The first code length may be 2040 bits, 1360 bits, 1296 bits, 1944 bits, or the like. Code words may be classified into short codes, medium codes, and long codes based on their code lengths. A code length of a short code is shorter than a code length of a medium code, and a code length of a medium code is shorter than a code length of a long code. A code word whose code length is the first code length is a long code or a medium code.

1002: The transmit end transmits a first data packet obtained based on the first encoded sequence.

Correspondingly, a receive end receives a signal from the transmit end that carries the first data packet obtained based on the first encoded sequence. For step 1002, refer to step 902.

1003: The receive end obtains the first encoded sequence based on the received signal that carries the first data packet.

For step 1003, refer to step 903.

1004: The receive end performs decoding on the first encoded sequence based on the first check matrix, to obtain a first decoding result.

The receive end may learn, based on control information from the transmit end, the check matrix used for decoding the first encoded sequence. The receive end may also learn, in another manner, the check matrix used for decoding the first encoded sequence. This is not limited in this application.

1005: If the decoding succeeds, the receive end outputs the first decoding result.

Step 1005 is optional rather than mandatory. For step 1005, refer to step 905.

1006: The transmit end performs LDPC encoding on a second bit sequence based on a second check matrix, to obtain a second encoded sequence.

Before performing step 1006, the transmit end may perform the following operations: obtaining a second set of circular shift values by using the stored first set of circular shift values; and expanding the base matrix by using the second set of circular shift values, to obtain the second check matrix. In a possible implementation, the second set of circular shift values are obtained by performing modulo processing on the first set of circular shift values and the expansion factor corresponding to the second check matrix. The foregoing has described the method of obtaining the second set of circular shift values by performing modulo processing on the first set of circular shift values and the expansion factor corresponding to the second check matrix. Therefore, details are not described herein again.

Before performing step 1006, the transmit end may perform the following operation: when LDPC encoding is to be performed on the second bit sequence by using the second check matrix, expanding the base matrix by using the second set of circular shift values, to obtain the second check matrix. The second bit sequence is a bit sequence currently to be sent by the transmit end. A case in which LDPC encoding is to be performed on the second bit sequence by using the second check matrix may be that a length of the second bit sequence is within a second interval. The second interval may be an interval configured as required. This is not limited in this application. For example, the second interval may be less than P bits (bits) and greater than Q bits, where F is 680, 1020, 648, 972, or the like, and Q is 340, 324, or the like. When a length of any to-be-encoded bit sequence (for example, the second bit sequence) is within the second interval, the transmit end performs LDPC encoding on the bit sequence based on the second check matrix, where the second check matrix is used for encoding to obtain a code word of a second code length. The second code length may be 680 bits, 1360 bits, 648 bits, 1296 bits, or the like. That the length of the to-be-encoded second bit sequence is within the second interval may be understood as a condition that needs to be satisfied for obtaining the second check matrix by expanding based on the base matrix. In other words, that the length of the to-be-encoded second bit sequence is within the second interval is a condition for triggering the transmit end to obtain the second check matrix by expanding based on the base matrix. It should be understood that the transmit end may also obtain the second check matrix by expanding based on the base matrix when another condition is satisfied. For example, when it is determined that the to-be-encoded bit sequence needs to be encoded as the code word of the second code length, the transmit end obtains the second check matrix by expanding based on the base matrix.

The second check matrix is used for encoding to obtain a code word whose code length is the second code length. The second encoded sequence (that is, an encoded sequence corresponding to the second check matrix) includes one or more code words of the second code length. The second code length may be 1360 bits, 680 bits, 1296 bits, 648 bits, or the like. A code word whose code length is the second code length is a medium code or a short code. Optionally, a code word of the first code length is a medium code, and a code word of the second code length is a short code. For example, the first code length is 1360 bits, and the second code length is 680 bits. Optionally, a code word of the first code length is a long code, and a code word of the second code length is a medium code. For example, the first code length is 2040 bits, and the second code length is 1360 bits. A length of the first bit sequence is different from a length of the second bit sequence. The first bit sequence and the second bit sequence need to be LDPC encoded by using check matrices corresponding to different expansion factors. In other words, the first bit sequence and the second bit sequence need to be encoded as code words of different code lengths. For example, the first bit sequence includes 1600 bits (bits), and the second bit sequence includes 500 bits. The transmit end performs LDPC encoding on the first bit sequence based on the first check matrix, to obtain a first code word whose code length is the first code length, that is, the first encoded sequence. The transmit end performs LDPC encoding on the second bit sequence based on the second check matrix, to obtain a second code word whose code length is the second code length, that is, the second encoded sequence. It can be learned from this example that when transmitting code words of different code lengths, the transmit end needs to perform LDPC encoding on to-be-encoded bit sequences based on different check matrices.

1007: The transmit end transmits a second data packet obtained based on the second encoded sequence.

Correspondingly, the receive end receives a signal from the transmit end that carries the second data packet obtained based on the second encoded sequence. For step 1007, refer to step 902.

1008: The receive end obtains the second encoded sequence based on the received signal that carries the second data packet.

For step 1008, refer to step 903.

1009: The receive end performs decoding on the second encoded sequence based on the second check matrix, to obtain a second decoding result.

The receive end may learn, based on control information from the transmit end, the check matrix used for decoding the second encoded sequence. The receive end may also learn, in another manner, the check matrix used for decoding the second encoded sequence. This is not limited in this application.

1010: If the decoding succeeds, the receive end outputs the second decoding result.

Step 1010 is optional rather than mandatory. For step 1010, refer to step 905.

It should be noted that the transmit end and the receive end may first perform step 1001 to step 1005, and then perform step 1006 to step 1010; or may first perform step 1006 to step 1010, and then perform step 1001 to step 1005.

Step 1001 to step 1005 show the process in which the transmit end and the receive end perform encoding and decoding by using the first check matrix, and step 1006 to step 1010 show the process in which the transmit end and the receive end perform encoding and decoding by using the second check matrix. That is, step 1001 to step 1010 show a process in which the transmit end and the receive end perform encoding and decoding by using check matrices of different code lengths.

1011: The transmit end performs LDPC encoding on a third bit sequence based on a third check matrix, to obtain a third encoded sequence.

Before performing step 1011, the transmit end may perform the following operations: obtaining a third set of circular shift values by using the stored first set of circular shift values; and expanding the base matrix by using the third set of circular shift values, to obtain the third check matrix. In a possible implementation, the third set of circular shift values are obtained by performing modulo processing on the first set of circular shift values and a third expansion factor corresponding to the third check matrix. For example, the first set of circular shift values and the third set of circular shift values are different two-dimensional matrices, and elements in the first set of circular shift values are in a one-to-one correspondence with those at the same positions in the third set of circular shift values. An element in an $i^{th}$ row and a $j^{th}$ column in the first set of circular shift values is $Z1(i,j)$, an element in an $i^{th}$ row and a $j^{th}$ column in the third set of circular shift values is $Z3(i,j)$, and $Z3(i,j) = Z1(i,j) \% Z3$, where $Z3$ is the expansion factor corresponding to the third check matrix, and both i and j are integers greater than 0. $Z3(i,j)$ may be an element at any position in the third set of circular shift values. It should be noted that, if $Z1(i,j) = -1$, $Z3(i,j) = -1$; or if $Z1(i,j) = 0$, $Z3(i,j) = 0$. In this implementation, the third set of circular shift values can be quickly and accurately obtained by performing modulo processing on the first set of circular shift values and the third expansion factor corresponding to the third check matrix.

Before performing step 1011, the transmit end may perform the following operation: when LDPC encoding is to be performed on the third bit sequence by using the third check matrix, expanding the base matrix by using the third set of circular shift values, to obtain the third check matrix. The third bit sequence is a bit sequence currently to be sent by the transmit end. A case in which LDPC encoding is to be performed on the third bit sequence by using the third check matrix may be that a length of the third bit sequence is within a third interval. The third interval may be an interval configured as required. This is not limited in this application. For example, the third interval may be less than or equal to Q bits (bits), where Q is 340, 324, or the like. When a length of any to-be-encoded bit sequence (for example, the third bit sequence) is within the second interval, the transmit end performs LDPC encoding on the bit sequence based on the third check matrix, where the third check matrix is used for encoding to obtain a code word of a third code length. The third code length may be 680 bits or 648 bits. That the length of the to-be-encoded third bit sequence is within the third interval is a condition for triggering the transmit end to obtain the third check matrix by expanding based on the base matrix. It should be understood that the transmit end may also obtain the third check matrix by expanding based on the base matrix when another condition is satisfied. For example, when it is determined that the to-be-encoded bit sequence needs to be encoded as the code word of the third code length, the transmit end obtains the third check matrix by expanding based on the base matrix.

The third check matrix is used for encoding to obtain a code word whose code length is the third code length. The third encoded sequence (that is, an encoded sequence corresponding to the third check matrix) includes one or more code words of the third code length. The third code length may be 680 bits, 648 bits, or the like. A code word whose code length is the third code length is a short code. Optionally, a code word of the first code length is a long code, a code word of the second code length is a medium code, and a code word of the third code length is a short code. For example, the first code length is 2040 bits, the second code length is 1360 bits, and the third code length is 680 bits. For another example, the first code length is 1944 bits, the second code length is 1296 bits, and the third code length is 648 bits. The first bit sequence, the second bit sequence, and the third bit sequence need to be encoded as code words of different code lengths. Therefore, LDPC encoding needs to be performed by using different check matrices.

1012: The transmit end transmits a third data packet obtained based on the third encoded sequence.

Correspondingly, the receive end receives a signal from the transmit end that carries the third data packet obtained based on the third encoded sequence. For step 1012, refer to step 902.

1013: The receive end obtains the third encoded sequence based on the received signal that carries the third data packet.

For step 1013, refer to step 903.

1014: The receive end performs decoding on the third encoded sequence based on the third check matrix, to obtain a third decoding result.

The receive end may learn, based on control information from the transmit end, the check matrix used for decoding the third encoded sequence. The receive end may also learn, in another manner, the check matrix used for decoding the third encoded sequence. This is not limited in this application.

1015: If the decoding succeeds, the receive end outputs the third decoding result.

Step 1011 to step 1015 are optional rather than mandatory.

When the check matrix set includes only the first check matrix and the second check matrix, the transmit end and the receive end do not perform step 1011 to step 1015. That is, the transmit end performs LDPC encoding on the to-be-encoded bit sequence by using the first check matrix or the second check matrix.

When the check matrix set includes the first check matrix, the second check matrix, and the third check matrix, the transmit end and the receive end may perform step 1011 to step 1015.

Step 1001 to step 1005 are the process in which the transmit end and the receive end perform encoding and decoding by using the first check matrix. Step 1006 to step 1010 are the process in which the transmit end and the receive end perform encoding and decoding by using the second check matrix. Step 1011 to step 1015 are the process in which the transmit end and the receive end perform encoding and decoding by using the third check matrix. The order of the three processes is not limited.

In embodiments of this application, the transmit end performs LDPC encoding on bit sequences of different lengths by using different check matrices, so that code words of different code lengths can be obtained through encoding, thereby reducing resource overheads.

FIG. 9, and FIG. 10A and FIG. 10B describe the processes in which the transmit end and the receive end perform encoding and decoding by using the check matrices in the check matrix set. Examples of the base matrix and the check matrices in the check matrix set are not shown in the foregoing description. Therefore, the following describes an example of the base matrix and several possible examples of the first check matrix according to embodiments of this application. The base matrix may be a first base matrix, or may be a second base matrix.

In a possible implementation, the first base matrix is a (12×22) matrix shown as follows:

```
1 1 0 1 0 0 1 0 0 0 1 1 0 0 0 0 0 0 0
0 0 0
1 0 0 1 1 1 0 1 1 0 0 1 1 0 0 0 0 0 0
0 0 0
1 1 1 0 0 0 1 0 1 1 0 0 1 1 0 0 0 0 0
0 0 0
0 1 1 1 1 1 0 0 1 1 0 0 1 1 0 0 0 0
0 0 0
1 1 1 0 1 1 0 1 1 0 0 0 0 1 1 0 0 0
0 0 0
1 0 0 1 0 0 0 1 0 0 1 0 0 0 0 1 0 0 0
0 0 0
1 1 0 0 0 0 0 0 0 0 0 0 0 0 0 0 1 0 0
0 0 0
0 1 0 1 0 0 0 0 0 1 0 1 1 0 0 0 0 1 0
0 0 0
1 1 0 0 0 0 0 0 1 0 0 0 0 0 0 0 0 0 1
0 0 0
1 0 0 0 1 0 0 0 1 0 0 0 0 0 1 0 0 0 0
1 0 0
1 1 0 1 0 0 0 0 0 0 0 1 0 0 0 1 0 0 0
0 1 0
0 1 0 1 1 1 0 0 0 0 0 0 0 0 0 0 0 0 0
0 0 1
```

If the expansion factor Z = 34 is used to expand the first base matrix, a size of an actually obtained check matrix (that is, the third check matrix) of an LDPC code is (12×34)×(22×34). If the check matrix is used for encoding at a code rate of 1/2, 10 x 34 = 340 information bits are encoded to obtain a code word sequence with a code length of (22 - 2) × 34 = 680 bits, that is, the encoded sequence. If the information bits are less than 340 bits, 0 may be added to the end of the information bits according to an industry practice, and then encoding is performed. In addition, after the encoding, check bits obtained through encoding may also be punctured, to obtain a higher code rate or a shorter code length.

In this implementation, the design of the first base matrix allows a check matrix that conforms to the first base matrix to have information quickly transmitted and exchanged, and decoded and updated between code word bits corresponding to columns of the check matrix, thereby accelerating an overall decoding convergence speed of a system.

In a possible implementation, the second base matrix is a (12×24) matrix shown as follows:

```
1 0 0 0 1 1 0 0 1 0 0 1 1 1 0 0 0 0 0
0 0 0 0 0
1 1 0 0 1 0 1 1 1 0 0 0 0 1 1 0 0 0 0
0 0 0 0 0
1 0 1 0 1 0 0 0 1 0 1 0 0 0 1 1 0 0 0
0 0 0 0 0
1 0 0 1 1 0 0 0 1 1 0 0 0 0 0 1 1 0 0
0 0 0 0 0
1 0 0 0 1 0 0 0 1 0 1 1 0 0 0 0 1 1 0
0 0 0 0 0
1 0 1 1 1 0 1 0 1 0 0 0 0 0 0 0 0 1 1
0 0 0 0 0
1 0 0 0 1 0 0 0 1 1 0 0 1 0 0 0 0 0 1
1 0 0 0 0
1 1 0 0 1 0 1 0 1 0 0 0 0 0 0 0 0 0 0
```

```
1 1 0 0 0
1 1 0 1 1 1 0 0 1 0 0 0 0 0 0 0 0 0 0
0 1 1 0 0
1 0 0 0 1 0 0 0 1 0 1 1 0 0 0 0 0 0 0
0 0 1 1 0
1 0 1 0 1 1 0 1 1 0 0 0 0 0 0 0 0 0 0
0 0 0 1 1
1 0 0 0 1 0 0 1 1 1 0 0 1 0 0 0 0 0 0
0 0 0 0 1
```

D is an integer from 1 to 12, and E is an integer from 1 to 24.

The second base matrix is a base matrix corresponding to a check matrix with a code length n = 648 bits and a code rate R = 1/2 in the 802.11n LDPC.

It should be noted that first base matrices obtained by performing various row and column permutations on the first base matrix (or the second base matrix) provided in this application are equivalent to the first base matrix provided in this application. That is, the first base matrices obtained by performing the row and column permutations on the first base matrix provided in this application also belong to the base matrices protected in this application. The various row and column permutations of the first base matrix mean that one or more elements in the first base matrix are replaced by one or more other elements. That is, the first base matrix with one or more elements being replaced by one or more other elements is equivalent to the first base matrix. In other words, the first base matrix with one or more elements being replaced by one or more other elements may still be considered as the first base matrix. In this application, the row and column permutation of the first base matrix may include any one of the following: One or more elements in a row of the first base matrix are replaced by one or more other elements, one or more elements in a column of the first base matrix are replaced by one or more other elements, a plurality of elements in different rows of the first base matrix are replaced by other elements, a plurality of elements in different columns of the first base matrix are replaced by other elements, positions of a plurality of rows of the first base matrix are changed, and positions of a plurality of columns of the first base matrix are changed. For example, positions of two columns of the first base matrix are interchanged. One element being replaced by another element may be understood as the element being replaced by any element different from the element. For example, one or more elements 0 in the base matrix are replaced by an element 1. For another example, one or more elements 1 in the first base matrix are replaced by an element 0.

The first base matrix is a ($12 \times 22$) two-dimensional matrix, that is, a matrix with 12 rows and 22 columns. Herein, the specific parameter selection of the 12 rows and 22 columns is a tradeoff between implementation complexity and decoding performance of the base matrix. Generally, a smaller base matrix indicates lower implementation complexity, but a degree of freedom in designing the base matrix is also affected.

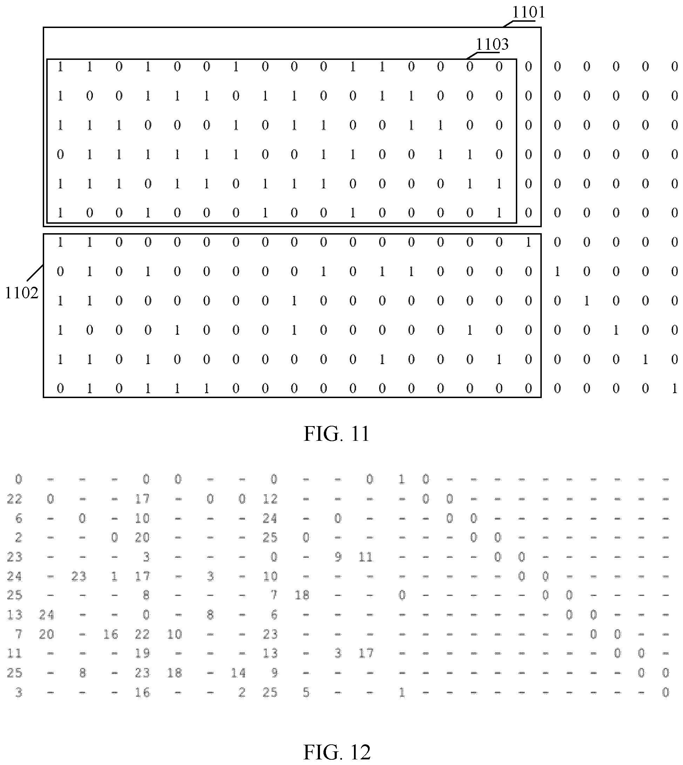

FIG. 11 shows an example of a first base matrix according to this application. In a possible implementation, as shown in FIG. 11, a matrix in a rectangular box 1101 is a core matrix, that is, $H_{MC}$, of the first base matrix; a matrix in a rectangular box 1102 is an expanded matrix, that is, $H_{IR}$, of the first base matrix; and a matrix in a rectangular box 1103 is a submatrix of the first base matrix, and the lower right corner of the first base matrix is an identity matrix. This application further protects a local matrix (namely, a submatrix) of the first base matrix provided in this application, for example, the matrix in the rectangular box 1101, the matrix in the rectangular box 1102, or the matrix in the rectangular box 1103. That is, the first base matrix may be a rate-compatible base matrix. If an incremental redundancy bit corresponding to a lower code rate is to be obtained by performing rate compatibility on the first base matrix, the matrix $H_{MC}$ may be expanded a required quantity of columns based on the required code rate.

In a possible implementation, the first two columns of the first base matrix are (state) punctured columns, that is, the first two columns participate in encoding but are not actually transmitted. Herein, puncturing is a common operation in channel encoding in which a corresponding bit is not transmitted after encoding. Details are not described herein. For example, the check matrix 1 is a check matrix obtained by expanding the first base matrix, the first two columns of the first base matrix correspond to the first 68 columns of the check matrix, and the first 68 columns of the check matrix 1 participate in encoding, but the first 68 columns of a code word obtained through encoding are not transmitted. The first two columns of the first base matrix are directly punctured and do not participate in transmission. This is because the two columns have heavy weights and can have information quickly transmitted and exchanged, and decoded and updated between code word bits corresponding to columns of the matrix, thereby accelerating an overall decoding convergence speed of a system. However, because the column weights of the two columns are heavy, if they participate in transmission and an error occurs in their respective bits, the error is quickly propagated to the other code word bits. This adversely affects decoding. Therefore, the two columns participate in actual encoding, but the corresponding bits are punctured without being transmitted. In addition, the two columns are combined with the seventh row (having only one 1 except the corresponding positions of the two punctured columns) and the seventeenth column (having only one 1) of the first base matrix, so that decoding performance can be greatly improved. The specific design principle for which the first two columns of the base matrix are punctured columns as follows: A heavier weight of a punctured column indicates better performance of the punctured column in a long code. However, for a short code, if the column weight is too heavy, a subgraph structure that causes a loss of decoding performance, such as a short ring or a trap set, may appear in a corresponding factor graph. The first two columns control the weight and the sparseness by using the design shown in the matrix, and a tradeoff is made between the performance of the short code and the performance of the long code.

In a possible implementation, columns corresponding to information bits in the first base matrix are the first 10 columns, and the subsequent columns are all columns corresponding to check bits. Therefore, a minimum code rate of the first base matrix is R = 10/(22 - 2) = 1/2. In the case of a code rate R = 2/3, a corresponding check matrix is the upper left corner part of the entire first base matrix, that is, the part in the rectangular box 1101: R = 10/(17 - 2) = 2/3. In addition to the foregoing two code rates, the first base matrix may also work at another code rate, which specifically depends on the number of rows and columns of the first base matrix during encoding. For example, if the first nine rows and the first 19 columns of the first base matrix are used, a code rate R = 10/(17 - 2 + 2) = 10/17 may be obtained.

In a possible implementation, during specific encoding, the transmit end may first divide the information bit sequence into sub-information sequences of size (10×Z), where a part that is less than (10×Z) may be padded with 0s at any position in the sub-information sequence. Generally, 0s are padded at the tail of the sub-information sequence (that is, a shortening operation in conventional channel encoding). Then, regardless of a code rate required by the transmit end, encoding is first performed by using a part that is of an expanded base matrix (that is, the check matrix) and that corresponds to the rectangular box 1103, and an encoding method is similar to an LDPC encoding method in 802.11n. Subsequently, the remaining check bit sequence may continue to be encoded based on a required code rate or the number of transmitted bits and based on an encoded code word sequence by using the remaining part of the expanded base matrix. The remaining check bit sequence may be encoded through a recursive operation, and a specific method is similar to an existing 5G NR LDPC encoding method. Finally, information bits corresponding to the first two columns of the base matrix are punctured without being transmitted, and then 0-padded bits during encoding are removed, and finally a code word bit sequence required for system transmission is obtained. A part of the specific encoding process is shown in FIG. 4. The information bits corresponding to the first two columns of the base matrix are obtained by encoding an expanded part of the first two columns of the base matrix.

The first base matrix provided in this application may be expanded into a check matrix used for encoding to obtain code words of different code lengths as required. As described above, 1s in the first base matrix are replaced by CPMs of various circular shift values, and 0s are all-0 square matrices of the corresponding size. Therefore, a series of check matrices of the LDPC code may be obtained based on the first base matrix. Expansion factors corresponding to these check matrices may be different from circular shift values of each CPM, but correspond to a same base matrix.

Examples of the first check matrix are classified into four types based on an expansion factor corresponding to the first check matrix. The first type corresponds to an expansion factor 68, the second type corresponds to an expansion factor 102, the third type corresponds to an expansion factor 54, and the fourth type corresponds to an expansion factor 81. These cases are separately described below.

The following describes an example in which the expansion factor corresponding to the first check matrix is 68.

In a possible implementation, the check matrix set includes a first check matrix and a second check matrix, a first expansion factor corresponding to the first check matrix is 68, an expansion factor corresponding to the second check matrix is 34, the first check matrix is any one of the following matrix 1 to matrix 5, and the second check matrix is a matrix 6 shown in the following.

```
Matrix 1:
 19 64 -1 42 -1 -1 61 -1 -1 -1  1  0 -1 -1 -1 -1 -1 -1 -
 1 -1 -1 -1
 58 -1 -1 27 37 32 -1 32 49 -1 -1  0  0 -1 -1 -1 -1 -1 -
 1 -1 -1 -1
 47  0 11 -1 -1 -1  3 -1  8 13 -1 -1  0  0 -1 -1 -1 -1 -1
 -1 -1 -1
 -1 55  7 24  4  7 54 -1 -1 28  0 -1 -1  0  0 -1 -1 -1 -
 1 -1 -1 -1
 29 38 53 -1 40 16 -1 30 15 67 -1 -1 -1  0  0 -1 -1 -
 1 -1 -1 -1
  7 -1 -1  0 -1 -1 -1 52 -1 -1  1 -1 -1 -1 -1  0 -1 -1 -1
 -1 -1 -1
 39 12 -1 -1 -1 -1 -1 -1 -1 -1 -1 -1 -1 -1 -1 -1  0 -1 -
 1 -1 -1 -1
 -1 61 -1 11 -1 -1 -1 -1 -1 24 -1 51 44 -1 -1 -1 -1  0 -1
 -1 -1 -1
  0 16 -1 -1 -1 -1 -1 -1  5 -1 -1 -1 -1 -1 -1 -1 -1 -1  0
 -1 -1 -1
 24 -1 -1 -1 36 -1 -1 -1 61 -1 -1 -1 -1 -1 56 -1 -1 -1 -
 1  0 -1 -1
 58 24 -1 50 -1 -1 -1 -1 -1 -1 -1 26 -1 -1 -1 10 -1 -1 -
 1 -1  0 -1
 -1  4 -1 60 61 48 -1 -1 -1 -1 -1 -1 -1 -1 -1 -1 -1 -1 -
 1 -1 -1  0
```

Matrix 2:
```
53 64 -1 42 -1 -1 61 -1 -1 -1 1 0 -1 -1 -1 -1 -1 -1 -
1 -1 -1 -1
24 -1 -1 61 37 66 -1 32 49 -1 -1 0 0 -1 -1 -1 -1 -1 -
1 -1 -1 -1
47 0 45 -1 -1 -1 37 -1 8 13 -1 -1 0 0 -1 -1 -1 -1 -
1 -1 -1 -1
-1 55 41 24 38 7 54 -1 -1 62 0 -1 -1 0 0 -1 -1 -1 -
1 -1 -1 -1
63 38 19 -1 40 16 -1 64 15 67 -1 -1 -1 -1 0 0 -1 -1 -
1 -1 -1 -1
41 -1 -1 0 -1 -1 -1 52 -1 -1 1 -1 -1 -1 -1 0 -1 -1 -
1 -1 -1 -1
5 46 -1 -1 -1 -1 -1 -1 -1 -1 -1 -1 -1 -1 -1 -1 0 -1 -1
-1 -1 -1
-1 61 -1 45 -1 -1 -1 -1 -1 58 -1 51 44 -1 -1 -1 -1 0 -
1 -1 -1 -1
0 16 -1 -1 -1 -1 -1 -1 5 -1 -1 -1 -1 -1 -1 -1 -1 -1 0
-1 -1 -1
58 -1 -1 -1 36 -1 -1 -1 27 -1 -1 -1 -1 -1 56 -1 -1 -1 -
1 0 -1 -1
24 58 -1 50 -1 -1 -1 -1 -1 -1 -1 60 -1 -1 -1 10 -1 -1 -
1 -1 0 -1
-1 38 -1 60 61 14 -1 -1 -1 -1 -1 -1 -1 -1 -1 -1 -1 -1 -
1 -1 -1 0
```

Matrix 3:
```
19 64 -1 42 -1 -1 27 -1 -1 -1 1 0 -1 -1 -1 -1 -1 -1 -
1 -1 -1 -1
58 -1 -1 27 3 66 -1 66 15 -1 -1 0 0 -1 -1 -1 -1 -1 -
1 -1 -1 -1
13 0 45 -1 -1 -1 37 -1 42 13 -1 -1 0 0 -1 -1 -1 -1 -
1 -1 -1 -1
-1 55 7 24 38 41 20 -1 -1 28 0 -1 -1 0 0 -1 -1 -1 -
1 -1 -1 -1
29 38 53 -1 40 50 -1 64 49 33 -1 -1 -1 -1 0 0 -1 -1 -
1 -1 -1 -1
41 -1 -1 0 -1 -1 -1 52 -1 -1 1 -1 -1 -1 -1 0 -1 -1 -
1 -1 -1 -1
39 46 -1 -1 -1 -1 -1 -1 -1 -1 -1 -1 -1 -1 -1 0 -1 -
1 -1 -1 -1
-1 61 -1 45 -1 -1 -1 -1 -1 24 -1 17 44 -1 -1 -1 -1 0 -
1 -1 -1 -1
0 16 -1 -1 -1 -1 -1 -1 39 -1 -1 -1 -1 -1 -1 -1 -1 -1 0
-1 -1 -1
24 -1 -1 -1 2 -1 -1 -1 27 -1 -1 -1 -1 -1 56 -1 -1 -1 -
1 0 -1 -1
24 58 -1 16 -1 -1 -1 -1 -1 -1 -1 26 -1 -1 -1 44 -1 -1 -
1 -1 0 -1
-1 38 -1 60 61 48 -1 -1 -1 -1 -1 -1 -1 -1 -1 -1 -1 -1 -
1 -1 -1 0
```

Matrix 4:
```
53 30 -1 42 -1 -1 27 -1 -1 -1 1 0 -1 -1 -1 -1 -1 -1 -
1 -1 -1 -1
58 -1 -1 27 3 32 -1 66 49 -1 -1 0 0 -1 -1 -1 -1 -1 -
1 -1 -1 -1
47 0 45 -1 -1 -1 3 -1 8 47 -1 -1 0 0 -1 -1 -1 -1 -
1 -1 -1 -1
-1 21 41 24 38 7 54 -1 -1 28 0 -1 -1 0 0 -1 -1 -1 -
1 -1 -1 -1
63 38 19 -1 6 50 -1 64 15 67 -1 -1 -1 -1 0 0 -1 -1 -
1 -1 -1 -1
7 -1 -1 0 -1 -1 -1 52 -1 -1 1 -1 -1 -1 -1 0 -1 -1 -1
-1 -1 -1
5 12 -1 -1 -1 -1 -1 -1 -1 -1 -1 -1 -1 -1 -1 -1 0 -1 -1
-1 -1 -1
-1 61 -1 45 -1 -1 -1 -1 -1 24 -1 17 44 -1 -1 -1 -1 0 -
1 -1 -1 -1
0 16 -1 -1 -1 -1 -1 -1 5 -1 -1 -1 -1 -1 -1 -1 -1 -1 0
-1 -1 -1
24 -1 -1 -1 2 -1 -1 -1 61 -1 -1 -1 -1 -1 56 -1 -1 -1 -
1 0 -1 -1
24 24 -1 50 -1 -1 -1 -1 -1 -1 -1 60 -1 -1 -1 10 -1 -1 -
1 -1 0 -1
```

```
-1 38 -1 60 61 14 -1 -1 -1 -1 -1 -1 -1 -1 -1 -1 -1 -
1 -1 -1 0


Matrix 5:
19 64 -1 8 -1 -1 61 -1 -1 -1 1 0 -1 -1 -1 -1 -1 -1 -
1 -1 -1 -1
58 -1 -1 61 37 32 -1 32 15 -1 -1 0 0 -1 -1 -1 -1 -1 -
1 -1 -1 -1
47 0 45 -1 -1 -1 3 -1 8 47 -1 -1 0 0 -1 -1 -1 -1 -
1 -1 -1 -1
-1 21 7 58 38 7 54 -1 -1 28 0 -1 -1 0 0 -1 -1 -1 -
1 -1 -1 -1
29 4 53 -1 40 50 -1 30 49 33 -1 -1 -1 -1 0 0 -1 -1 -
1 -1 -1 -1
7 -1 -1 0 -1 -1 -1 18 -1 -1 1 -1 -1 -1 -1 0 -1 -1 -1
-1 -1 -1
39 46 -1 -1 -1 -1 -1 -1 -1 -1 -1 -1 -1 -1 -1 -1 0 -1 -
1 -1 -1 -1
-1 27 -1 11 -1 -1 -1 -1 -1 58 -1 51 44 -1 -1 -1 -1 0 -1
-1 -1 -1
0 50 -1 -1 -1 -1 -1 -1 5 -1 -1 -1 -1 -1 -1 -1 -1 -1 0
-1 -1 -1
24 -1 -1 -1 36 -1 -1 -1 61 -1 -1 -1 -1 -1 22 -1 -1 -1 -
1 0 -1 -1
24 24 -1 16 -1 -1 -1 -1 -1 -1 -1 60 -1 -1 -1 44 -1 -1 -
1 -1 0 -1
-1 38 -1 26 27 48 -1 -1 -1 -1 -1 -1 -1 -1 -1 -1 -1 -1 -
1 -1 -1 0


Matrix 6:
19 30 -1 8 -1 -1 27 -1 -1 -1 1 0 -1 -1 -1 -1 -1 -1 -
1 -1 -1 -1
24 -1 -1 27 3 32 -1 32 15 -1 -1 0 0 -1 -1 -1 -1 -1 -
1 -1 -1 -1
13 0 11 -1 -1 -1 3 -1 8 13 -1 -1 0 0 -1 -1 -1 -1 -1
-1 -1 -1
-1 21 7 24 4 7 20 -1 -1 28 0 -1 -1 0 0 -1 -1 -1 -
1 -1 -1 -1
29 4 19 -1 6 16 -1 30 15 33 -1 -1 -1 -1 0 0 -1 -1 -
1 -1 -1 -1
7 -1 -1 0 -1 -1 -1 18 -1 -1 1 -1 -1 -1 -1 0 -1 -1 -1
-1 -1 -1
5 12 -1 -1 -1 -1 -1 -1 -1 -1 -1 -1 -1 -1 -1 0 -1 -1
-1 -1 -1
-1 27 -1 11 -1 -1 -1 -1 -1 24 -1 17 10 -1 -1 -1 -1 0 -1
-1 -1 -1
0 16 -1 -1 -1 -1 -1 -1 5 -1 -1 -1 -1 -1 -1 -1 -1 -1 0
-1 -1 -1
24 -1 -1 -1 2 -1 -1 -1 27 -1 -1 -1 -1 -1 22 -1 -1 -1 -
1 0 -1 -1
24 24 -1 16 -1 -1 -1 -1 -1 -1 -1 26 -1 -1 -1 10 -1 -1 -
1 -1 0 -1
-1 4 -1 26 27 14 -1 -1 -1 -1 -1 -1 -1 -1 -1 -1 -1 -1 -
1 -1 -1 0
```

When -1 in the matrix 1 represents a (68×68) all-zero matrix, 0 represents an identity matrix of size (68×68), and an element greater than 0 represents a CPM of a circular shift value being the element and of size (68×68), the matrix 1 is an example of the first check matrix. Similarly, the matrix 2, the matrix 3, the matrix 4, and the matrix 5 are all examples of the first check matrix. When -1 in the matrix 6 represents a (34×34) all-zero matrix, 0 represents an identity matrix of size (34×34), and an element greater than 0 represents a CPM of a circular shift value being the element and of size (34×34), the matrix 6 is an example of the second check matrix. When the matrix 1 to the matrix 5 each represent a (12×22) two-dimensional matrix, elements of each of the matrix 1 to the matrix 5 are examples of the first set of circular shift values. When the matrix 6 represents a (12×22) two-dimensional matrix, elements in the matrix 6 are examples of the second set of circular shift values.

The following describes an example in which the expansion factor corresponding to the first check matrix is 102.

In a possible implementation, the check matrix set includes a first check matrix, a second check matrix, and a third check matrix, a first expansion factor corresponding to the first check matrix is 102, a second expansion factor corresponding to the second check matrix is 68, an expansion factor corresponding to the third check matrix is 34, the first check matrix is the following matrix 21 or matrix 22, the second check matrix is the foregoing matrix 1, and the third check matrix is the foregoing matrix 6.

```
Matrix 21:
87 64 -1 42 -1 -1 61 -1 -1 -1 1 0 -1 -1 -1 -1 -1 -1 -
1 -1 -1 -1
58 -1 -1 27 37 100 -1 32 49 -1 -1 0 0 -1 -1 -1 -1 -1 -1
-1 -1 -1
47 0 11 -1 -1 -1 71 -1 8 13 -1 -1 0 0 -1 -1 -1 -1 -1
-1 -1 -1
-1 55 7 24 4 75 54 -1 -1 28 0 -1 -1 0 0 -1 -1 -1 -
1 -1 -1 -1
97 38 53 -1 40 84 -1 30 83 67 -1 -1 -1 -1 0 0 -1 -1 -
1 -1 -1 -1
7 -1 -1 0 -1 -1 -1 52 -1 -1 1 -1 -1 -1 -1 0 -1 -1 -1
-1 -1 -1
39 80 -1 -1 -1 -1 -1 -1 -1 -1 -1 -1 -1 -1 -1 -1 0 -1 -
1 -1 -1 -1
-1 61 -1 79 -1 -1 -1 -1 -1 24 -1 51 44 -1 -1 -1 -1 0 -
1 -1 -1 -1
0 16 -1 -1 -1 -1 -1 -1 73 -1 -1 -1 -1 -1 -1 -1 -1 -1 0
-1 -1 -1
92 -1 -1 -1 36 -1 -1 -1 61 -1 -1 -1 -1 -1 56 -1 -1 -1 -
1 0 -1 -1
58 24 -1 50 -1 -1 -1 -1 -1 -1 26 -1 -1 -1 10 -1 -1 -
1 -1 0 -1
-1 4 -1 60 61 48 -1 -1 -1 -1 -1 -1 -1 -1 -1 -1 -1 -
1 -1 -1 0


Matrix 22:
19 64 -1 42 -1 -1 61 -1 -1 -1 1 0 -1 -1 -1 -1 -1 -1 -
1 -1 -1 -1
58 -1 -1 27 37 100 -1 32 49 -1 -1 0 0 -1 -1 -1 -1 -1 -1
-1 -1 -1
47 0 11 -1 -1 -1 71 -1 8 13 -1 -1 0 0 -1 -1 -1 -1 -1
-1 -1 -1
-1 55 7 24 72 75 54 -1 -1 28 0 -1 -1 0 0 -1 -1 -1 -
1 -1 -1 -1
97 38 53 -1 40 84 -1 30 83 67 -1 -1 -1 -1 0 0 -1 -1 -
1 -1 -1 -1
75 -1 -1 0 -1 -1 -1 52 -1 -1 1 -1 -1 -1 -1 0 -1 -1 -
1 -1 -1 -1
39 12 -1 -1 -1 -1 -1 -1 -1 -1 -1 -1 -1 -1 -1 -1 0 -1 -
1 -1 -1 -1
-1 61 -1 79 -1 -1 -1 -1 -1 24 -1 51 44 -1 -1 -1 -1 0 -
1 -1 -1 -1
0 16 -1 -1 -1 -1 -1 -1 73 -1 -1 -1 -1 -1 -1 -1 -1 -1 0
-1 -1 -1
24 -1 -1 -1 36 -1 -1 -1 61 -1 -1 -1 -1 -1 56 -1 -1 -1 -
1 0 -1 -1
58 92 -1 50 -1 -1 -1 -1 -1 -1 26 -1 -1 -1 78 -1 -1 -
1 -1 0 -1
-1 72 -1 60 61 48 -1 -1 -1 -1 -1 -1 -1 -1 -1 -1 -1 -
1 -1 -1 0
```

In a possible implementation, the check matrix set includes a first check matrix, a second check matrix, and a third check matrix, a first expansion factor corresponding to the first check matrix is 102, a second expansion factor corresponding to the second check matrix is 68, an expansion factor corresponding to the third check matrix is 34, the first check matrix is the following matrix 23, the second check matrix is the foregoing matrix 2, and the third check matrix is the foregoing matrix 6.

```
Matrix 23:
53 64 -1 42 -1 -1 61 -1 -1 -1 1 0 -1 -1 -1 -1 -1 -1 -
1 -1 -1 -1
92 -1 -1 61 37 66 -1 100 49 -1 -1 0 0 -1 -1 -1 -1 -1 -1
-1 -1 -1
47 0 45 -1 -1 -1 37 -1 76 81 -1 -1 0 0 -1 -1 -1 -1 -
1 -1 -1 -1
-1 55 41 92 38 75 54 -1 -1 62 0 -1 -1 0 0 -1 -1 -1 -
1 -1 -1 -1
63 38 87 -1 40 16 -1 64 83 67 -1 -1 -1 -1 0 0 -1 -1 -
1 -1 -1 -1
41 -1 -1 0 -1 -1 -1 52 -1 -1 1 -1 -1 -1 -1 0 -1 -1 -
1 -1 -1 -1
73 46 -1 -1 -1 -1 -1 -1 -1 -1 -1 -1 -1 -1 -1 -1 0 -1 -
1 -1 -1 -1
```

```
-1 61 -1 45 -1 -1 -1 -1 -1 58 -1 51 44 -1 -1 -1 -1 0 -
1 -1 -1 -1
0 16 -1 -1 -1 -1 -1 -1 73 -1 -1 -1 -1 -1 -1 -1 -1 -1 0
-1 -1 -1
58 -1 -1 -1 36 -1 -1 -1 95 -1 -1 -1 -1 -1 56 -1 -1 -1 -
1 0 -1 -1
24 58 -1 50 -1 -1 -1 -1 -1 -1 -1 60 -1 -1 -1 78 -1 -1 -
1 -1 0 -1
-1 38 -1 60 61 14 -1 -1 -1 -1 -1 -1 -1 -1 -1 -1 -1 -1 -
1 -1 -1 0
```

In a possible implementation, the check matrix set includes a first check matrix, a second check matrix, and a third check matrix, a first expansion factor corresponding to the first check matrix is 102, a second expansion factor corresponding to the second check matrix is 68, an expansion factor corresponding to the third check matrix is 34, the first check matrix is the following matrix 24, the second check matrix is the foregoing matrix 3, and the third check matrix is the foregoing matrix 6.

```
Matrix 24:
87 64 -1 42 -1 -1 27 -1 -1 -1 1 0 -1 -1 -1 -1 -1 -1 -
1 -1 -1 -1
58 -1 -1 27 3 66 -1 66 83 -1 -1 0 0 -1 -1 -1 -1 -1 -
1 -1 -1 -1
13 0 45 -1 -1 -1 37 -1 42 81 -1 -1 0 0 -1 -1 -1 -1 -
1 -1 -1 -1
-1 55 75 92 38 41 20 -1 -1 28 0 -1 -1 0 0 -1 -1 -1 -
1 -1 -1 -1
97 38 53 -1 40 50 -1 64 49 33 -1 -1 -1 0 0 -1 -1 -
1 -1 -1 -1
41 -1 -1 0 -1 -1 -1 52 -1 -1 1 -1 -1 -1 -1 0 -1 -1 -
1 -1 -1 -1
39 46 -1 -1 -1 -1 -1 -1 -1 -1 -1 -1 -1 -1 -1 -1 0 -1 -
1 -1 -1 -1
-1 61 -1 45 -1 -1 -1 -1 -1 24 -1 85 44 -1 -1 -1 -1 0 -
1 -1 -1 -1
0 16 -1 -1 -1 -1 -1 -1 39 -1 -1 -1 -1 -1 -1 -1 -1 -1 0
-1 -1 -1
92 -1 -1 -1 70 -1 -1 -1 27 -1 -1 -1 -1 -1 56 -1 -1 -1 -
1 0 -1 -1
92 58 -1 16 -1 -1 -1 -1 -1 -1 -1 26 -1 -1 -1 44 -1 -1 -
1 -1 0 -1
-1 38 -1 60 61 48 -1 -1 -1 -1 -1 -1 -1 -1 -1 -1 -1 -1 -
1 -1 -1 0
```

In a possible implementation, the check matrix set includes a first check matrix, a second check matrix, and a third check matrix, a first expansion factor corresponding to the first check matrix is 102, a second expansion factor corresponding to the second check matrix is 68, an expansion factor corresponding to the third check matrix is 34, the first check matrix is the following matrix 25, the second check matrix is the foregoing matrix 4, and the third check matrix is the foregoing matrix 6.

```
Matrix 25:
53 30 -1 42 -1 -1 27 -1 -1 -1 1 0 -1 -1 -1 -1 -1 -1 -
1 -1 -1 -1
58 -1 -1 27 71 100 -1 66 49 -1 -1 0 0 -1 -1 -1 -1 -1
-1 -1 -1
47 0 45 -1 -1 -1 71 -1 76 47 -1 -1 0 0 -1 -1 -1 -
1 -1 -1 -1
-1 21 41 24 38 75 54 -1 -1 28 0 -1 -1 0 0 -1 -1 -1 -
1 -1 -1 -1
63 38 19 -1 6 50 -1 64 83 67 -1 -1 -1 0 0 -1 -1 -
1 -1 -1 -1
7 -1 -1 0 -1 -1 -1 52 -1 -1 1 -1 -1 -1 -1 0 -1 -1 -1
-1 -1 -1
73 80 -1 -1 -1 -1 -1 -1 -1 -1 -1 -1 -1 -1 -1 -1 0 -1 -
1 -1 -1 -1
-1 61 -1 45 -1 -1 -1 -1 -1 24 -1 17 44 -1 -1 -1 -1 0 -
1 -1 -1 -1
0 16 -1 -1 -1 -1 -1 -1 5 -1 -1 -1 -1 -1 -1 -1 -1 -1 0
-1 -1 -1
24 -1 -1 -1 70 -1 -1 -1 61 -1 -1 -1 -1 -1 56 -1 -1 -1 -
1 0 -1 -1
24 24 -1 50 -1 -1 -1 -1 -1 -1 -1 60 -1 -1 -1 78 -1 -1 -
```

```
1 -1 0 -1
-1 38 -1 60 61 82 -1 -1 -1 -1 -1 -1 -1 -1 -1 -1 -1 -
1 -1 -1 0
```

In a possible implementation, the check matrix set includes a first check matrix, a second check matrix, and a third check matrix, a first expansion factor corresponding to the first check matrix is 102, a second expansion factor corresponding to the second check matrix is 68, an expansion factor corresponding to the third check matrix is 34, the first check matrix is the following matrix 26, the second check matrix is the foregoing matrix 5, and the third check matrix is the foregoing matrix 6.

```
Matrix 26:
 87 64 -1 8 -1 -1 61 -1 -1 -1 1 0 -1 -1 -1 -1 -1 -1 -
1 -1 -1 -1
58 -1 -1 61 37 32 -1 100 83 -1 -1 0 0 -1 -1 -1 -1 -1 -1
-1 -1 -1
47 0 45 -1 -1 -1 71 -1 8 47 -1 -1 0 0 -1 -1 -1 -1 -
1 -1 -1 -1
-1 21 75 58 38 75 54 -1 -1 28 0 -1 -1 0 0 -1 -1 -1 -
1 -1 -1 -1
29 4 53 -1 40 50 -1 30 49 101 -1 -1 -1 -1 0 0 -1 -1 -1
-1 -1 -1
7 -1 -1 0 -1 -1 -1 18 -1 -1 1 -1 -1 -1 -1 0 -1 -1 -1
-1 -1 -1
39 46 -1 -1 -1 -1 -1 -1 -1 -1 -1 -1 -1 -1 -1 -1 0 -1 -
1 -1 -1 -1
-1 27 -1 79 -1 -1 -1 -1 -1 58 -1 51 44 -1 -1 -1 -1 0 -
1 -1 -1 -1
0 50 -1 -1 -1 -1 -1 -1 73 -1 -1 -1 -1 -1 -1 -1 -1 -1 0
-1 -1 -1
92 -1 -1 -1 36 -1 -1 -1 61 -1 -1 -1 -1 -1 22 -1 -1 -1 -
1 0 -1 -1
24 24 -1 16 -1 -1 -1 -1 -1 -1 -1 60 -1 -1 -1 44 -1 -1 -
1 -1 0 -1
-1 38 -1 26 95 48 -1 -1 -1 -1 -1 -1 -1 -1 -1 -1 -1 -1 -
1 -1 -1 0
```

When -1 in the matrix 21 represents a (68×68) all-zero matrix, 0 represents an identity matrix of size (68×68), and an element greater than 0 represents a CPM of a circular shift value being the element and of size (68×68), the matrix 21 is an example of the first check matrix. Similarly, the matrix 22, the matrix 23, the matrix 24, the matrix 25, and the matrix 26 are all examples of the first check matrix. When the matrix 21 to the matrix 26 each represent a (12×22) two-dimensional matrix, elements of each of the matrix 21 to the matrix 26 are examples of the first set of circular shift values.

The following describes an example in which the expansion factor corresponding to the first check matrix is 54.

In a possible implementation, the check matrix set includes a first check matrix and a second check matrix, a first expansion factor corresponding to the first check matrix is 54, a second expansion factor corresponding to the second check matrix is 27, the first check matrix is the following matrix 31, and the second check matrix is a (12×24) two-dimensional matrix shown in FIG. 12. FIG. 12 shows an example of a check matrix.

```
Matrix 31:
 0 -1 -1 -1 0 0 -1 -1 0 -1 -1 0 1 0 -1 -1 -1 -1 -1
-1 -1 -1 -1 -1
49 0 -1 -1 44 -1 0 0 39 -1 -1 -1 -1 0 0 -1 -1 -1 -
1 -1 -1 -1 -1 -1
6 -1 0 -1 37 -1 -1 -1 51 -1 0 -1 -1 -1 0 0 -1 -1 -1
-1 -1 -1 -1 -1
2 -1 -1 0 47 -1 -1 -1 52 0 -1 -1 -1 -1 0 0 -1 -1
-1 -1 -1 -1 -1
23 -1 -1 -1 30 -1 -1 -1 0 -1 36 11 -1 -1 -1 -1 0 0 -1
-1 -1 -1 -1
51 -1 23 28 17 -1 30 -1 37 -1 -1 -1 -1 -1 -1 -1 -1 0
0 -1 -1 -1 -1 -1
52 -1 -1 -1 35 -1 -1 -1 7 45 -1 -1 0 -1 -1 -1 -1 -1
0 0 -1 -1 -1 -1
13 51 -1 -1 0 -1 8 -1 33 -1 -1 -1 -1 -1 -1 -1 -1 -
1 0 0 -1 -1 -1
7 20 -1 16 22 37 -1 -1 23 -1 -1 -1 -1 -1 -1 -1 -1 -1
-1 0 0 -1 -1
38 -1 -1 -1 19 -1 -1 -1 13 -1 3 17 -1 -1 -1 -1 -1 -
1 -1 -1 0 0 -1
25 -1 35 -1 23 45 -1 41 9 -1 -1 -1 -1 -1 -1 -1 -1 -1 -
```

```
1 -1 -1 -1 0 0
3 -1 -1 -1 16 -1 -1 2 25 32 -1 -1 1 -1 -1 -1 -1 -1 -1
-1 -1 -1 -1 0
```

The following describes an example in which the expansion factor corresponding to the first check matrix is 81.

In a possible implementation, the check matrix set includes a first check matrix, a second check matrix, and a third check matrix, a first expansion factor corresponding to the first check matrix is 81, a second expansion factor corresponding to the second check matrix is 54, a third expansion factor corresponding to the third check matrix is 27, the first check matrix is the following matrix 32, the second check matrix is the foregoing matrix 31, and the third check matrix is a (12×24) two-dimensional matrix shown in FIG. 12.

```
Matrix 32:
0 -1 -1 -1 0 0 -1 -1 0 -1 -1 0 1 0 -1 -1 -1 -1 -1
-1 -1 -1 -1 -1
49 0 -1 -1 44 -1 0 0 39 -1 -1 -1 -1 0 0 -1 -1 -1 -
1 -1 -1 -1 -1 -1
60 -1 0 -1 37 -1 -1 -1 51 -1 0 -1 -1 -1 0 0 -1 -1 -
1 -1 -1 -1 -1 -1
56 -1 -1 0 47 -1 -1 -1 52 0 -1 -1 -1 -1 0 0 -1 -
1 -1 -1 -1 -1 -1
77 -1 -1 -1 30 -1 -1 -1 0 -1 36 11 -1 -1 -1 -1 0 0 -1
-1 -1 -1 -1 -1
51 -1 77 28 17 -1 30 -1 37 -1 -1 -1 -1 -1 -1 -1 -1 0
0 -1 -1 -1 -1
52 -1 -1 -1 35 -1 -1 -1 7 45 -1 -1 0 -1 -1 -1 -1 -1
0 0 -1 -1 -1 -1
67 51 -1 -1 0 -1 8 -1 33 -1 -1 -1 -1 -1 -1 -1 -1 -1 -
1 0 0 -1 -1 -1
61 74 -1 70 22 37 -1 -1 23 -1 -1 -1 -1 -1 -1 -1 -1 -
1 -1 0 0 -1 -1
38 -1 -1 -1 73 -1 -1 -1 67 -1 57 71 -1 -1 -1 -1 -1 -1 -
1 -1 -1 0 0 -1
25 -1 35 -1 77 45 -1 41 9 -1 -1 -1 -1 -1 -1 -1 -1 -
1 -1 -1 -1 0 0
57 -1 -1 -1 16 -1 -1 56 25 32 -1 -1 1 -1 -1 -1 -1 -1 -
1 -1 -1 -1 -1 0
```

The matrix 1 to the matrix 5, the matrix 21 to the matrix 26, and the matrix 31 and the matrix 32 are merely some examples rather than all examples of the first check matrix provided in this application. The first check matrix provided in this application may include some rows or columns of any check matrix in the matrix 1 to the matrix 5, the matrix 21 to the matrix 26, and the matrix 31 and the matrix 32. That is, this application protects not only the entire first base matrix and check matrix that are provided, but also some rows and columns of the first base matrix and some rows and columns of the check matrix.

It should be noted that first check matrices obtained by performing various row and column permutations on the first check matrix provided in this application are equivalent to the first check matrix provided in this application. That is, the first check matrices obtained by performing the row and column permutations on the first check matrix provided in this application also belong to the base matrices protected in this application.

The following describes the design principle of the first check matrix.

In a possible implementation, the first set of circular shift values are a set of circular shift values obtained by expanding the second set of circular shift values. In other words, the first set of expanded shift values are obtained by expanding circular shift values in the second set of circular shift values for the first time. The second set of circular shift values may be any existing set of circular shift values. To meet a nesting relationship between the first set of circular shift values and the second set of circular shift values, a modulo operation relationship between the first set of circular shift values and the second set of circular shift values needs to be met, that is, $Z2(i,j) = Z1(i,j) \% Z2$. For example, a circular shift value $Z2(2,1)$ in the second set of circular shift values is 24. If a corresponding circular shift value $Z1(2,1)$ in the first set of circular shift values is 58, 58 % 34 = 24, and therefore $Z2(2,1)$ and $Z1(2,1)$ meet the modulo operation relationship. If the first set of circular shift values and the second set of circular shift values meet the modulo operation relationship, only the first set of circular shift values are required, and the second set of circular shift values can be calculated by performing a modulo operation on the first set of circular shift values and Z2. In this way, only one set of expansion factors may be stored to obtain two check matrices.

For the first expansion, to ensure the foregoing modulo operation relationship, there are two choices for a circular shift value of each non-negative 1 in the second set of circular shift values. If any one of the second set of circular shift values is $Z2(i,j) = s$, the first expansion of the entry may be $Z1(i,j) = s$ (unchanged) or $Z1(i,j) = s + Z2$. Z2 is the expansion factor corresponding to the second check matrix. That is, $Z2(i,j) = s$ in the second set of circular shift values is expanded into

35

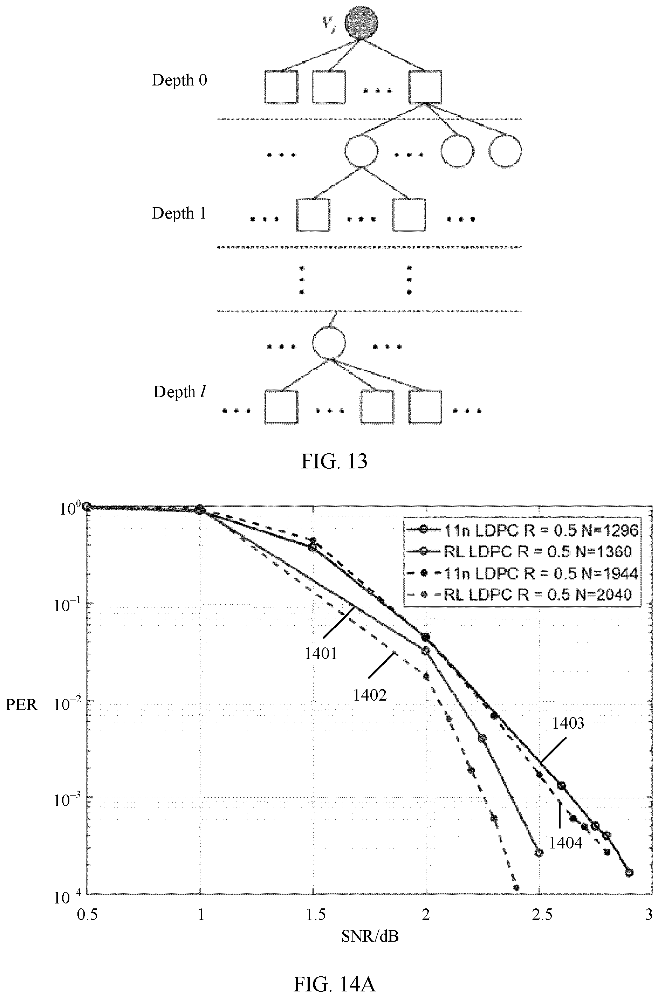

Z1(i,j) = s (unchanged) or Z1(i,j) = s + Z2. In a possible implementation, a to-be-selected node corresponding to Z1(i,j) is expanded according to a tree, and a circular shift value with a relatively deep depth may be selected. That is, the to-be-selected node corresponding to Z1(i,j) is used as a root node to expand the current Tanner graph into a tree graph. FIG. 13 is a diagram of tree expansion according to an embodiment of this application. As shown in FIG. 13, a circle mark represents a variable node, and a square mark represents a check node. A deeper depth of the tree expansion of the to-be-selected node indicates fewer short rings included in the corresponding matrix, while the short rings negatively affect performance.

In a possible implementation, the second set of circular shift values are a set of circular shift values obtained by expanding the third set of circular shift values, and the first set of circular shift values are a set of circular shift values obtained by expanding the second set of circular shift values. In other words, the second set of expanded shift values are obtained by expanding circular shift values in the third set of circular shift values for the first time, and the first set of expanded shift values are obtained by expanding circular shift values in the second set of circular shift values for the second time. The third set of circular shift values may be any existing set of circular shift values. To meet a nesting relationship between the first set of circular shift values, the second set of circular shift values, and the third set of circular shift values, a modulo operation relationship between the first set of circular shift values, the second set of circular shift values, and the third set of circular shift values needs to be met, that is, Z2(i,j) = Z1(i,j) % Z2, and Z3(i,j) = Z1(i,j) % Z3. For example, a circular shift value Z3(1,1) in the third set of circular shift values is 19. If a corresponding circular shift value Z1(1,1) in the first set of circular shift values is 87, 87 % 68 = 19, and therefore Z2(1, 1) and Z1(1,1) meet the modulo operation relationship. If the first set of circular shift values and the second set of circular shift values meet the modulo operation relationship, and the first set of circular shift values and the third set of circular shift values meet the modulo operation relationship, only the first set of circular shift values are required, the second set of circular shift values can be calculated by performing a modulo operation on the first set of circular shift values and Z2, and the third set of circular shift values can be calculated by performing a modulo operation on the first set of circular shift values and Z3. In this way, only one set of expansion factors may be stored to obtain three check matrices.

For the first expansion, to ensure the foregoing modulo operation relationship, there are two choices for a circular shift value of each non-negative 1 in the third set of circular shift values. If any one of the third set of circular shift values is Z3(i,j) = s, the first expansion of the entry may be Z2(i,j) = s (unchanged) or Z2(i,j) = s + Z3. Z3 is the expansion factor corresponding to the third check matrix. That is, Z3(i,j) = s in the third set of circular shift values is expanded into Z2(i,j) = s (unchanged) or Z2(i,j) = s + Z3. In a possible implementation, a to-be-selected node corresponding to Z2(i,j) is expanded according to a tree, and a circular shift value with a relatively deep depth may be selected.

For the second expansion, to ensure the foregoing modulo operation relationship, a circular shift value of each non-negative 1 in the second set of circular shift values may be selected based on two cases, that is, whether Z2(i,j) is less than Z3. If Z2(i,j) >= Z3, it is case A (Case A); otherwise, it is case B (Case B).

For case A, there is only one expansion manner, that is, the circular shift value (Z1(i,j) = Z2(i,j)) remains unchanged. In this way, it can be ensured that the modulo operation relationship is retained between Z1(i,j) and Z2(i,j) after the expansion.

For case B, there are two expansion manners. If Z2(i,j) = s, the entry may be expanded into Z1(i,j) = s (unchanged) or Z1(i,j) = s + Z2. In this way, it can be ensured that the modulo operation relationship is retained between the second expansion factor and the first expansion factor after the expansion. In a possible implementation, a to-be-selected node corresponding to Z1(i,j) is expanded according to a tree, and a circular shift value with a relatively deep depth may be selected.

The following describes performance of the coding scheme provided in this application with reference to the accompanying drawings.

FIG. 14A is a diagram of a packet error rate (packet error rate, PER) simulation performance comparison for LDPC codes according to an embodiment of this application. As shown in FIG. 14A, 1401 represents a PER of an LDPC code with a code length of 1460 bits that is obtained by encoding using the check matrix (namely, the foregoing matrix 2) provided in an embodiment of this application, 1402 represents a PER of an LDPC code with a code length of 2040 bits that is obtained by encoding using the check matrix (namely, the foregoing matrix 23) provided in an embodiment of this application, 1403 represents a PER of an existing LDPC code with a code length of 1296 bits, and 1404 represents a PER of an existing LDPC code with a code length of 1944 bits. All the codes in the simulation are not shortened or punctured, that is, code rates of all the codes are R = 1/2. It can be learned from the simulation result that the LDPC codes obtained by encoding using the check matrix designed in this application are all better than the existing LDPC codes of corresponding code lengths. Herein, only the PER of the LDPC code obtained by performing LDPC encoding based on the foregoing matrix 2 and the PER of the LDPC code obtained by performing LDPC encoding based on the foregoing matrix 23 are shown. An LDPC code obtained by performing LDPC encoding based on another check matrix provided in an embodiment of this application is also better than an existing LDPC code of a corresponding code length.

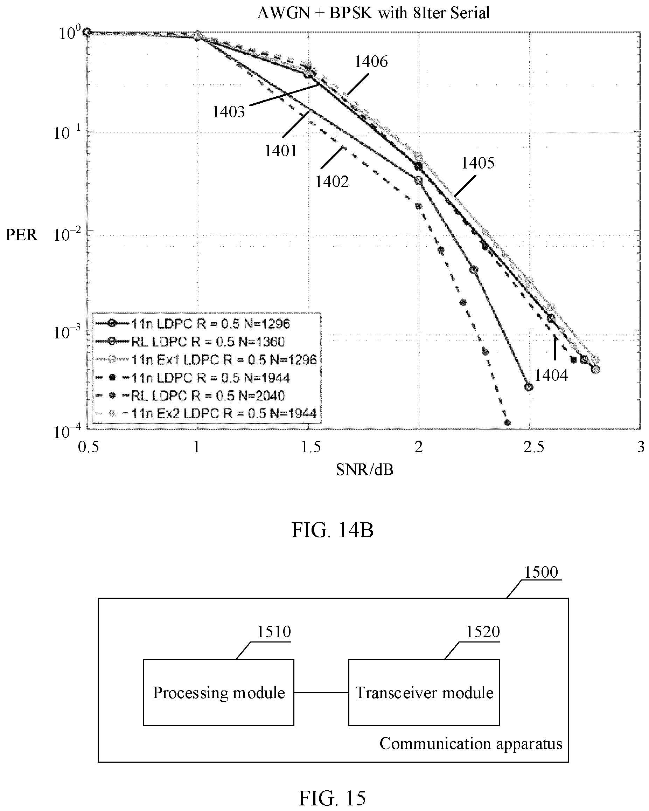

FIG. 14B is a diagram of another PER simulation performance comparison for LDPC codes according to an embodiment of this application. As shown in FIG. 14B, 1401 represents a PER of an LDPC code with a code length of 1360 bits that is obtained by encoding using the check matrix (namely, the foregoing matrix 2) provided in an embodiment of this application, 1402 represents a PER of an LDPC code with a code length of 2040 bits that is obtained by encoding using the check matrix (namely, the foregoing matrix 23) provided in an embodiment of this application, 1403 represents a PER of an existing LDPC code with a code length of 1296 bits, 1404 represents a PER of an existing LDPC code with a code length of 1944 bits, 1405 represents a PER of an LDPC code with a code length of 1296 bits that is obtained by encoding using the check matrix (namely, the foregoing matrix 31) provided in an embodiment of this application, and 1406 represents a PER of an LDPC code with a code length of 1944 bits that is obtained by encoding using the check matrix (namely, the foregoing matrix 32) provided in an embodiment of this application. All the codes in the simulation are not shortened or punctured, that is, code rates of all the codes are R = 1/2. It can be learned from the simulation result that an LDPC code obtained by performing LDPC encoding based on the check matrix provided in an embodiment of this application is almost consistent with a PER of an 11n LDPC code of a corresponding code length. However, the transmit end and the receive end only need to implement a short code with a 11n LDPC code length of 648 bits, and can simply implement a medium code length (1296 bits) and a long code (1944 bits) by using the short code.

The following describes, with reference to the accompanying drawings, structures of communication apparatuses that can implement the communication methods provided in embodiments of this application.

FIG. 15 is a diagram of a structure of a communication apparatus 1500 according to an embodiment of this application. The communication apparatus 1500 may correspondingly implement functions or steps implemented by the transmit end in the foregoing method embodiments, or may correspondingly implement functions or steps implemented by the receive end in the foregoing method embodiments. The communication apparatus may include a processing module 1510 and a transceiver module 1520. In a possible implementation, the apparatus may further include a storage unit. The storage unit may be configured to store instructions (code or a program) and/or data. The processing module 1510 and the transceiver module 1520 may be coupled to the storage unit. For example, the processing module 1510 may read the instructions (the code or the program) and/or the data in the storage unit, to implement a corresponding method. The foregoing units may be independently disposed, or may be partially or completely integrated. For example, the transceiver module 1520 may include a transmitting module and a receiving module. The transmitting module may be a transmitter, and the receiving module may be a receiver. An entity corresponding to the transceiver module 1520 may be a transceiver, or may be a communication interface.

In some possible implementations, the communication apparatus 1500 can correspondingly implement behavior and functions of the transmit end in the foregoing method embodiments. For example, the communication apparatus 1500 may be the transmit end, or may be a component (for example, a chip or a circuit) used in the transmit end. The transceiver module 1520 may be configured to perform, for example, all receiving or transmitting operations performed by the transmit end in the embodiments of FIG. 9, and FIG. 10A and FIG. 10B, for example, step 902 in the embodiment shown in FIG. 9, and step 1002, step 1007, and step 1012 in the embodiment shown in FIG. 10A and FIG. 10B, and/or is configured to support another process of the technology described herein. The processing module 1510 is configured to perform all operations except the receiving and transmitting operations performed by the transmit end in the embodiments shown in FIG. 9, and FIG. 10A and FIG. 10B, for example, step 901 in the embodiment shown in FIG. 9 and step 1001, step 1006, and step 1011 in the embodiment shown in FIG. 10A and FIG. 10B.

In some possible implementations, the communication apparatus 1500 can correspondingly implement behavior and functions of the receive end in the foregoing method embodiments. For example, the communication apparatus 1500 may be the receive end, or may be a component (for example, a chip or a circuit) used in the receive end. The transceiver module 1520 may be configured to perform, for example, all receiving or transmitting operations performed by the transmit end in the embodiments of FIG. 9, and FIG. 10A and FIG. 10B, for example, step 902 in the embodiment shown in FIG. 9, and step 1002, step 1007, and step 1012 in the embodiment shown in FIG. 10A and FIG. 10B, and/or is configured to support another process of the technology described herein. The processing module 1510 is configured to perform all operations except the receiving and transmitting operations performed by the receive end, for example, step 903, step 904, and step 905 in the embodiment shown in FIG. 9, and step 1003, step 1004, step 1005, step 1008, step 1009, step 1010, step 1013, step 1014, and step 1015 in the embodiment shown in FIG. 10A and FIG. 10B.

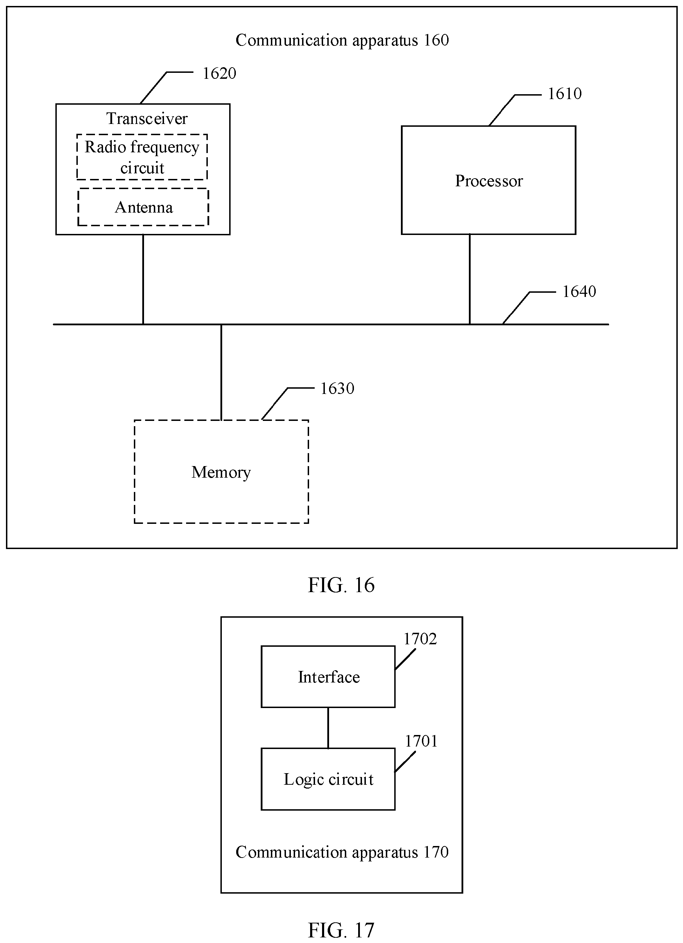

FIG. 16 is a diagram of a structure of another communication apparatus 160 according to an embodiment of this application. The communication apparatus in FIG. 16 may be the foregoing transmit end, or may be the foregoing receive end.

As shown in FIG. 16, the communication apparatus 160 includes at least one processor 1610 and a transceiver 1620.

In some embodiments of this application, the processor 1610 and the transceiver 1620 may be configured to perform functions, operations, or the like performed by the transmit end. The transceiver 1620 performs, for example, all receiving or transmitting operations performed by the transmit end in the embodiments of FIG. 9, and FIG. 10A and FIG. 10B. The processor 1610 is configured to perform, for example, all operations except the receiving and transmitting operations performed by the transmit end in the embodiments of FIG. 9, and FIG. 10A and FIG. 10B.

In some embodiments of this application, the processor 1610 and the transceiver 1620 may be configured to perform functions, operations, or the like performed by the receive end. The transceiver 1620 performs, for example, all receiving or transmitting operations performed by the receive end in the embodiments of FIG. 9, and FIG. 10A and FIG. 10B. The processor 1610 is configured to perform all operations except the receiving and transmitting operations performed by the receive end.

The transceiver 1620 is configured to communicate with another device/apparatus through a transmission medium. The processor 1610 receives or transmits data and/or signaling through the transceiver 1620, and is configured to implement the method in the foregoing method embodiments. The processor 1610 may implement functions of the processing module 1510, and the transceiver 1620 may implement functions of the transceiver module 1520.

Optionally, the transceiver 1620 may include a radio frequency circuit and an antenna. The radio frequency circuit is mainly configured to perform conversion between a baseband signal and a radio frequency signal, and process the radio frequency signal. The antenna is mainly configured to receive and transmit a radio frequency signal in the form of an electromagnetic wave. The input/output apparatus, such as a touchscreen, a display, or a keyboard, is mainly configured to receive data input by a user and output data to the user.

Optionally, the communication apparatus 160 may further include at least one memory 1630, configured to store program instructions and/or data. The memory 1630 is coupled to the processor 1610. The coupling in embodiments of this application may be an indirect coupling or a communication connection between apparatuses, units, or modules in an electrical form, a mechanical form, or another form, and is used for information exchange between the apparatuses, the units, or the modules. The processor 1610 may cooperate with the memory 1630. The processor 1610 may execute the program instructions stored in the memory 1630. At least one of the at least one memory may be included in the processor.

The processor 1610 may read the software program in the memory 1630, interpret and execute instructions of the software program, and process data of the software program. When data needs to be sent wirelessly, the processor 1610 performs baseband processing on the to-be-sent data, and then outputs a baseband signal to a radio frequency circuit. The radio frequency circuit performs radio frequency processing on the baseband signal, and then sends, by using the antenna, a radio frequency signal in an electromagnetic wave form. When data is sent to the communication apparatus, the radio frequency circuit receives a radio frequency signal through the antenna, converts the radio frequency signal into a baseband signal, and outputs the baseband signal to the processor 1610. The processor 1610 converts the baseband signal into data, and processes the data.

In another implementation, the radio frequency circuit and the antenna may be disposed independently of the processor that performs baseband processing. For example, in a distributed scenario, the radio frequency circuit and the antenna may be remotely disposed independently of the communication apparatus.

A specific connection medium between the transceiver 1620, the processor 1610, and the memory 1630 is not limited in embodiments of this application. In this embodiment of this application, the memory 1630, the processor 1610, and the transceiver 1620 are connected through a bus 1640 in FIG. 16. The bus is represented by using a thick line in FIG. 16. A manner of a connection between other components is merely an example for description, and imposes no limitation. The bus may be classified into an address bus, a data bus, a control bus, and the like. For ease of description, the bus in FIG. 16 is represented by only one thick line, but which does not indicate that there is only one bus or one type of bus.

In embodiments of this application, the processor may be a general-purpose processor, a digital signal processor, an application-specific integrated circuit, a field programmable gate array or another programmable logic device, a discrete gate or transistor logic device, or a discrete hardware component, and may implement or execute the methods, steps, and logical block diagrams disclosed in embodiments of this application. The general purpose processor may be a microprocessor or any conventional processor or the like. The steps of the method disclosed with reference to embodiments of this application may be directly performed by a hardware processor, or may be performed by using a combination of hardware in the processor and a software module.

FIG. 17 is a diagram of a structure of another communication apparatus 170 according to an embodiment of this application. As shown in FIG. 17, the communication apparatus shown in FIG. 17 includes a logic circuit 1701 and an interface 1702. The processing module 1510 in FIG. 15 may be implemented by the logic circuit 1701, and the transceiver module 1520 in FIG. 15 may be implemented by the interface 1702. The logic circuit 1701 may be a chip, a processing circuit, an integrated circuit, a system-on-chip (system on chip, SoC), or the like. The interface 1702 may be a communication interface, an input/output interface, or the like. In this embodiment of this application, the logic circuit and the interface may be coupled to each other. A specific manner of connection between the logical circuit and the interface is not limited in this embodiment of this application.

In some embodiments of this application, the logic circuit and the interface may be configured to perform functions, operations, or the like performed by the transmit end.

In some embodiments of this application, the logic circuit and the interface may be configured to perform functions, operations, or the like performed by the receive end.

This application further provides a computer-readable storage medium. The computer-readable storage medium stores a computer program or instructions. When the computer program or the instructions are run on a computer, the computer is enabled to perform the method in the foregoing embodiments.

This application further provides a computer program product. The computer program product includes instructions or a computer program. When the instructions or the computer program is run on a computer, the method in the foregoing embodiment is performed.

This application further provides a communication system, including the transmit end and the receive end.

This application further provides a chip. The chip includes a communication interface and a processor. The communication interface is configured to receive/transmit a signal from/to the chip. The processor is configured to execute computer program instructions, so that a communication apparatus including the chip performs the method in the foregoing embodiments.

The foregoing descriptions are merely specific implementations of this application, but are not intended to limit the scope of protection of this application. Any variations or replacements readily figured out by a person skilled in the art within the technical scope disclosed in this application shall fall within the scope of protection of this application. Therefore, the scope of protection of this application shall be subject to the scope of protection of the claims.

**Claims**

1. An encoding method, comprising:

   performing low-density parity-check LDPC encoding on a bit sequence based on a check matrix set, to obtain an encoded sequence, wherein the check matrix set comprises a first check matrix and a second check matrix, a first expansion factor corresponding to the first check matrix is different from a second expansion factor corresponding to the second check matrix, the first check matrix is a check matrix obtained by expanding a base matrix using a first set of circular shift values, the second check matrix is a check matrix obtained by expanding the base matrix using a second set of circular shift values, and the second set of circular shift values are circular shift values obtained by using the first set of circular shift values; and
   transmitting a data packet obtained based on the encoded sequence.

2. A decoding method, comprising:

   obtaining a low-density parity-check LDPC encoded sequence; and
   decoding the encoded sequence based on a check matrix set, wherein the check matrix set comprises a first check matrix and a second check matrix, a first expansion factor corresponding to the first check matrix is different from a second expansion factor corresponding to the second check matrix, the first check matrix is a check matrix obtained by expanding a base matrix using a first set of circular shift values, the second check matrix is a check matrix obtained by expanding the base matrix using a second set of circular shift values, and the second set of circular shift values are circular shift values obtained by using the first set of circular shift values.

3. The method according to claim 1 or 2, wherein respective circular shift values of the first set of circular shift values and the second set of circular shift values meet a same modulo operation relationship.

4. The method according to claim 3, wherein the second set of circular shift values are circular shift values obtained by performing modulo processing on the first set of circular shift values and the second expansion factor.

5. The method according to any one of claims 1 to 4, wherein the check matrix set further comprises a third check matrix, the first expansion factor is K times a third expansion factor corresponding to the third check matrix, K is an odd number greater than 1, the third check matrix is a check matrix obtained by expanding the base matrix using a third set of circular shift values, the third set of circular shift values are circular shift values obtained by using the first set of circular shift values, and the third set of circular shift values are different from the second set of circular shift values.

6. The method according to claim 5, wherein the second expansion factor is F times the third expansion factor, and F is an even number greater than 1.

7. The method according to claim 6, wherein the first expansion factor is 102, the second expansion factor is 68, and the third expansion factor is 34.

8. The method according to claim 6 or 7, wherein an encoded sequence corresponding to the first check matrix comprises a code word with a code length of 2040 bits, an encoded sequence corresponding to the second check matrix comprises a code word with a code length of 1360 bits, and an encoded sequence corresponding to the third check matrix comprises a code word with a code length of 680 bits.

9. The method according to any one of claims 1 to 8, wherein the method is applied to a wireless local area network system and/or an ultra-wideband UWB-based wireless personal local area network system.

10. The method according to any one of claims 1 to 9, wherein the base matrix comprises H rows or M columns of the following (12×22) matrix:

```
1 1 0 1 0 0 1 0 0 0 1 1 0 0 0 0 0 0 0 0 0 0
1 0 0 1 1 1 0 1 1 0 0 1 1 0 0 0 0 0 0 0 0 0
1 1 1 0 0 0 1 0 1 1 0 0 1 1 0 0 0 0 0 0 0 0
0 1 1 1 1 1 1 0 0 1 1 0 0 1 1 0 0 0 0 0 0 0
1 1 1 0 1 1 0 1 1 1 0 0 0 0 1 1 0 0 0 0 0 0
1 0 0 1 0 0 0 1 0 0 1 0 0 0 0 1 0 0 0 0 0 0
1 1 0 0 0 0 0 0 0 0 0 0 0 0 0 0 1 0 0 0 0 0
0 1 0 1 0 0 0 0 0 1 0 1 1 0 0 0 0 1 0 0 0 0
1 1 0 0 0 0 0 0 1 0 0 0 0 0 0 0 0 0 0 1 0 0 0
1 0 0 0 1 0 0 0 1 0 0 0 0 0 1 0 0 0 0 1 0 0
1 1 0 1 0 0 0 0 0 0 0 1 0 0 0 1 0 0 0 0 1 0
0 1 0 1 1 1 0 0 0 0 0 0 0 0 0 0 0 0 0 0 0 1
```

H is an integer from 1 to 12, and M is an integer from 1 to 22.

11. The method according to any one of claims 1 to 10, wherein the first check matrix comprises H rows or M columns of the following (12×22) matrix:

```
19 64 -1 42 -1 -1 61 -1 -1 -1 1 0 -1 -1 -1 -1 -1 -1 -1 -1 -1 -1
58 -1 -1 27 37 32 -1 32 49 -1 -1 0 0 -1 -1 -1 -1 -1 -1 -1 -1 -1
47 0 11 -1 -1 -1 3 -1 8 13 -1 -1 0 0 -1 -1 -1 -1 -1 -1 -1 -1
-1 55 7 24 4 7 54 -1 -1 28 0 -1 -1 0 0 -1 -1 -1 -1 -1 -1 -1
29 38 53 -1 40 16 -1 30 15 67 -1 -1 -1 -1 0 0 -1 -1 -1 -1 -1 -1
7 -1 -1 0 -1 -1 -1 52 -1 -1 1 -1 -1 -1 -1 0 -1 -1 -1 -1 -1 -1
39 12 -1 -1 -1 -1 -1 -1 -1 -1 -1 -1 -1 -1 -1 -1 0 -1 -1 -1 -1 -1
-1 61 -1 11 -1 -1 -1 -1 -1 24 -1 51 44 -1 -1 -1 -1 0 -1 -1 -1 -1
0 16 -1 -1 -1 -1 -1 -1 5 -1 -1 -1 -1 -1 -1 -1 -1 -1 0 -1 -1 -1
24 -1 -1 -1 36 -1 -1 -1 61 -1 -1 -1 -1 -1 56 -1 -1 -1 -1 1 0 -1 -1
58 24 -1 50 -1 -1 -1 -1 -1 -1 -1 26 -1 -1 -1 10 -1 -1 -1 1 -1 0 -1
-1 4 -1 60 61 48 -1 -1 -1 -1 -1 -1 -1 -1 -1 -1 -1 -1 1 -1 -1 0
```

- 1 in the first check matrix represents an all-zero matrix of size (K×K), 0 in the first check matrix represents an identity matrix of size (K×K), and an element greater than 0 in the first check matrix represents a CPM of size (K×K), wherein H is an integer from 1 to 12, and M is an integer from 1 to 22.

12. The method according to any one of claims 1 to 10, wherein the first check matrix comprises H rows or M columns of the following (12×22) matrix:

```
53 64 -1 42 -1 -1 61 -1 -1 -1 1 0 -1 -1 -1 -1 -1 -1 -
1 -1 -1 -1
24 -1 -1 61 37 66 -1 32 49 -1 -1 0 0 -1 -1 -1 -1 -1 -
1 -1 -1 -1
47 0 45 -1 -1 -1 37 -1 8 13 -1 -1 0 0 -1 -1 -1 -1 -
1 -1 -1 -1
-1 55 41 24 38 7 54 -1 -1 62 0 -1 -1 0 0 -1 -1 -1 -
1 -1 -1 -1
63 38 19 -1 40 16 -1 64 15 67 -1 -1 -1 -1 0 0 -1 -1 -
1 -1 -1 -1
41 -1 -1 0 -1 -1 -1 52 -1 -1 1 -1 -1 -1 -1 0 -1 -1 -
1 -1 -1 -1
5 46 -1 -1 -1 -1 -1 -1 -1 -1 -1 -1 -1 -1 -1 -1 0 -1 -1
-1 -1 -1
-1 61 -1 45 -1 -1 -1 -1 -1 58 -1 51 44 -1 -1 -1 -1 0 -
1 -1 -1 -1
0 16 -1 -1 -1 -1 -1 -1 5 -1 -1 -1 -1 -1 -1 -1 -1 -1 0
-1 -1 -1
58 -1 -1 -1 36 -1 -1 -1 27 -1 -1 -1 -1 -1 56 -1 -1 -1 -
1 0 -1 -1
24 58 -1 50 -1 -1 -1 -1 -1 -1 -1 60 -1 -1 -1 10 -1 -1 -
1 -1 0 -1
-1 38 -1 60 61 14 -1 -1 -1 -1 -1 -1 -1 -1 -1 -1 -1 -1 -
1 -1 -1 0
```

- 1 in the first check matrix represents an all-zero matrix of size (K×K), 0 in the first check matrix represents an identity matrix of size (K×K), and an element greater than 0 in the first check matrix represents a CPM of size (K×K), wherein H is an integer from 1 to 12, and M is an integer from 1 to 22.

13. The method according to any one of claims 1 to 10, wherein the first check matrix comprises H rows or M columns of the following (12×22) matrix:

```
19 64 -1 42 -1 -1 27 -1 -1 -1 1 0 -1 -1 -1 -1 -1 -1 -
1 -1 -1 -1
58 -1 -1 27 3 66 -1 66 15 -1 -1 0 0 -1 -1 -1 -1 -1 -
1 -1 -1 -1
13 0 45 -1 -1 -1 37 -1 42 13 -1 -1 0 0 -1 -1 -1 -1 -
1 -1 -1 -1
-1 55 7 24 38 41 20 -1 -1 28 0 -1 -1 0 0 -1 -1 -1 -
1 -1 -1 -1
29 38 53 -1 40 50 -1 64 49 33 -1 -1 -1 -1 0 0 -1 -1 -
1 -1 -1 -1
41 -1 -1 0 -1 -1 -1 52 -1 -1 1 -1 -1 -1 -1 0 -1 -1 -
1 -1 -1 -1
39 46 -1 -1 -1 -1 -1 -1 -1 -1 -1 -1 -1 -1 -1 -1 0 -1 -
1 -1 -1 -1
-1 61 -1 45 -1 -1 -1 -1 -1 24 -1 17 44 -1 -1 -1 -1 0 -
1 -1 -1 -1
0 16 -1 -1 -1 -1 -1 -1 39 -1 -1 -1 -1 -1 -1 -1 -1 -1 0
-1 -1 -1
24 -1 -1 -1 2 -1 -1 -1 27 -1 -1 -1 -1 -1 56 -1 -1 -1 -
1 0 -1 -1
24 58 -1 16 -1 -1 -1 -1 -1 -1 -1 26 -1 -1 -1 44 -1 -1 -
1 -1 0 -1
-1 38 -1 60 61 48 -1 -1 -1 -1 -1 -1 -1 -1 -1 -1 -1 -1 -
1 -1 -1 0
```

- 1 in the first check matrix represents an all-zero matrix of size (K×K), 0 in the first check matrix represents an identity matrix of size (K×K), and an element greater than 0 in the first check matrix represents a CPM of size (K×K), wherein H is an integer from 1 to 12, and M is an integer from 1 to 22.

14. The method according to any one of claims 1 to 10, wherein the first check matrix comprises H rows or M columns of the following (12×22) matrix:

```
53 30 -1 42 -1 -1 27 -1 -1 -1 1 0 -1 -1 -1 -1 -1 -1 -
1 -1 -1 -1
58 -1 -1 27 3 32 -1 66 49 -1 -1 0 0 -1 -1 -1 -1 -1 -
1 -1 -1 -1
47 0 45 -1 -1 -1 3 -1 8 47 -1 -1 0 0 -1 -1 -1 -1 -
1 -1 -1 -1
```

```
-1 21 41 24 38 7 54 -1 -1 28 0 -1 -1 0 0 -1 -1 -1 -
1 -1 -1 -1
63 38 19 -1 6 50 -1 64 15 67 -1 -1 -1 -1 0 0 -1 -1 -
1 -1 -1 -1
7 -1 -1 0 -1 -1 -1 52 -1 -1 1 -1 -1 -1 -1 0 -1 -1 -1
-1 -1 -1
5 12 -1 -1 -1 -1 -1 -1 -1 -1 -1 -1 -1 -1 -1 -1 0 -1 -1
-1 -1 -1
-1 61 -1 45 -1 -1 -1 -1 -1 24 -1 17 44 -1 -1 -1 -1 0 -
1 -1 -1 -1
0 16 -1 -1 -1 -1 -1 -1 5 -1 -1 -1 -1 -1 -1 -1 -1 -1 0
-1 -1 -1
24 -1 -1 -1 2 -1 -1 -1 61 -1 -1 -1 -1 -1 56 -1 -1 -1 -
1 0 -1 -1
24 24 -1 50 -1 -1 -1 -1 -1 -1 -1 60 -1 -1 -1 10 -1 -1 -
1 -1 0 -1
-1 38 -1 60 61 14 -1 -1 -1 -1 -1 -1 -1 -1 -1 -1 -1 -1 -
1 -1 -1 0
```

- 1 in the first check matrix represents an all-zero matrix of size (K×K), 0 in the first check matrix represents an identity matrix of size (K×K), and an element greater than 0 in the first check matrix represents a CPM of size (K×K), wherein H is an integer from 1 to 12, and M is an integer from 1 to 22.

15. The method according to any one of claims 1 to 10, wherein the first check matrix comprises H rows or M columns of the following (12×22) matrix:

```
19 64 -1 8 -1 -1 61 -1 -1 -1 1 0 -1 -1 -1 -1 -1 -1 -
1 -1 -1 -1
58 -1 -1 61 37 32 -1 32 15 -1 -1 0 0 -1 -1 -1 -1 -1 -
1 -1 -1 -1
47 0 45 -1 -1 -1 3 -1 8 47 -1 -1 0 0 -1 -1 -1 -1 -
1 -1 -1 -1
-1 21 7 58 38 7 54 -1 -1 28 0 -1 -1 0 0 -1 -1 -1 -
1 -1 -1 -1
29 4 53 -1 40 50 -1 30 49 33 -1 -1 -1 0 0 -1 -1 -
1 -1 -1 -1
7 -1 -1 0 -1 -1 -1 18 -1 -1 1 -1 -1 -1 -1 0 -1 -1 -1
-1 -1 -1
39 46 -1 -1 -1 -1 -1 -1 -1 -1 -1 -1 -1 -1 -1 -1 0 -1 -
1 -1 -1 -1
-1 27 -1 11 -1 -1 -1 -1 -1 58 -1 51 44 -1 -1 -1 -1 0 -1
-1 -1 -1
0 50 -1 -1 -1 -1 -1 -1 5 -1 -1 -1 -1 -1 -1 -1 -1 0
-1 -1 -1
24 -1 -1 -1 36 -1 -1 -1 61 -1 -1 -1 -1 -1 22 -1 -1 -1 -
1 0 -1 -1
24 24 -1 16 -1 -1 -1 -1 -1 -1 -1 60 -1 -1 -1 44 -1 -1 -
1 -1 0 -1
-1 38 -1 26 27 48 -1 -1 -1 -1 -1 -1 -1 -1 -1 -1 -1 -1 -
1 -1 -1 0
```

- 1 in the first check matrix represents an all-zero matrix of size (K×K), 0 in the first check matrix represents an identity matrix of size (K×K), and an element greater than 0 in the first check matrix represents a CPM of size (K×K), wherein H is an integer from 1 to 12, and M is an integer from 1 to 22.

16. The method according to any one of claims 1 to 10, wherein the first check matrix comprises H rows or M columns of the following (12×22) matrix:

```
87 64 -1 42 -1 -1 61 -1 -1 -1 1 0 -1 -1 -1 -1 -1 -1 -
1 -1 -1 -1
58 -1 -1 27 37 100 -1 32 49 -1 -1 0 0 -1 -1 -1 -1 -1 -1
-1 -1 -1
47 0 11 -1 -1 -1 71 -1 8 13 -1 -1 0 0 -1 -1 -1 -1 -1
-1 -1 -1
-1 55 7 24 4 75 54 -1 -1 28 0 -1 -1 0 0 -1 -1 -1 -
1 -1 -1 -1
97 38 53 -1 40 84 -1 30 83 67 -1 -1 -1 0 0 -1 -1 -
1 -1 -1 -1
7 -1 -1 0 -1 -1 -1 52 -1 -1 1 -1 -1 -1 -1 0 -1 -1 -1
-1 -1 -1
```

```
39 80 -1 -1 -1 -1 -1 -1 -1 -1 -1 -1 -1 -1 -1 -1 0 -1 -
1 -1 -1 -1
-1 61 -1 79 -1 -1 -1 -1 -1 24 -1 51 44 -1 -1 -1 -1 0 -
1 -1 -1 -1
0 16 -1 -1 -1 -1 -1 -1 73 -1 -1 -1 -1 -1 -1 -1 -1 -1 0
-1 -1 -1
92 -1 -1 -1 36 -1 -1 -1 61 -1 -1 -1 -1 -1 56 -1 -1 -1 -
1 0 -1 -1
58 24 -1 50 -1 -1 -1 -1 -1 -1 -1 26 -1 -1 -1 10 -1 -1 -
1 -1 0 -1
-1 4 -1 60 61 48 -1 -1 -1 -1 -1 -1 -1 -1 -1 -1 -1 -
1 -1 -1 0
```

    - 1 in the first check matrix represents an all-zero matrix of size (K×K), 0 in the first check matrix represents an identity matrix of size (K×K), and an element greater than 0 in the first check matrix represents a CPM of size (K×K), wherein H is an integer from 1 to 12, and M is an integer from 1 to 22.

**17.** The method according to any one of claims 1 to 10, wherein the first check matrix comprises H rows or M columns of the following (12×22) matrix:

```
19 64 -1 42 -1 -1 61 -1 -1 -1 1 0 -1 -1 -1 -1 -1 -1 -
1 -1 -1 -1
58 -1 -1 27 37 100 -1 32 49 -1 -1 0 0 -1 -1 -1 -1 -1 -1
-1 -1 -1
47 0 11 -1 -1 -1 71 -1 8 13 -1 -1 0 0 -1 -1 -1 -1 -1
-1 -1 -1
-1 55 7 24 72 75 54 -1 -1 28 0 -1 -1 0 0 -1 -1 -1 -
1 -1 -1 -1
97 38 53 -1 40 84 -1 30 83 67 -1 -1 -1 -1 0 0 -1 -1 -
1 -1 -1 -1
75 -1 -1 0 -1 -1 -1 52 -1 -1 1 -1 -1 -1 -1 0 -1 -1 -
1 -1 -1 -1
39 12 -1 -1 -1 -1 -1 -1 -1 -1 -1 -1 -1 -1 -1 0 -1 -
1 -1 -1 -1
-1 61 -1 79 -1 -1 -1 -1 -1 24 -1 51 44 -1 -1 -1 -1 0 -
1 -1 -1 -1
0 16 -1 -1 -1 -1 -1 -1 73 -1 -1 -1 -1 -1 -1 -1 -1 -1 0
-1 -1 -1
24 -1 -1 -1 36 -1 -1 -1 61 -1 -1 -1 -1 -1 56 -1 -1 -1 -
1 0 -1 -1
58 92 -1 50 -1 -1 -1 -1 -1 -1 -1 26 -1 -1 -1 78 -1 -1 -
1 -1 0 -1
-1 72 -1 60 61 48 -1 -1 -1 -1 -1 -1 -1 -1 -1 -1 -1 -
1 -1 -1 0
```

    - 1 in the first check matrix represents an all-zero matrix of size (K×K), 0 in the first check matrix represents an identity matrix of size (K×K), and an element greater than 0 in the first check matrix represents a CPM of size (K×K), wherein H is an integer from 1 to 12, and M is an integer from 1 to 22.

**18.** The method according to any one of claims 1 to 10, wherein the first check matrix comprises H rows or M columns of the following (12×22) matrix:

```
53 64 -1 42 -1 -1 61 -1 -1 -1 1 0 -1 -1 -1 -1 -1 -1 -
1 -1 -1 -1
92 -1 -1 61 37 66 -1 100 49 -1 -1 0 0 -1 -1 -1 -1 -1 -1
-1 -1 -1
47 0 45 -1 -1 -1 37 -1 76 81 -1 -1 0 0 -1 -1 -1 -1 -
1 -1 -1 -1
-1 55 41 92 38 75 54 -1 -1 62 0 -1 -1 0 0 -1 -1 -1 -
1 -1 -1 -1
63 38 87 -1 40 16 -1 64 83 67 -1 -1 -1 -1 0 0 -1 -1 -
1 -1 -1 -1
41 -1 -1 0 -1 -1 -1 52 -1 -1 1 -1 -1 -1 -1 0 -1 -1 -
1 -1 -1 -1
73 46 -1 -1 -1 -1 -1 -1 -1 -1 -1 -1 -1 -1 -1 0 -1 -
1 -1 -1 -1
-1 61 -1 45 -1 -1 -1 -1 -1 58 -1 51 44 -1 -1 -1 -1 0 -
1 -1 -1 -1
0 16 -1 -1 -1 -1 -1 -1 73 -1 -1 -1 -1 -1 -1 -1 -1 -1 0
-1 -1 -1
```

```
58 -1 -1 -1 36 -1 -1 -1 95 -1 -1 -1 -1 -1 56 -1 -1 -1 -
1 0 -1 -1
24 58 -1 50 -1 -1 -1 -1 -1 -1 -1 60 -1 -1 -1 78 -1 -1 -
1 -1 0 -1
-1 38 -1 60 61 14 -1 -1 -1 -1 -1 -1 -1 -1 -1 -1 -1 -1 -
1 -1 -1 0
```

- 1 in the first check matrix represents an all-zero matrix of size (K×K), 0 in the first check matrix represents an identity matrix of size (K×K), and an element greater than 0 in the first check matrix represents a CPM of size (K×K), wherein H is an integer from 1 to 12, and M is an integer from 1 to 22.

**19.** The method according to any one of claims 1 to 10, wherein the first check matrix comprises H rows or M columns of the following (12×22) matrix:

```
87 64 -1 42 -1 -1 27 -1 -1 -1 1 0 -1 -1 -1 -1 -1 -1 -
1 -1 -1 -1
58 -1 -1 27 3 66 -1 66 83 -1 -1 0 0 -1 -1 -1 -1 -1 -
1 -1 -1 -1
13 0 45 -1 -1 -1 37 -1 42 81 -1 -1 0 0 -1 -1 -1 -1 -
1 -1 -1 -1
-1 55 75 92 38 41 20 -1 -1 28 0 -1 -1 0 0 -1 -1 -1 -
1 -1 -1 -1
97 38 53 -1 40 50 -1 64 49 33 -1 -1 -1 -1 0 0 -1 -1 -
1 -1 -1 -1
41 -1 -1 0 -1 -1 -1 52 -1 -1 1 -1 -1 -1 -1 0 -1 -1 -
1 -1 -1 -1
39 46 -1 -1 -1 -1 -1 -1 -1 -1 -1 -1 -1 -1 -1 -1 0 -1 -
1 -1 -1 -1
-1 61 -1 45 -1 -1 -1 -1 -1 24 -1 85 44 -1 -1 -1 -1 0 -
1 -1 -1 -1
0 16 -1 -1 -1 -1 -1 -1 39 -1 -1 -1 -1 -1 -1 -1 -1 -1 0
-1 -1 -1
92 -1 -1 -1 70 -1 -1 -1 27 -1 -1 -1 -1 -1 56 -1 -1 -1 -
1 0 -1 -1
92 58 -1 16 -1 -1 -1 -1 -1 -1 -1 26 -1 -1 -1 44 -1 -1 -
1 -1 0 -1
-1 38 -1 60 61 48 -1 -1 -1 -1 -1 -1 -1 -1 -1 -1 -1 -1 -
1 -1 -1 0
```

- 1 in the first check matrix represents an all-zero matrix of size (K×K), 0 in the first check matrix represents an identity matrix of size (K×K), and an element greater than 0 in the first check matrix represents a CPM of size (K×K), wherein H is an integer from 1 to 12, and M is an integer from 1 to 22.

**20.** The method according to any one of claims 1 to 10, wherein the first check matrix comprises H rows or M columns of the following (12×22) matrix:

```
53 30 -1 42 -1 -1 27 -1 -1 -1 1 0 -1 -1 -1 -1 -1 -1 -
1 -1 -1 -1
58 -1 -1 27 71 100 -1 66 49 -1 -1 0 0 -1 -1 -1 -1 -1 -1
-1 -1 -1
47 0 45 -1 -1 -1 71 -1 76 47 -1 -1 0 0 -1 -1 -1 -1 -
1 -1 -1 -1
-1 21 41 24 38 75 54 -1 -1 28 0 -1 -1 0 0 -1 -1 -1 -
1 -1 -1 -1
63 38 19 -1 6 50 -1 64 83 67 -1 -1 -1 0 0 -1 -1 -
1 -1 -1 -1
7 -1 -1 0 -1 -1 -1 52 -1 -1 1 -1 -1 -1 -1 0 -1 -1 -1
-1 -1 -1
73 80 -1 -1 -1 -1 -1 -1 -1 -1 -1 -1 -1 -1 -1 -1 0 -1 -
1 -1 -1 -1
-1 61 -1 45 -1 -1 -1 -1 -1 24 -1 17 44 -1 -1 -1 -1 0 -
1 -1 -1 -1
0 16 -1 -1 -1 -1 -1 -1 5 -1 -1 -1 -1 -1 -1 -1 -1 -1 0
-1 -1 -1
24 -1 -1 -1 70 -1 -1 -1 61 -1 -1 -1 -1 -1 56 -1 -1 -1 -
1 0 -1 -1
24 24 -1 50 -1 -1 -1 -1 -1 -1 -1 60 -1 -1 -1 78 -1 -1 -
1 -1 0 -1
-1 38 -1 60 61 82 -1 -1 -1 -1 -1 -1 -1 -1 -1 -1 -1 -1 -
1 -1 -1 0
```

- 1 in the first check matrix represents an all-zero matrix of size (K×K), 0 in the first check matrix represents an identity matrix of size (K×K), and an element greater than 0 in the first check matrix represents a CPM of size (K×K), wherein H is an integer from 1 to 12, and M is an integer from 1 to 22.

21. The method according to any one of claims 1 to 10, wherein the first check matrix comprises H rows or M columns of the following (12×22) matrix:

```
87 64 -1 8 -1 -1 61 -1 -1 -1 1 0 -1 -1 -1 -1 -1 -1 -
1 -1 -1 -1
58 -1 -1 61 37 32 -1 100 83 -1 -1 0 0 -1 -1 -1 -1 -1 -1
-1 -1 -1
47 0 45 -1 -1 -1 71 -1 8 47 -1 -1 0 0 -1 -1 -1 -1 -
1 -1 -1 -1
-1 21 75 58 38 75 54 -1 -1 28 0 -1 -1 0 0 -1 -1 -1 -
1 -1 -1 -1
29 4 53 -1 40 50 -1 30 49 101 -1 -1 -1 -1 0 0 -1 -1 -1
-1 -1 -1
7 -1 -1 0 -1 -1 -1 18 -1 -1 1 -1 -1 -1 -1 0 -1 -1 -1
-1 -1 -1
39 46 -1 -1 -1 -1 -1 -1 -1 -1 -1 -1 -1 -1 -1 -1 0 -1 -
1 -1 -1 -1
-1 27 -1 79 -1 -1 -1 -1 -1 58 -1 51 44 -1 -1 -1 -1 0 -
1 -1 -1 -1
0 50 -1 -1 -1 -1 -1 -1 73 -1 -1 -1 -1 -1 -1 -1 -1 -1 0
-1 -1 -1
92 -1 -1 -1 36 -1 -1 -1 61 -1 -1 -1 -1 -1 22 -1 -1 -1 -
1 0 -1 -1
24 24 -1 16 -1 -1 -1 -1 -1 -1 -1 60 -1 -1 -1 44 -1 -1 -
1 -1 0 -1
-1 38 -1 26 95 48 -1 -1 -1 -1 -1 -1 -1 -1 -1 -1 -1 -1 -
1 -1 -1 0
```

- 1 in the first check matrix represents an all-zero matrix of size (K×K), 0 in the first check matrix represents an identity matrix of size (K×K), and an element greater than 0 in the first check matrix represents a CPM of size (K×K), wherein H is an integer from 1 to 12, and M is an integer from 1 to 22.

22. The method according to any one of claims 1 to 6, wherein the first check matrix comprises D rows or E columns of the following (12×24) matrix:

```
0 -1 -1 -1 0 0 -1 -1 0 -1 -1 0 1 0 -1 -1 -1 -1 -1
-1 -1 -1 -1 -1
49 0 -1 -1 44 -1 0 0 39 -1 -1 -1 -1 0 0 -1 -1 -1 -
1 -1 -1 -1 -1 -1
6 -1 0 -1 37 -1 -1 -1 51 -1 0 -1 -1 -1 0 0 -1 -1 -1
-1 -1 -1 -1 -1
2 -1 -1 0 47 -1 -1 -1 52 0 -1 -1 -1 -1 -1 0 0 -1 -1
-1 -1 -1 -1 -1
23 -1 -1 -1 30 -1 -1 -1 0 -1 36 11 -1 -1 -1 -1 0 0 -1
-1 -1 -1 -1 -1
51 -1 23 28 17 -1 30 -1 37 -1 -1 -1 -1 -1 -1 -1 -1 -1 0
0 -1 -1 -1 -1 -1
52 -1 -1 -1 35 -1 -1 -1 7 45 -1 -1 0 -1 -1 -1 -1 -1
0 0 -1 -1 -1 -1
13 51 -1 -1 0 -1 8 -1 33 -1 -1 -1 -1 -1 -1 -1 -1 -1 -
1 0 0 -1 -1 -1
7 20 -1 16 22 37 -1 -1 23 -1 -1 -1 -1 -1 -1 -1 -1 -1 -1
-1 0 0 -1 -1
38 -1 -1 -1 19 -1 -1 -1 13 -1 3 17 -1 -1 -1 -1 -1 -1 -
1 -1 -1 0 0 -1
25 -1 35 -1 23 45 -1 41 9 -1 -1 -1 -1 -1 -1 -1 -1 -1 -
1 -1 -1 -1 0 0
3 -1 -1 -1 16 -1 -1 2 25 32 -1 -1 1 -1 -1 -1 -1 -1 -1
-1 -1 -1 -1 0
```

- 1 in the first check matrix represents an all-zero matrix of size (L×L), 0 in the first check matrix represents an identity matrix of size (L×L), and an element greater than 0 in the first check matrix represents a CPM of size (L×L), wherein D is an integer from 1 to 12, and E is an integer from 1 to 24.

23. The method according to any one of claims 1 to 6, wherein the first check matrix comprises D rows or E columns of the following (12×24) matrix:

```
0 -1 -1 -1 0 0 -1 -1 0 -1 -1 0 1 0 -1 -1 -1 -1 -1
-1 -1 -1 -1 -1
49 0 -1 -1 44 -1 0 0 39 -1 -1 -1 -1 0 0 -1 -1 -1 -
1 -1 -1 -1 -1 -1
60 -1 0 -1 37 -1 -1 -1 51 -1 0 -1 -1 -1 0 0 -1 -1 -
1 -1 -1 -1 -1 -1
56 -1 -1 0 47 -1 -1 -1 52 0 -1 -1 -1 -1 0 0 -1 -
1 -1 -1 -1 -1 -1
77 -1 -1 -1 30 -1 -1 -1 0 -1 36 11 -1 -1 -1 -1 0 0 -1
-1 -1 -1 -1 -1
51 -1 77 28 17 -1 30 -1 37 -1 -1 -1 -1 -1 -1 -1 -1 0
0 -1 -1 -1 -1 -1
52 -1 -1 -1 35 -1 -1 -1 7 45 -1 -1 0 -1 -1 -1 -1 -1
0 0 -1 -1 -1 -1
67 51 -1 -1 0 -1 8 -1 33 -1 -1 -1 -1 -1 -1 -1 -1 -1 -
1 0 0 -1 -1 -1
61 74 -1 70 22 37 -1 -1 23 -1 -1 -1 -1 -1 -1 -1 -1 -1 -
1 -1 0 0 -1 -1
38 -1 -1 -1 73 -1 -1 -1 67 -1 57 71 -1 -1 -1 -1 -1 -1 -
1 -1 -1 0 0 -1
25 -1 35 -1 77 45 -1 41 9 -1 -1 -1 -1 -1 -1 -1 -1 -1 -
1 -1 -1 -1 0 0
57 -1 -1 -1 16 -1 -1 56 25 32 -1 -1 1 -1 -1 -1 -1 -1 -
1 -1 -1 -1 -1 0
```

- 1 in the first check matrix represents an all-zero matrix of size (L×L), 0 in the first check matrix represents an identity matrix of size (L×L), and an element greater than 0 in the first check matrix represents a CPM of size (L×L), wherein D is an integer from 1 to 12, and E is an integer from 1 to 24.

24. The method according to claim 22 or 23, wherein the first expansion factor is 81, the second expansion factor is 54, and the third expansion factor is 27.

25. The method according to claim 24, wherein an encoded sequence corresponding to the first check matrix comprises a code word with a code length of 1944 bits, an encoded sequence corresponding to the second check matrix comprises a code word with a code length of 1296 bits, and an encoded sequence corresponding to the third check matrix comprises a code word with a code length of 648 bits.

26. A communication apparatus, comprising a module or a unit configured to implement the method according to any one of claims 1 to 25.

27. A computer-readable storage medium, wherein the computer-readable storage medium stores a computer program, the computer program comprises program instructions, and when the program instructions are executed, a computer is enabled to perform the method according to any one of claims 1 to 25.

28. A communication apparatus, comprising a processor, wherein the processor is coupled to a memory, the memory stores computer program instructions, and the processor is configured to execute the computer program instructions, so that the communication apparatus performs the method according to any one of claims 1 to 25.

29. A chip, comprising:

a communication interface, configured to receive/transmit a signal from/to the chip; and
a processor, configured to execute computer program instructions, so that a communication apparatus that comprises the chip performs the method according to any one of claims 1 to 25.

$$
\mathbf{H} = \begin{bmatrix}
V_1 & V_2 & V_3 & V_4 & V_5 & V_6 & V_7 & V_8 \\
1 & 0 & 1 & 0 & 1 & 0 & 1 & 0 \\
1 & 0 & 0 & 1 & 0 & 1 & 0 & 1 \\
0 & 1 & 1 & 0 & 0 & 1 & 1 & 0 \\
0 & 1 & 0 & 1 & 1 & 0 & 0 & 1
\end{bmatrix} \begin{matrix} C_1 \\ C_2 \\ C_3 \\ C_4 \end{matrix}
$$

FIG. 1

FIG. 2

Check matrix H → Gaussian elimination → [I P]

$G \cdot H^T = 0$

Generator matrix $G = [-P^T\ I]$ → $x = c \cdot G$ → Transmit code word x

FIG. 3

401

| payload bits<br>(data bits to be encoded) |

402

Step 1

| LDPC code word<br>(LDPC code word) | | LDPC code word<br>(LDPC code word) | | ... | | LDPC code word<br>(LDPC code word) |

403

Step 2

| payload<br>bits | shortening zero<br>bits (shortening<br>0 bits) | | | payload<br>bits | shortening zero<br>bits (shortening<br>0 bits) | | | payload<br>bits | shortening zero<br>bits (shortening<br>0 bits) | |

404

Step 3

| payload<br>bits | shortening zero<br>bits (shortening<br>0 bits) | check<br>bits | | payload<br>bits | shortening zero<br>bits (shortening<br>0 bits) | check<br>bits | | payload<br>bits | shortening zero<br>bits (shortening<br>0 bits) | check<br>bits |

405

Delete
shortening
0 bits

| payload<br>bits | shortening zero<br>bits (shortening<br>0 bits) | | payload<br>bits | shortening zero<br>bits (shortening<br>0 bits) | | payload<br>bits | shortening zero<br>bits (shortening<br>0 bits) |

FIG. 4

| 10 | 40 | 67 | 55 | 3 | 62 | 5 | 25 | 64 | 43 | 31 | 50 | | 41 | 61 | 26 | 62 | 61 | 19 | | 0 | 0 | | |
|----|----|----|----|---|----|---|----|----|----|----|----|--|----|----|----|----|----|----|--|---|---|--|--|
| 58 | 53 | 62 | 47 | 54 | 64 | 48 | 54 | 5 | 13 | 43 | | 54 | | 57 | 7 | 40 | 52 | 45 | 22 | | 0 | 0 | |
| 43 | 12 | 0 | 67 | 20 | 21 | 35 | 45 | 37 | 59 | 59 | 7 | 56 | 29 | | 48 | | 24 | | 44 | 0 | | 0 | 0 |
| 13 | 24 | 30 | 34 | 37 | 47 | 49 | 31 | 42 | 20 | | 54 | 3 | 54 | 43 | | 3 | | 61 | 43 | 0 | | | 0 |
| | | 25 | | | | 24 | | | | | | | | 6 | | | | | | 47 | 0 | | |
| | | | 73 | | | 23 | | | | | | | | 16 | | | | 49 | | | | 0 | |
| 30 | | 16 | | | | | | | 47 | | | | | 19 | | | | | | | | 0 | |
| | | | | 65 | | 40 | | 44 | 0 | | | | | | | | | | | | | | 0 |

FIG. 5

$$p_0 = \begin{bmatrix} 1 & 0 & 0 & 0 \\ 0 & 1 & 0 & 0 \\ 0 & 0 & 1 & 0 \\ 0 & 0 & 0 & 1 \end{bmatrix} \quad p_1 = \begin{bmatrix} 0 & 1 & 0 & 0 \\ 0 & 0 & 1 & 0 \\ 0 & 0 & 0 & 1 \\ 1 & 0 & 0 & 0 \end{bmatrix} \quad p_2 = \begin{bmatrix} 0 & 0 & 1 & 0 \\ 0 & 0 & 0 & 1 \\ 1 & 0 & 0 & 0 \\ 0 & 1 & 0 & 0 \end{bmatrix} \quad p_3 = \begin{bmatrix} 0 & 0 & 0 & 1 \\ 1 & 0 & 0 & 0 \\ 0 & 1 & 0 & 0 \\ 0 & 0 & 1 & 0 \end{bmatrix}$$

FIG. 6

```
19  64  -1  42  -1  -1  61  -1  -1  -1   1   0  -1  -1  -1  -1  -1  -1  -1  -1  -1  -1
58  -1  -1  27  37  32  -1  32  49  -1  -1   0   0  -1  -1  -1  -1  -1  -1  -1  -1  -1
47   0  11  -1  -1  -1   3  -1   8  13  -1  -1   0   0  -1  -1  -1  -1  -1  -1  -1  -1
-1  55   7  24   4   7  54  -1  -1  28   0  -1  -1   0   0  -1  -1  -1  -1  -1  -1  -1
29  38  53  -1  40  16  -1  30  15  67  -1  -1  -1  -1   0   0  -1  -1  -1  -1  -1  -1
 7  -1  -1   0  -1  -1  -1  52  -1  -1   1  -1  -1  -1  -1   0  -1  -1  -1  -1  -1  -1
39  12  -1  -1  -1  -1  -1  -1  -1  -1  -1  -1  -1  -1  -1  -1   0  -1  -1  -1  -1  -1
-1  61  -1  11  -1  -1  -1  -1  -1  24  -1  51  44  -1  -1  -1  -1   0  -1  -1  -1  -1
 0  16  -1  -1  -1  -1  -1  -1   5  -1  -1  -1  -1  -1  -1  -1  -1   0  -1  -1  -1  -1
24  -1  -1  -1  36  -1  -1  -1  61  -1  -1  -1  -1  -1  56  -1  -1  -1  -1   0  -1  -1
58  24  -1  50  -1  -1  -1  -1  -1  -1  -1  26  -1  -1  -1  10  -1  -1  -1  -1   0  -1
-1   4  -1  60  61  48  -1  -1  -1  -1  -1  -1  -1  -1  -1  -1  -1  -1  -1  -1  -1   0
```

FIG. 7

AP

STA 1          STA 2

FIG. 8

Transmit end

Receive end

901

Perform LDPC encoding on a to-be-encoded bit sequence based on a check matrix set, to obtain an encoded sequence

Data packet obtained based on the encoded sequence

902

903

Obtain an LDPC encoded sequence based on a received signal that carries the data packet obtained based on the encoded sequence

904

Decode the LDPC encoded sequence based on the check matrix set, to obtain a decoding result

905

If the decoding succeeds, output the decoding result

FIG. 9

| Transmit end | | Receive end |

1001
Perform LDPC encoding on a first bit sequence based on a first check matrix, to obtain a first encoded sequence

First data packet obtained based on the first encoded sequence
1002

1003
Obtain the first encoded sequence based on a received signal that carries the first data packet

1004
Decode the first encoded sequence based on the first check matrix, to obtain a first decoding result

1005
If the decoding succeeds, output the first decoding result

1006
Perform LDPC encoding on a second bit sequence based on a second check matrix, to obtain a second encoded sequence

Second data packet obtained based on the second encoded sequence
1007

1008
Obtain the second encoded sequence based on a received signal that carries the second data packet

TO
FIG. 10B

TO
FIG. 10B

FIG. 10A

CONT.
FROM
FIG. 10B

CONT.
FROM
FIG. 10B

1009

Decode the second encoded sequence based on the second check matrix, to obtain a second decoding result

1010

If the decoding succeeds, output the second decoding result

1011

Perform LDPC encoding on a third bit sequence based on a third check matrix, to obtain a third encoded sequence

Third data packet obtained based on the third encoded sequence

1012

1013

Obtain the third encoded sequence based on a received signal that carries the third data packet

1014

Decode the third encoded sequence based on the third check matrix, to obtain a third decoding result

1015

If the decoding succeeds, output the third decoding result

FIG. 10B

1101

1103

```
1 1 0 1 0 0 1 0 0 0 1 1 0 0 0 0 | 0 | 0 0 0 0 0
1 0 0 1 1 1 0 1 1 0 0 1 1 0 0 0 | 0 | 0 0 0 0 0
1 1 1 0 0 0 1 0 1 1 0 0 1 1 0 0 | 0 | 0 0 0 0 0
0 1 1 1 1 1 1 0 0 1 1 0 0 1 1 0 | 0 | 0 0 0 0 0
1 1 1 0 1 1 0 1 1 1 0 0 0 0 1 1 | 0 | 0 0 0 0 0
1 0 0 1 0 0 0 1 0 0 1 0 0 0 0 1 | 0 | 0 0 0 0 0
```

1102

```
1 1 0 0 0 0 0 0 0 0 0 0 0 0 0 0 1 | 0 0 0 0 0
0 1 0 1 0 0 0 0 0 1 0 1 1 0 0 0 0 | 1 0 0 0 0
1 1 0 0 0 0 0 0 1 0 0 0 0 0 0 0 0 | 0 1 0 0 0
1 0 0 0 1 0 0 0 1 0 0 0 0 0 1 0 0 | 0 0 1 0 0
1 1 0 1 0 0 0 0 0 0 0 1 0 0 0 1 0 | 0 0 0 1 0
0 1 0 1 1 1 0 0 0 0 0 0 0 0 0 0 0 | 0 0 0 0 1
```

FIG. 11

```
 0  -  -  -  0  0  -  -  0  -  -  0  1  0  -  -  -  -  -  -  -  -  -
22  0  -  - 17  -  0  0 12  -  -  -  -  0  0  -  -  -  -  -  -  -  -
 6  -  0  - 10  -  -  - 24  -  0  -  -  -  0  0  -  -  -  -  -  -  -
 2  -  -  0 20  -  -  - 25  0  -  -  -  -  -  0  0  -  -  -  -  -  -
23  -  -  -  3  -  -  -  0  -  9 11  -  -  -  -  0  0  -  -  -  -  -
24  - 23  1 17  -  3  - 10  -  -  -  -  -  -  -  0  0  -  -  -  -  -
25  -  -  -  8  -  -  -  7 18  -  -  0  -  -  -  -  -  0  0  -  -  -
13 24  -  -  0  -  8  -  6  -  -  -  -  -  -  -  -  -  0  0  -  -  -
 7 20  - 16 22 10  -  - 23  -  -  -  -  -  -  -  -  -  -  0  0  -  -
11  -  -  - 19  -  -  - 13  -  3 17  -  -  -  -  -  -  -  -  0  0  -
25  -  8  - 23 18  - 14  9  -  -  -  -  -  -  -  -  -  -  -  -  0  0
 3  -  -  - 16  -  -  2 25  5  -  -  1  -  -  -  -  -  -  -  -  -  0
```

FIG. 12

Depth 0

Depth 1

Depth $l$

FIG. 13

FIG. 14A

AWGN + BPSK with 8Iter Serial

FIG. 14B

FIG. 15

Communication apparatus 160

1620

Transceiver

Radio frequency circuit

Antenna

1610

Processor

1640

1630

Memory

FIG. 16

1702

Interface

1701

Logic circuit

Communication apparatus 170

FIG. 17

## INTERNATIONAL SEARCH REPORT

| International application No. |
| --- |
| **PCT/CN2023/118033** |

**A. CLASSIFICATION OF SUBJECT MATTER**

H03M13/11(2006.01)i; H04L1/00(2006.01)i

According to International Patent Classification (IPC) or to both national classification and IPC

**B. FIELDS SEARCHED**

Minimum documentation searched (classification system followed by classification symbols)

IPC:H03M,H04L

Documentation searched other than minimum documentation to the extent that such documents are included in the fields searched

Electronic data base consulted during the international search (name of data base and, where practicable, search terms used)

CNTXT; ENTXTC; ENTXT; DWPI; CNKI; IEEE: 低密度奇偶校验, 编码, 译码, 解码, 校验, 矩阵, 第二, 另一, 其他, 扩展, 循环, 移位, 基矩阵, 基础矩阵, 母矩阵, LDPC, cod+, decod+, low, density, parity, check, matrix, basic, expand+, second, shift +, cycl+

**C. DOCUMENTS CONSIDERED TO BE RELEVANT**

| Category* | Citation of document, with indication, where appropriate, of the relevant passages | Relevant to claim No. |
| --- | --- | --- |
| A | CN 113078911 A (HUAWEI TECHNOLOGIES CO., LTD.) 06 July 2021 (2021-07-06) description, pages 6-11 and 40-41 | 1-29 |
| A | CN 110289933 A (HUAWEI TECHNOLOGIES CO., LTD.) 27 September 2019 (2019-09-27) entire document | 1-29 |
| A | CN 110677157 A (HUAWEI TECHNOLOGIES CO., LTD.) 10 January 2020 (2020-01-10) entire document | 1-29 |
| A | CN 114257250 A (ZTE CORP.) 29 March 2022 (2022-03-29) entire document | 1-29 |
| A | CN 114448446 A (GUANGDONG XINGYUAN ROBOT TECHNOLOGY CO., LTD.) 06 May 2022 (2022-05-06) entire document | 1-29 |
| A | EP 2211470 A1 (NOKIA SIEMENS NETWORKS OY) 28 July 2010 (2010-07-28) entire document | 1-29 |

☐ Further documents are listed in the continuation of Box C.  ☑ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **18 November 2023** | **22 November 2023** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2023/118033**

| Patent document cited in search report | | | Publication date (day/month/year) | Patent family member(s) | | | Publication date (day/month/year) |
|---|---|---|---|---|---|---|---|
| CN | 113078911 | A | 06 July 2021 | WO | 2021136540 | A1 | 08 July 2021 |
| | | | | EP | 4072024 | A1 | 12 October 2022 |
| | | | | US | 2022352904A1 | A1 | 03 November 2022 |
| CN | 110289933 | A | 27 September 2019 | WO | 2019179404 | A1 | 26 September 2019 |
| CN | 110677157 | A | 10 January 2020 | EP | 3582398 | A1 | 18 December 2019 |
| | | | | EP | 3582398 | A4 | 12 August 2020 |
| | | | | EP | 3582398 | B1 | 15 June 2022 |
| | | | | EP | 4113848 | A1 | 04 January 2023 |
| | | | | ES | 2922630 | T3 | 19 September 2022 |
| | | | | JP | 2020516147 | A | 28 May 2020 |
| | | | | JP | 6815537 | B2 | 20 January 2021 |
| | | | | BR | 112019020898 | A2 | 28 April 2020 |
| | | | | BR | 112019020898 | B1 | 15 February 2022 |
| | | | | ZA | 201905739 | B | 28 July 2021 |
| | | | | BR | 112019026818 | A2 | 30 June 2020 |
| | | | | AU | 2018290395 | A1 | 19 September 2019 |
| | | | | AU | 2018290395 | B2 | 21 May 2020 |
| | | | | MX | 2019012019 | A | 11 November 2019 |
| | | | | US | 2019349006 | A1 | 14 November 2019 |
| | | | | US | 10784893 | B2 | 22 September 2020 |
| | | | | US | 2023059125 | A1 | 23 February 2023 |
| | | | | US | 11770135 | B2 | 26 September 2023 |
| | | | | US | 2020403636 | A1 | 24 December 2020 |
| | | | | US | 11469776 | B2 | 11 October 2022 |
| | | | | KR | 20190112129 | A | 02 October 2019 |
| | | | | KR | 102194617 | B1 | 24 December 2020 |
| | | | | RU | 2019131324 | A | 05 April 2021 |
| | | | | RU | 2019131324 | A3 | 05 August 2021 |
| | | | | RU | 2769096 | C2 | 28 March 2022 |
| CN | 114257250 | A | 29 March 2022 | WO | 2022063237 | A1 | 31 March 2022 |
| CN | 114448446 | A | 06 May 2022 | | None | | |
| EP | 2211470 | A1 | 28 July 2010 | AT | 523967 | T | 15 September 2011 |
| | | | | EP | 2211470 | B1 | 07 September 2011 |

Form PCT/ISA/210 (patent family annex) (July 2022)

**EP 4 576 585 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202211110834